(19) Europäisches Patentamt
European Patent Office
Office européen des brevets

(11) **EP 4 596 608 A1**

(12) **EUROPEAN PATENT APPLICATION**
published in accordance with Art. 153(4) EPC

(43) Date of publication:
**06.08.2025 Bulletin 2025/32**

(21) Application number: **23872459.5**

(22) Date of filing: **27.09.2023**

(51) International Patent Classification (IPC):
***C08G 73/12*** (2006.01) ***C08F 290/14*** (2006.01)
***G03F 7/004*** (2006.01) ***G03F 7/027*** (2006.01)
***G03F 7/037*** (2006.01) ***G03F 7/20*** (2006.01)

(52) Cooperative Patent Classification (CPC):
**C08F 290/14; C08G 73/12; G03F 7/004; G03F 7/027; G03F 7/037; G03F 7/20**

(86) International application number:
**PCT/JP2023/035249**

(87) International publication number:
**WO 2024/071237 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.09.2022 JP 2022159087**

(71) Applicant: **FUJIFILM Corporation**
**Tokyo 106-8620 (JP)**

(72) Inventors:
- **OOTA, Kazuya**
  **Haibara-gun, Shizuoka 421-0396 (JP)**
- **NOZAKI, Atsuyasu**
  **Haibara-gun, Shizuoka 421-0396 (JP)**
- **OGAWA, Michihiro**
  **Haibara-gun, Shizuoka 421-0396 (JP)**
- **MASAKI, Yosuke**
  **Haibara-gun, Shizuoka 421-0396 (JP)**

(74) Representative: **HGF**
**HGF Limited**
**1 City Walk**
**Leeds LS11 9DX (GB)**

(54) **RESIN COMPOSITION, CURED PRODUCT, LAMINATE, METHOD FOR PRODUCING CURED PRODUCT, METHOD FOR PRODUCING LAMINATE, METHOD FOR PRODUCING SEMICONDUCTOR DEVICE, AND SEMICONDUCTOR DEVICE**

(57) There are provided a resin composition containing at least one resin selected from the group consisting of a polyimide and a precursor thereof, in which a dielectric loss tangent of a cured substance obtained by heating the resin composition at 230°C for 1 hour is less than 0.03, a cured substance, a laminate, a manufacturing method for a cured substance, a manufacturing method for a laminate, a manufacturing method for a semiconductor device, and a semiconductor device.

EP 4 596 608 A1

## Description

## BACKGROUND OF THE INVENTION

1. Field of the Invention

The present invention relates to a resin composition, a cured substance, a laminate, a manufacturing method for a cured substance, a manufacturing method for a laminate, a manufacturing method for a semiconductor device, and a semiconductor device.

2. Description of the Related Art

In recent years, a resin material that has been produced from a resin composition containing a resin has been utilized in various fields.

For example, a polyimide is applied to various use applications since it has an excellent heat resistance and insulating properties. The above-described use applications are not particularly limited, and examples thereof in a semiconductor device for mounting include the use as a material of an insulating film or sealing material, or as a protective film. In addition, such a resin can also be used as a base film or a cover lay for a flexible substrate.

For example, in the above-described use applications, the polyimide is used in a form of a resin composition containing a polyimide or a polyimide precursor.

Such a resin composition is applied onto a base material by coating or the like to form a photosensitive film, and then, as necessary, subjected to exposure, development, or heating, whereby a cured substance can be formed on the base material.

The polyimide precursor is cyclized by, for example, heating, and it is converted to a polyimideduring curing.

Since the resin composition can be applied by a publicly known coating method or the like, it can be said that the resin composition is excellent in the manufacturing adaptability, for example, a high degree of freedom in designing the shape, size, application position during application of the resin composition to be applied. From the viewpoint of such excellent manufacturing adaptability in addition to the high performance possessed by the polyimide, the industrial application and development of the above-described resin composition are expected increasingly.

For example, WO2020/255859A describes a curable resin composition containing at least one resin selected from the group consisting of a polyimide and a polyimide precursor, which has a polyalkyleneoxy group and a polymerizable group, a polymerization initiator, a polymerizable compound, and a solvent.

WO2021/039782A describes a curable resin composition containing a resin having a specific repeating unit and a solvent.

## SUMMARY OF THE INVENTION

In a case where a cured substance is obtained from a resin composition containing at least one resin selected from the group consisting of a polyimide and a polyimide precursor, for example, a resin composition may be applied onto a base material having a multilayer and in which a stepped structure is formed, such as a base material on which a metal wire is formed, so that a cured substance may be formed.

Here, in a case where a cured substance is formed on a base material on which such a stepped structure is formed, it is required that the surface of the cured substance is flat.

In the present specification, the resin composition in which a cured substance having a flat surface is easily formed is also referred to as a resin composition having excellent flatness of a cured substance to be obtained.

In addition, the manufacturing method for a cured substance in which a cured substance having a flat surface is easily formed is also described as a manufacturing method for a cured substance having excellent flatness of a cured substance to be obtained.

An object of the present invention is to provide a resin composition from which a cured substance having excellent flatness is obtained, a cured substance obtained by curing the resin composition, a laminate including the cured substance, a manufacturing method for the cured substance, a manufacturing method for the laminate, a manufacturing method for a semiconductor device including the manufacturing method for the cured substance, and a semiconductor device including the cured substance.

In addition, another object of the present invention is to provide a manufacturing method for a cured substance, which has excellent flatness of a cured substance to be obtained.

Examples of representative embodiments according to the present invention are described below.

<1> A resin composition comprising:

at least one resin selected from the group consisting of a polyimide and a precursor thereof,
in which a dielectric loss tangent of a cured substance obtained by heating the resin composition at 230°C for 1 hour is less than 0.03.

<2> A resin composition comprising:

at least one resin selected from the group consisting of a polyimide and a precursor thereof,
in which a dielectric loss tangent of the resin is less than 0.025.

<3> The resin composition according to <1> or <2>, further comprising:

a polymerizable compound; and
a photopolymerization initiator.

<4> The resin composition according to <3>,
in which the polymerizable compound contains an acryloyl group.
<5> The resin composition according to any one of <1> to <4>,
in which a weight-average molecular weight of the resin is 20,000 or less.
<6> The resin composition according to any one of <1> to <5>,
in which the resin has a polymerizable group.
<7> The resin composition according to any one of <1> to <6>,
in which the resin has a vinylphenyl group.
<8> The resin composition according to any one of <1> to <7>,

in which the resin has a group obtained by removing two or more hydrogen atoms from a structure represented by Formula (A-1),

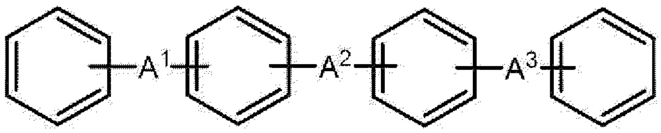

(A-1)

in Formula (A-1), $A^1$ to $A^3$ each independently represent a single bond or a divalent linking group, and four benzene rings described in Formula (A-1) may each have a substituent.

<9> The resin composition according to any one of <1> to <8>, further comprising:
a solvent having a boiling point of 180°C or lower.
<10> The resin composition according to <9>, further comprising:
a solvent having a boiling point of higher than 180°C.
<11> The resin composition according to any one of <1> to <10>, further comprising:
a surfactant.
<12> The resin composition according to <11>,
in which the surfactant is a compound containing a silicon atom.
<13> The resin composition according to any one of <1> to <12>,
in which the resin composition is used for forming an interlayer insulating film for a re-distribution layer.
<14> A cured substance obtained by curing the resin composition according to any one of <1> to <13>.
<15> A laminate comprising:

two or more layers consisting of the cured substance according to <14>; and
a metal layer provided between any of the layers consisting of the cured substance.

<16> A manufacturing method for a cured substance, further comprising:
a film forming step of applying the resin composition according to any one of <1> to <13> onto a base material to form a film.
<17> A manufacturing method for a cured substance, comprising:

a drying step of heating and drying a resin composition containing at least one resin selected from the group consisting of a polyimide and a precursor thereof, in which a dielectric loss tangent of the resin is less than 0.25,

thereby forming a film; and
a heating step of heating the film,
in which any one of the following condition i to condition v is satisfied,

condition i: a heating temperature in the drying step is 120°C or higher and lower than 150°C,
condition ii: a heating temperature in the drying step is lower than 120°C and a heating time is 5 minutes or longer,
condition iii: a heating temperature in the heating step is 240°C or higher,
condition iv: a heating temperature in the heating step is 150°C or higher and lower than 240°C, and the heating time is 3 hours or longer,
condition v: the heating step includes at least a first heating step and a second heating step performed after the first heating step, in which a heating temperature in the first heating step is 150°C or higher and lower than 200°C and a heating temperature in the second heating step is 200°C or higher.

<18> A manufacturing method for a cured substance, comprising:

a drying step of heating and drying a curable composition containing at least one resin selected from the group consisting of a polyimide and a precursor thereof, thereby forming a film; and
a heating step of heating the film,
in which a dielectric loss tangent of the obtained cured substance is less than 0.03, and
any one of the following condition i to condition v is satisfied,

condition i: a heating temperature in the drying step is 120°C or higher and lower than 150°C,
condition ii: a heating temperature in the drying step is lower than 120°C and a heating time is 5 minutes or longer,
condition iii: a heating temperature in the heating step is 240°C or higher,
condition iv: a heating temperature in the heating step is 150°C or higher and lower than 240°C, and the heating time is 3 hours or longer,
condition v: the heating step includes at least a first heating step and a second heating step performed after the first heating step, in which a heating temperature in the first heating step is 150°C or higher and lower than 200°C and a heating temperature in the second heating step is 200°C or higher.

<19> The manufacturing method for a cured substance according to <17> or <18>, further comprising:
an exposure step of selectively exposing the film and a development step of developing the film using a developer to form a pattern, between the drying step and the heating step.
<20> A manufacturing method for a laminate, comprising:
the manufacturing method for a cured substance according to <16>.
<21> A manufacturing method for a semiconductor device, comprising:
the manufacturing method for a cured substance according to <16>.
<22> A semiconductor device comprising:
the cured substance according to <14>.

According to the present invention, there are provided a resin composition from which a cured substance having excellent flatness is obtained, a cured substance obtained by curing the resin composition, a laminate including the cured substance, a manufacturing method for the cured substance, a manufacturing method for the laminate, a manufacturing method for a semiconductor device including the manufacturing method for the cured substance, and a semiconductor device including the cured substance.
In addition, according to the present invention, there is provided a manufacturing method for a cured substance, which has excellent flatness of a cured substance to be obtained.

## BRIEF DESCRIPTION OF THE DRAWINGS

Fig. 1 is a schematic cross-sectional view of a state where a cured substance is formed on a silicon wafer on which a copper wire is formed, in evaluation of flatness.
Fig. 2 is a schematic top view showing a measurement position of a film thickness of a dried film formed on a circular silicon wafer in evaluation of in-plane wafer coating uniformity.

## DESCRIPTION OF THE PREFERRED EMBODIMENTS

Hereinafter, the main embodiments according to the present invention will be described. However, the present invention is not limited to the specified embodiments.

In the present specification, a numerical value range described by using "to" means a range including numerical values described before and after the preposition "to" as a lower limit value and an upper limit value, respectively.

In the present specification, the term "step" means not only an independent step but also a step that cannot be clearly distinguished from other steps as long as the desired action of the step can be achieved.

In describing a group (an atomic group) in the present specification, in a case where a description of substitution and unsubstitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

In the present specification, the "exposure" includes not only exposure using light but also exposure using corpuscular beams such as an electron beam and an ion beam, unless otherwise specified. In addition, examples of the light that is used for exposure include an actinic ray such as a bright line spectrum of a mercury lamp, a far ultraviolet ray represented by an excimer laser, an extreme ultraviolet ray (EUV light), an X-ray, or an electron beam, and a radioactive ray.

In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the structural formulae of the present specification, Me represents a methyl group, Et represents an ethyl group, Bu represents a butyl group, and Ph represents a phenyl group.

In the present specification, the total solid content refers to the total mass of components excluding a solvent from the entire components of the composition. In addition, in the present specification, the concentration of solid contents is a mass percentage of other components excluding a solvent with respect to the total mass of the composition.

In the present specification, weight-average molecular weight (Mw) and number-average molecular weight (Mn) are each a value measured using gel permeation chromatography (GPC) unless otherwise specified, which are defined as a polystyrene equivalent value. In the present specification, the weight-average molecular weight (Mw) and the number-average molecular weight (Mn) can be determined, for example, by using HLC-8220 GPC(manufactured by Tosoh Corporation) and using GUARD COLUMN HZ-L, TSKgel Super HZM-M, TSK gel Super HZ4000, TSK gel Super HZ3000, and TSK gel Super HZ2000 (all of which are manufactured by Tosoh Corporation) as a column connected in series. The molecular weights thereof are measured using N-methyl-2-pyrrolidone (NMP) as an eluant unless otherwise specified. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between the reference layer and the other layer, and the reference layer and the other layer need not be in contact with each other. Unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such a setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise specified. The content of each component in the composition means the total content of all the compounds corresponding to the component unless otherwise specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

(Resin composition)

A resin composition according to a first aspect of the present invention (hereinafter, also simply referred to as a "first resin composition") is a resin composition containing at least one resin selected from the group consisting of a polyimide and a precursor thereof, in which a dielectric loss tangent of a cured substance obtained by heating the resin composition at 230°C for 1 hour is less than 0.03.

A resin composition according to a second aspect of the present invention (hereinafter, also simply referred to as a "second resin composition") is a resin composition containing at least one resin selected from the group consisting of a

polyimide and a precursor thereof, in which a dielectric loss tangent of the resin is less than 0.025.

Hereinafter, the first resin composition and the second resin composition are simply referred to as a "resin composition".

Hereinafter, at least one resin selected from the group consisting of a polyimide and a precursor thereof, which is contained in the first resin composition, is also referred to as a "first specific resin".

Hereinafter, the resin, which is contained in the second resin composition and is at least one resin selected from the group consisting of a polyimide and a precursor thereof and has a dielectric loss tangent of less than 0.025, is also referred to as a "second specific resin".

Hereinafter, in a case where the term "specific resin" is simply described, it refers to all of the first specific resin and the second specific resin.

The resin composition according to the embodiment of the present invention is preferably used for forming a photosensitive film that is subjected to exposure and development, and it is preferably used for forming a film that is subjected to exposure and development using a developer containing an organic solvent.

The resin composition according to the embodiment of the present invention can be used, for example, for forming an insulating film of a semiconductor device, an interlayer insulating film for a re-distribution layer, or a stress buffer film, and it is preferably used for forming an interlayer insulating film for a re-distribution layer.

In particular, one of the preferred aspects of the present invention is that the resin composition according to the embodiment of the present invention is used for forming an interlayer insulating film for a re-distribution layer.

In addition, the resin composition according to the embodiment of the present invention is preferably used for forming a photosensitive film that is subjected to negative-tone development.

In the present invention, the negative-tone development refers to development in which, in exposure and development, a non-exposed portion is removed by the development, and the positive-tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

With the resin composition according to the embodiment of the present invention, a cured substance having a low dielectric constant can be obtained.

Although the mechanism by which the above effect is obtained is not revealed, it is presumed as follows.

As described above, in the aspect in which the resin composition is applied onto the base material on which the stepped structure is formed and the cured substance is obtained by heating or the like, the flatness of the obtained cured substance may be poor.

As a result of intensive studies, the present inventors found that the deterioration of the flatness is caused by the contraction of the film during heating.

Specifically, for example, it was found that the amount of contraction is large in a portion where the film is thick, such as a portion where the wiring is not formed, as compared with a portion where the film is thin, such as a portion where the wiring is formed, and thus the portion where the wiring is not formed in the cured substance may be recessed.

Here, the cured substance according to the first aspect of the present invention has a dielectric loss tangent of less than 0.03.

In such a cured substance, it is considered that the imide ring content is low, the stacking property between polymers is deteriorated, and thus the reflowability is improved and the flatness is excellent.

In addition, the resin according to the second aspect of the present invention has a dielectric loss tangent of less than 0.025. It is considered that such a resin has a low imide ring content (after cyclization), and thus the reflowability is improved due to a decrease in the stacking property between polymers, and the flatness is excellent.

In the present invention, the reflowability refers to a property in which a film is softened and flows by heating or the like, and unevenness is averaged.

In particular, in the first aspect and the second aspect, in a case where a polyimide is used, it is considered that the number of those which are released from the resin (for example, an ester portion in the polyimide precursor) is small, and the contraction of the film due to the effect is suppressed, so that the flatness is easily improved.

Here, both WO2020/255859A and WO2021/039782A do not describe an aspect in which the dielectric loss tangent of the cured substance is less than 0.03 and an aspect in which the dielectric loss tangent of the resin is less than 0.025.

Hereinafter, the physical properties of the resin composition according to the embodiment of the present invention and the components contained in the resin composition according to the embodiment of the present invention will be described in detail.

<Dielectric loss tangent>

A dielectric loss tangent (hereinafter, also referred to as tan δ) of a cured substance obtained by heating the first resin composition at 230°C for 1 hour is less than 0.03, preferably less than 0.025, more preferably less than 0.020, and still more preferably less than 0.015.

The lower limit of the dielectric loss tangent is not particularly limited, but is preferably, for example, 0.001 or more.

A dielectric loss tangent of a cured substance obtained by heating the second resin composition at 230°C for 1 hour is preferably less than 0.03, more preferably less than 0.025, still more preferably less than 0.020, and particularly preferably less than 0.015.

The lower limit of the dielectric loss tangent is not particularly limited, but is preferably, for example, 0.001 or more.

In the details of the measuring method for the tan δ of the cured substance, the tan δ can be measured by the method described in Examples described later.

<Specific resin>

The first resin composition contains at least one resin (first specific resin) selected from the group consisting of a polyimide and a precursor thereof.

The second resin composition includes a resin (second specific resin) which is at least one resin selected from the group consisting of a polyimide and a precursor thereof and has a dielectric loss tangent of less than 0.025.

The dielectric loss tangent of the first specific resin is preferably less than 0.025, more preferably less than 0.020, still more preferably less than 0.015, and particularly preferably less than 0.010.

The lower limit of the dielectric loss tangent is not particularly limited, but is preferably, for example, 0.001 or more.

The dielectric loss tangent of the second specific resin is less than 0.025, preferably less than 0.020, more preferably less than 0.015, and still more preferably less than 0.010.

The lower limit of the dielectric loss tangent is not particularly limited, but is preferably, for example, 0.001 or more.

In the details of the measuring method for the tan δ of the specific resin, the tan δ can be measured by the method described in Examples described later.

In addition, for example, in a case where a plurality of resins are included as the first specific resin, the dielectric loss tangent of at least one of the resins may be within the above-described range. In addition, a preferred aspect of the present invention is also that the dielectric loss tangent of all the resins of the plurality of resins is within the above-described range.

Here, the content of the resin having a dielectric loss tangent within the above range with respect to the total mass of the first specific resin is preferably 50% by mass or more, more preferably 60% by mass or more, and still more preferably 70% by mass or more. The upper limit of the content is not particularly limited, and an aspect in which the content is 100% by mass is also one of the preferred aspects of the present invention.

The resin composition according to the embodiment of the present invention preferably contains a polyimide as the specific resin.

The specific resin preferably has a polymerizable group and more preferably contains a radically polymerizable group.

In a case where the specific resin has a radically polymerizable group, the resin composition according to the embodiment of the present invention preferably contains a radical polymerization initiator, and it more preferably contains a radical polymerization initiator and a radical crosslinking agent. Further, a sensitizing agent can be contained as necessary. From such a resin composition, for example, a negative-tone photosensitive film is formed.

Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring directly bonded to a vinyl group, a (meth)acrylamide group, and a (meth)acryloyloxy group, and a group having an aromatic ring directly bonded to a vinyl group, a (meth)acrylamide group, or a (meth)acryloyloxy group is preferable, and a vinylphenyl group is more preferable.

The polymerizable group value (the total molar amount of polymerizable groups with respect to 1 g of the specific resin) in the specific resin is preferably 0.0001 to 0.1 mol/g and more preferably 0.001 to 0.05 mol/g.

In addition, the specific resin may have a polarity converting group such as an acid-decomposable group.

In a case where the specific resin has an acid-decomposable group, it is preferable that the resin composition contains a photoacid generator. From such a resin composition, for example, a positive-tone photosensitive film or a negative-tone photosensitive film, which is a chemical amplification type photosensitive film, is formed.

The specific resin preferably has a group obtained by removing two or more hydrogen atoms from a structure represented by Formula (A-1), and more preferably has a group obtained by removing two or more hydrogen atoms from a structure represented by Formula (A-2).

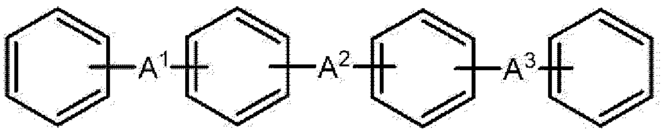

(A-1)

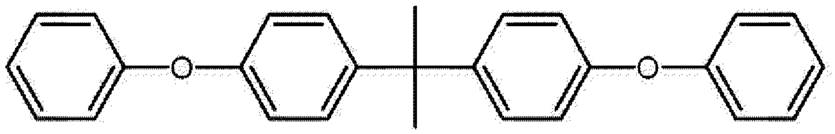

(A-2)

In Formula (A-1), $A^1$ to $A^3$ each independently represent a single bond or a divalent linking group, and four benzene rings described in Formula (A-1) may each have a substituent.

$A^1$ to $A^3$ are each preferably an aliphatic hydrocarbon group having 1 to 10 carbon atoms, which may be substituted with a fluorine atom, -O-, -C(=O)-, -S-, $-S(=O)_2-$, -NHC(=O)-, or a group consisting of a combination of two or more of these, more preferably an aliphatic hydrocarbon group having 1 to 10 carbon atoms, which may be substituted with a fluorine atom, -O-, -C(=O)-, or a group consisting of a combination of two or more of these, and still more preferably an aliphatic hydrocarbon group having 1 to 10 carbon atoms, which may be substituted with a fluorine atom, or -O-.

In particular, $A^1$ and $A^3$ are preferably -O-.

In particular, $A^2$ is preferably an aliphatic hydrocarbon group having 1 to 10 carbon atoms, which may be substituted with a fluorine atom.

Among these, an aspect in which $A^1$ and $A^3$ are -O- and $A^2$ is $-C(CH_3)_2-$ is also one of the preferred aspects of the present invention.

The number of carbon atoms in the aliphatic hydrocarbon group having 1 to 10 carbon atoms, which may be substituted with a fluorine atom, is not particularly limited, but is preferably 1 to 6 and more preferably 1 to 4.

Specific examples of the aliphatic hydrocarbon group having 1 to 10 carbon atoms, which may be substituted with a fluorine atom, include -CH2-, -C(CH3)2-, and -C(CF3)2-, and among these, -C(CH3)2- is preferable.

Examples of the substituent in the four benzene rings described in Formula (A-1) include a fluorine atom and a hydrocarbon group having 1 to 10 carbon atoms, in which the hydrogen atom may be substituted with a fluorine atom.

In addition, an aspect in which all four benzene rings described in Formula (A-1) are unsubstituted is also one of the preferred aspects of the present invention.

In addition, it is preferable that the specific resin includes a structure represented by Formula (A-1) as R115 or R111 in Formula (2) described later. These aspects will be described later.

Specific examples of the structure represented by Formula (A-1) will be described below, but the present invention is not limited thereto.

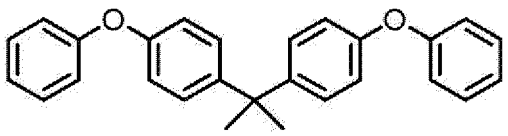

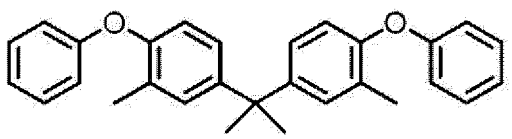

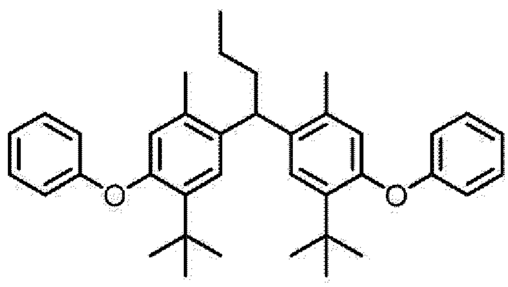

In addition, an aspect in which the weight-average molecular weight of the specific resin is 20,000 or less is also one of the preferred aspects of the present invention.

It is considered that, by adopting such an aspect, the flatness is excellent since the reflow is likely to occur during the heating step, and the solubility of the resin composition in a developer is excellent, and thus the resolution of the obtained cured substance is excellent.

The above-described weight-average molecular weight is preferably 17,000 or less, more preferably 13,000 or less, and still more preferably 10,000 or less.

The lower limit of the weight-average molecular weight is not particularly limited, but is preferably 5,000 or more.

[Polyimide precursor]

The kind and the like of the polyimide precursor used in the present invention are not particularly limited, but it is preferable that the polyimide precursor contains a repeating unit represented by Formula (2).

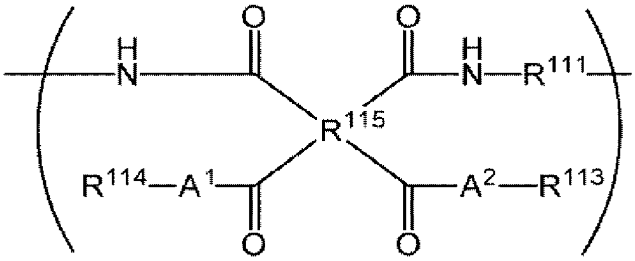

(2)

In Formula (2), $A^1$ and $A^2$ each independently represent an oxygen atom or $-NR^z-$, $R^{111}$ represents a divalent organic group, $R^{115}$ represents a tetravalent organic group, $R^{113}$ and $R^{114}$ each independently represent a hydrogen atom or a monovalent organic group, and $R^Z$ represents a hydrogen atom or a monovalent organic group.

$A^1$ and $A^2$ in Formula (2) each independently represent an oxygen atom or $-NR^Z-$, and an oxygen atom is preferable.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of $R^{111}$ in Formula (2) include groups represented by -Ar- and -Ar-L-Ar-, respectively, and a group represented by -Ar-L-Ar- is preferable. However, Ar's are each independently an aromatic group, and L is a single bond or an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, $R^{111}$ is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

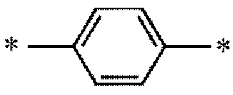

AR-1

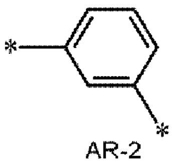

AR-2

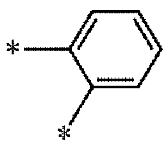

AR-3

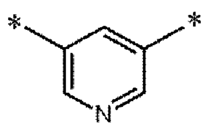

AR-4

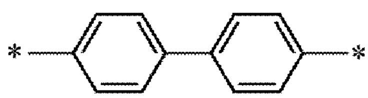

AR-5

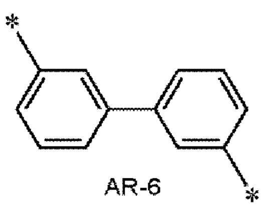

AR-6

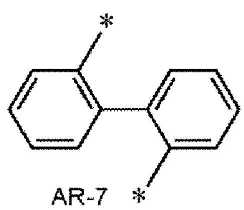

AR-7

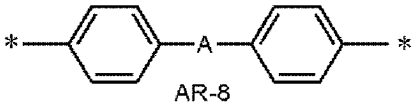
AR-8
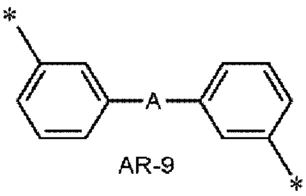
AR-9
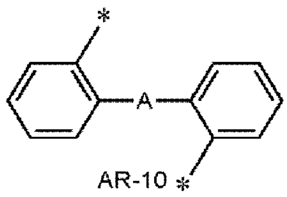
AR-10

In Formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In Formulae, * represents a bonding site to another structure.

Specific examples of diamine include at least one diamine selected from 1,2-diaminoethane, 1,2-diaminopropane, 1,3-diaminopropane, 1,4-diaminobutane, or 1,6-diaminohexane;

1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, and isophoronediamine;

m- or p-phenylenediamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4'-bis(4-aminophenoxy) biphenyl, bis[4-(4-aminophenoxy)phenyl]sulfone, bis[4-(3-aminophenoxy)phenyl]sulfone, bis[4-(2-aminophenoxy) phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenyl) benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- and 2,5-diaminocumen, 2,5-dimethyl-p-phenylenediamine, acetoguanamine, 2,3,5,6-tetramethyl-p-phenylenediamine, 2,4,6-trimethyl-m-phenylenediamine, bis(3-aminopropyl)tetramethyldisiloxane, bis(p-aminophenyl)octamethylpentasiloxane, 2,7-diaminofluorene, 2,5-diaminopyridine, 1,2-bis(4-aminophenyl)ethane, diaminobenzanilide, an ester of diaminobenzoic acid, 1,5-diaminonaphthalene, diaminobenzotrifluoride, 1,3-bis(4-aminophenyl) hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis [4-(4-aminophenoxy)-3,5-bis(trifluoromethyl)phenyl]hexafluoropropane, p-bis(4-amino-2-trifluoromethylphenoxy) benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, and 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

Formula (51)

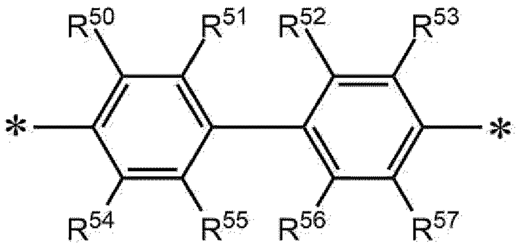

(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6 carbon atoms) carbon atoms and a fluorinated alkyl group having 1 to 10 (preferably 1 to 6 carbon atoms) carbon atoms.

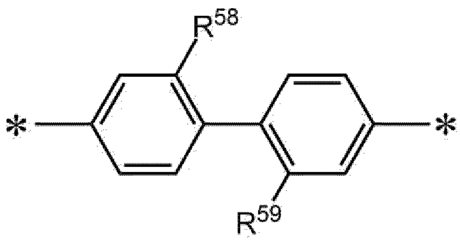

(61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, 2,2'-bis(fluoro)-4,4'-diaminobiphenyl, and 4,4'-diaminooctafluorobiphenyl. These may be used alone, or two or more kinds thereof may be used in combination.

In addition, $R^{111}$ is also preferably a group represented by Formula (71). In the above-described aspect, $R^{111}$ is more preferably a group represented by Formula (72).

Formula (71) is a group obtained by removing two hydrogen atoms from the structure represented by Formula (A-1) described above, and Formula (72) is a group obtained by removing two hydrogen atoms from the structure represented by Formula (A-2) described above.

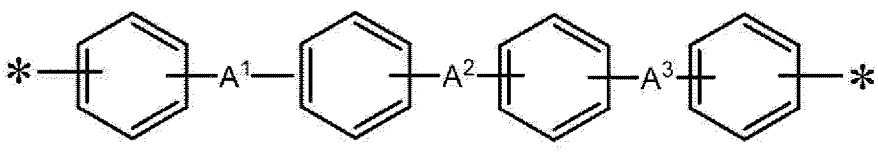

(71)

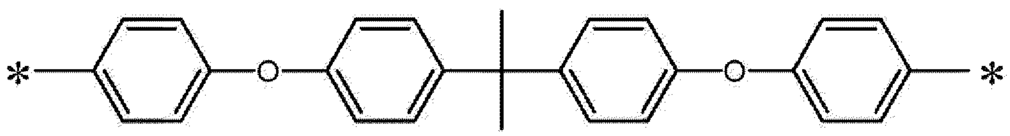

(72)

In Formula (71), $A^1$ to $A^3$ each independently represent a single bond or a divalent linking group, * represents a bonding site to a nitrogen atom in Formula (2), and the four benzene rings described in Formula (71) may each have a substituent.

In Formula (72), * represents a bonding site to the nitrogen atom in Formula (2).

In Formula (71), the preferred aspects of $A^1$ to $A^3$ and the substituent in the benzene ring are the same as the preferred aspects of $A^1$ to $A^3$ in Formula (A-1) and the substituent in the benzene ring.

$R^{115}$ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

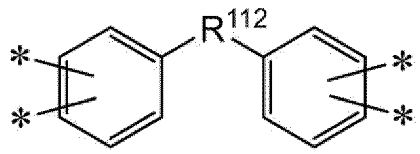
(5)

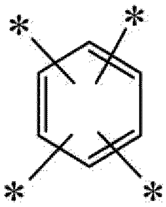
(6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or $-SO_2-$, and still more preferably a divalent group selected from the group consisting of $-CH_2-$, $-C(CF_3)_2-$, $-C(CH_3)_2-$, -O-, -CO-, -S-, and $-SO_2-$.

In addition, $R^{115}$ is also preferably a group represented by Formula (7). In the above-described aspect, $R^{111}$ is more preferably a group represented by Formula (7-2).

Formula (7) is a group obtained by removing four hydrogen atoms from the structure represented by Formula (A-1) described above, and Formula (7-2) is a group obtained by removing four hydrogen atoms from the structure represented by Formula (A-2) described above.

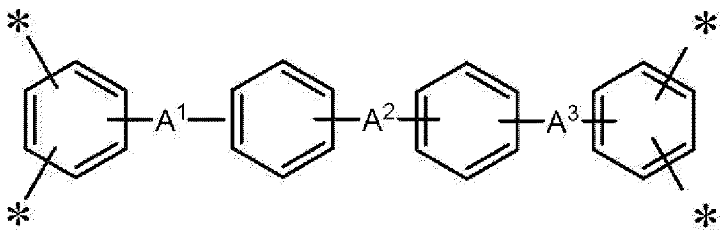
(7)

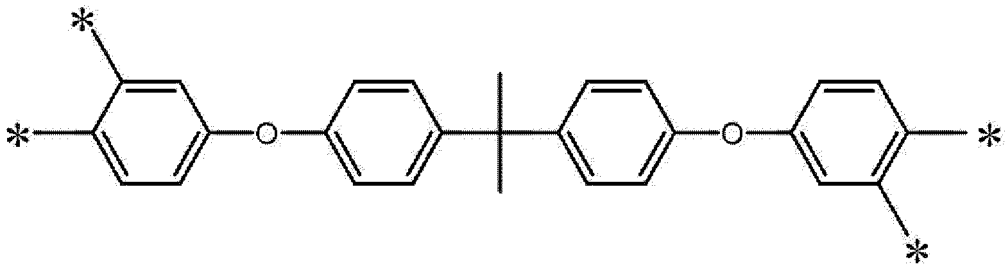
(7-2)

In Formula (7), $A^1$ to $A^3$ each independently represent a single bond or a divalent linking group, * represents a bonding site to a carbonyl group in Formula (2), and the four benzene rings described in Formula (7) may each have a substituent.

In the present specification, a bond that intersects with a side of a ring structure means that any hydrogen atom in the ring structure is substituted.

In Formula (7-2), * represents a bonding site to the carbonyl group in Formula (2).

In Formula (7), the preferred aspects of $A^1$ to $A^3$ and the substituent in the benzene ring are the same as the preferred aspects of $A^1$ to $A^3$ in Formula (A-1) and the substituent in the benzene ring.

Specific examples of $R^{115}$ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to $R^{115}$.

The tetracarboxylic acid dianhydride is preferably represented by Formula (O).

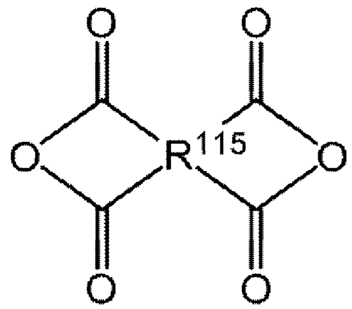

(O)

In Formula (O), $R^{115}$ represents a tetravalent organic group. $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

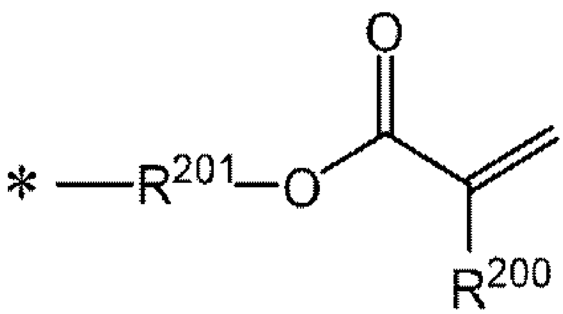

(III)

In Formula (III), $R^{200}$ represents a hydrogen atom, a methyl group, an ethyl group, or a methylol group, where a

hydrogen atom or a methyl group is preferable.

In Formula (III), * represents a bonding site to another structure.

In Formula (III), $R^{201}$ represents an alkylene group having 2 to 12 carbon atoms, $-CH_2CH(OH)CH_2-$, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, $-CH_2CH(OH)CH_2-$, and a polyalkyleneoxy group, where an alkylene group such as an ethylene group or a propylene group, $-CH_2CH(OH)CH_2-$, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a randomly arranged sequence, may be a sequence arranged to have a block, or may be a sequence arranged to have an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even more preferably 2 to 5, even still more preferably 2 to 4, even further still more preferably 2 or 3, and particularly preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polyethyleneoxy group or a polypropyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom, or in a case where $R^{114}$ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (2), at least one of $R^{113}$ or $R^{114}$ may be a polarity converting group such as an acid-decomposable group. The acid-decomposable group is not particularly limited as long as it decomposes by the action of the acid to generate an alkali-soluble group such as a phenolic hydroxy group or a carboxy group; however, it is preferably an acetal group, a ketal group, a silyl group, or a silyl ether group, a tertiary alkyl ester group, or the like, and from the viewpoint of exposure sensitivity, it is more preferably an acetal group or a ketal group.

Specific examples of the acid-decomposable group include a tert-butoxycarbonyl group, an isopropoxycarbonyl group, a tetrahydropyranyl group, a tetrahydrofuranyl group, an ethoxyethyl group, a methoxyethyl group, an ethoxymethyl group, a trimethylsilyl group, a tert-butoxycarbonylmethyl group, and a trimethylsilyl ether group. From the viewpoint of exposure sensitivity, an ethoxyethyl group or a tetrahydrofuranyl group is preferable.

The polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a substrate, the polyimide precursor may be copolymerized with an aliphatic group having a siloxane structure. Specifically, an aspect in which bis(3-aminopropyl) tetramethyldisiloxane, bis(p-aminophenyl)octamethylpentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating unit represented by Formula (2-A). In a case where the polyimide precursor contains a repeating unit represented by Formula (2-A), it is possible to further widen the width of the exposure latitude.

Formula (2-A)

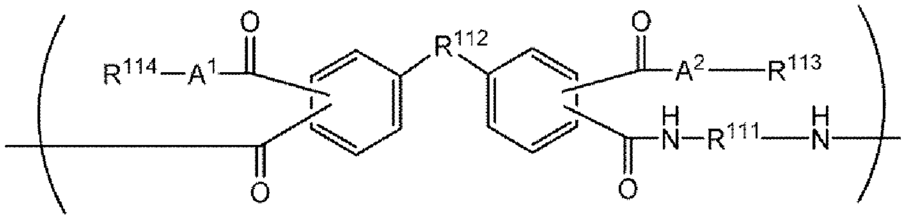

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group, where both of them are preferably a group containing a polymerizable group.

$A^1$, $A^2$, $R^{111}$, $R^{113}$, and $R^{114}$ each independently have the same meaning as $A^1$, $A^2$, $R^{111}$, $R^{113}$, and $R^{114}$ in Formula (2), respectively, and the same applies to the preferred ranges thereof.

$R^{112}$ has the same meaning as $R^{112}$ in Formula (5), and the same applies to the preferred range thereof.

In addition, it is also preferable that the polyimide precursor contains a repeating unit represented by Formula (1-2) as the repeating unit represented by Formula (2).

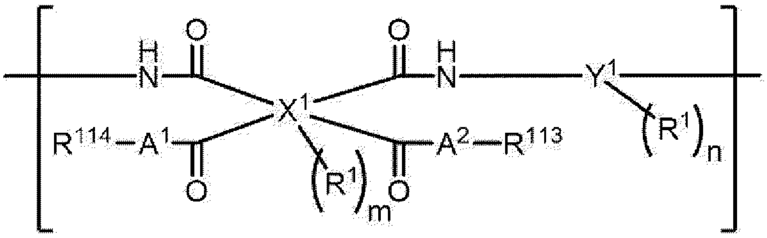

(1-2)

In Formula (1-2), $A^1$ and $A^2$ each independently represent an oxygen atom or $-NR^z-$, $X^1$ represents an organic group having 4 or more carbon atoms, $Y^1$ represents an organic group having 4 or more carbon atoms, $R^1$'s each independently represent a structure represented by Formula (R-1), $R^{113}$ and $R^{114}$ each independently represent a hydrogen atom or a monovalent organic group, $R^z$ represents a hydrogen atom or a monovalent organic group, m represents an integer of 0 to 4, and n represents an integer of 1 or more.

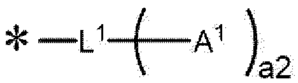

(R-1)

In Formula (R-1), $L^1$ represents an (a2+1)-valent linking group, $A^1$ represents a polymerizable group, a2 represents an integer of 1 or more, and * represents a bonding site to $X^1$ or $Y^1$ in Formula (1-2).

Preferred aspects of $X^1$, $Y^1$, $R^1$, n, and m in Formula (1-2) are the same as the preferred aspects of $X^1$, $Y^1$, $R^1$, n, and m in Formula (1-1) described later.

Preferred aspects of $A^1$, $A^2$, $R^{113}$, and $R^{114}$ in Formula (1-2) are the same as the preferred aspects of $A^1$, $A^2$, $R^{113}$, and $R^{114}$ in Formula (2) described above.

The polyimide precursor may contain one kind of repeating unit represented by Formula (2) or may contain two or more kinds thereof. In addition, the polyimide precursor may contain structural isomers of the repeating unit represented by Formula (2). The polyimide precursor may also contain another kind of repeating unit in addition to the above repeating unit represented by Formula (2).

One embodiment of the polyimide precursor in the present invention includes an aspect in which the content of the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyimide precursor excluding the terminal may be the repeating unit represented by Formula (2).

The weight-average molecular weight (Mw) of the polyimide precursor is preferably 5,000 to 100,000, more preferably 6,000 to 50,000, and still more preferably 7,000 to 20,000. The number-average molecular weight (Mn) of the polyimide precursor is preferably 2,000 to 40,000, more preferably 3,000 to 20,000, and still more preferably 4,000 to 10,000.

The dispersivity of the molecular weight of the polyimide precursor is preferably 1.5 or more, more preferably 1.8

or more, and still more preferably 2.0 or more. The upper limit value of the dispersivity of the molecular weight of the polyimide precursor is not particularly limited; however, it is, for example, preferably 7.0 or less, more preferably 6.5 or less, and still more preferably 6.0 or less.

In the present specification, the dispersity of the molecular weight is a value obtained by calculating "weight-average molecular weight/number-average molecular weight".

In a case where the resin composition contains a plurality of kinds of polyimide precursors as the specific resin, it is preferable that the weight-average molecular weight, the number-average molecular weight, and the dispersivity of at least one kind of polyimide precursor are in the above ranges. Further, it is also preferable that the weight-average molecular weight, the number-average molecular weight, and the dispersity, calculated by using the plurality of kinds of polyimide precursors as one resin, are within the above ranges.

[Polyimide]

The polyimide that is used in the present invention may be an alkali-soluble polyimide or may be a polyimide soluble in a developer containing an organic solvent as a main component.

In the present specification, the alkali-soluble polyimide refers to a polyimide, 0.1 g or more of which is dissolved in 100 g of an aqueous solution of 2.38% by mass of tetramethylammonium at 23°C, and from the viewpoint of pattern formation properties, it is preferably a polyimide, 0.5 g or more of which is dissolved therein and still more preferably a polyimide, 1.0 g or more of which is dissolved therein. The upper limit of the dissolution amount is not particularly limited; however, it is preferably 100 g or less.

The polyimide is preferably a polyimide having a plurality of imide structures in the main chain from the viewpoint of the film hardness and the insulating properties of the organic film to be obtained.

-Fluorine atom-

From the viewpoint of the film hardness of the organic film to be obtained, the polyimide preferably has a fluorine atom.

The fluorine atom is preferably contained in, for example, $R^{132}$ in a repeating unit represented by Formula (4) described later or $R^{131}$ in a repeating unit represented by Formula (4) described later, and it is more preferably contained, as a fluorinated alkyl group, in $R^{132}$ in a repeating unit represented by Formula (4) described later or $R^{131}$ in a repeating unit represented by Formula (4) described later.

The amount of fluorine atoms with respect to the total mass of the polyimide is preferably 5% by mass or more, and it is preferably 20% by mass or less.

-Silicon atom-

From the viewpoint of the film hardness of the organic film to be obtained, it is also preferable that the polyimide has a silicon atom.

The silicon atom is preferably contained in, for example, $R^{131}$ in a repeating unit represented by Formula (4) described later, and more preferably contained in $R^{131}$ in a repeating unit represented by Formula (4) described later as an organically modified (poly)siloxane structure.

The silicon atom or the organically modified (poly)siloxane structure may be contained in the side chain of the polyimide; however, it is preferably contained in the main chain of the polyimide.

The amount of silicon atoms with respect to the total mass of the polyimide is preferably 1% by mass or more and more preferably 20% by mass or less.

-Ethylenically unsaturated bond-

From the viewpoint of the film hardness of the organic film to be obtained, the polyimide preferably has an ethylenically unsaturated bond.

The polyimide may have an ethylenically unsaturated bond at the terminal of the main chain or the side chain; however, it preferably has an ethylenically unsaturated bond at the side chain.

The ethylenically unsaturated bond preferably has radical polymerizability.

The ethylenically unsaturated bond is preferably included in $R^{132}$ or $R^{131}$ in the repeating unit represented by Formula (4) described later, and more preferably included in $R^{132}$ or $R^{131}$ as a group having an ethylenically unsaturated bond.

Among these, the ethylenically unsaturated bond is preferably included in $R^{131}$ in the repeating unit represented by Formula (4) described later, and more preferably included in $R^{131}$ as a group having an ethylenically unsaturated bond.

Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, a (meth)acryloyloxy group, and a group represented by Formula (IV).

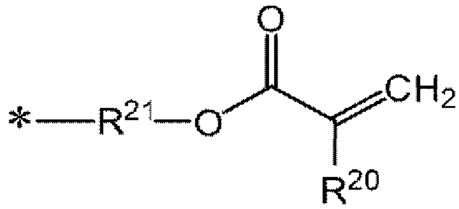

(IV)

In Formula (IV), $R^{20}$ represents a hydrogen atom, a methyl group, an ethyl group, or a methylol group, where a hydrogen atom or a methyl group is preferable.

In Formula (IV), $R^{21}$ represents an alkylene group having 2 to 12 carbon atoms, $-O-CH_2CH(OH)CH_2-$, -C(=O)O-, -O(C=O)NH-, a (poly)alkyleneoxy group having 2 to 30 carbon atoms (the alkylene group preferably has 2 to 12 carbon atoms, more preferably 2 to 6 carbon atoms, and particularly preferably 2 or 3 carbon atoms, and the number of repetitions of alkyleneoxy group is preferably 1 to 12, more preferably 1 to 6, and particularly preferably 1 to 3), or a group obtained by combining two or more of these.

The alkylene group having 2 to 12 carbon atoms may be a linear one, a branched one, or a cyclic one, or may be any alkylene group represented by a combination of these.

The alkylene group having 2 to 12 carbon atoms is preferably an alkylene group having 2 to 8 carbon atoms and more preferably an alkylene group having 2 to 4 carbon atoms.

Among the above, $R^{21}$ is preferably a group represented by any one of Formulae (R1) to (R3) and more preferably a group represented by Formula (R1).

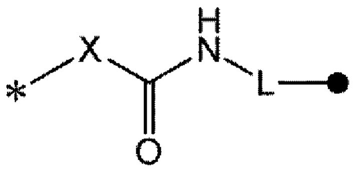

(R1)

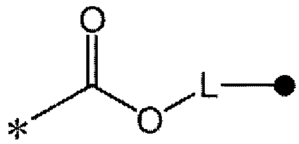

(R2)

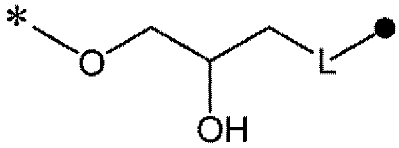

(R3)

In Formulae (R1) to (R3), L represents a single bond, an alkylene group having 2 to 12 carbon atoms, a (poly) alkyleneoxy group having 2 to 30 carbon atoms, or a group obtained by bonding two or more of these, X represents an oxygen atom or a sulfur atom, * represents a bonding site to another structure, and • represents a bonding site to an oxygen atom to which $R^{21}$ in Formula (IV) is bonded.

In Formulae (R1) to (R3), the preferred aspect of the alkylene group having 2 to 12 carbon atoms as L or the (poly) alkyleneoxy group having 2 to 30 carbon atoms is the same as the preferred aspect of the alkylene group having 2 to 12 carbon atoms as $R^{21}$ in Formula (IV) or the (poly)alkyleneoxy group having 2 to 30 carbon atoms.

In Formula (R1), X is preferably an oxygen atom.

In Formulae (R1) to (R3), * has the same meaning as * in Formula (IV), and the same applies to the preferred aspect thereof.

The structure represented by Formula (R1) is obtained, for example, by reacting a polyimide having a hydroxy group such as a phenolic hydroxy group with a compound (for example, 2-isocyanatoethyl methacrylate) having an isocyanato group and an ethylenically unsaturated bond.

The structure represented by Formula (R2) is obtained, for example, by reacting a polyimide having a carboxy group with a compound (for example, 2-hydroxyethyl methacrylate) having a hydroxy group and an ethylenically unsaturated bond.

The structure represented by Formula (R3) is obtained, for example, by reacting a polyimide having a hydroxy group such as a phenolic hydroxy group with a compound (for example, glycidyl methacrylate) having a glycidyl group and an ethylenically unsaturated bond.

In Formula (IV), * represents a bonding site to another structure, and it is preferably a bonding site to the main chain of the polyimide.

The amount of the ethylenically unsaturated bond with respect to the total mass of the polyimide is preferably 0.0001 to 0.1 mol/g and more preferably 0.001 to 0.05 mol/g.

-Polymerizable group other than group having ethylenically unsaturated bond-

The polyimide may have a polymerizable group other than the group having an ethylenically unsaturated bond.
Examples of the polymerizable group other than the group having an ethylenically unsaturated bond include a cyclic ether group such as an epoxy group or an oxetanyl group, an alkoxymethyl group such as a methoxymethyl group, and a methylol group.
The polymerizable group other than the group having an ethylenically unsaturated bond is preferably contained in, for example, $R^{131}$ in a repeating unit represented by Formula (4) described later.
The amount of the polymerizable group other than the group having an ethylenically unsaturated bond with respect to the total mass of the polyimide is preferably 0.0001 to 0.1 mol/g and more preferably 0.001 to 0.05 mol/g.

-Polarity converting group-

The polyimide may have a polarity converting group such as an acid-decomposable group. The acid-decomposable group in the polyimide is the same as the acid-decomposable group described in $R^{113}$ and $R^{114}$ in Formula (2) described above, and the same applies to the preferred aspect thereof.
The polarity converting group is contained, for example, in $R^{131}$ or $R^{132}$ in the repeating unit represented by Formula (4) described later, or a terminal of the polyimide.

-Acid value-

In a case where the polyimide is subjected to alkaline development, the acid value of the polyimide is preferably 30 mgKOH/g or more, more preferably 50 mgKOH/g or more, and still more preferably 70 mgKOH/g or more, from the viewpoint of improving developability.
The acid value thereof is preferably 500 mgKOH/g or less, more preferably 400 mgKOH/g or less, and still more preferably 200 mgKOH/g or less.
In a case where the polyimide is subjected to the development (for example, the "solvent development") using a developer containing an organic solvent as a main component, the acid value of the polyimide is preferably 1 to 35 mgKOH/g, more preferably 2 to 30 mgKOH/g, and still more preferably 5 to 20 mgKOH/g.
The acid value is measured by a known method, for example, by the method described in JIS K0070: 1992.
The acid group contained in the polyimide is preferably an acid group having a pKa of 0 to 10 and more preferably an acid group having a pKa of 3 to 8 from the viewpoint of achieving both storage stability and developability.
The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is defined as a calculated value according to ACD/ChemSketch (registered trademark). pKa may refer to the values published in "Handbook of Chemistry, Pure Chemistry, 5th Edition" edited by the Chemical Society of Japan.
In a case where the acid group is a polyvalent acid such as phosphoric acid, the pKa is the first dissociation constant.
As such an acid group, the polyimide preferably contains at least one selected from the group consisting of a carboxy group and a phenolic hydroxy group and more preferably contains a phenolic hydroxy group.

-Phenolic hydroxy group-

From the viewpoint of allowing the speed of development with an alkaline developer to be proper, the polyimide preferably has a phenolic hydroxy group.
The polyimide may have a phenolic hydroxy group at the terminal of the main chain or the side chain.
The phenolic hydroxy group is preferably contained in, for example, $R^{132}$ or $R^{131}$ in a repeating unit represented by Formula (4) described later.
The amount of the phenolic hydroxy group with respect to the total mass of the polyimide is preferably 0.1 to 30 mol/g and more preferably 1 to 20 mol/g.
The polyimide that is used in the present invention is not particularly limited as long as it is a polymer compound having an imide structure; however, it is preferable that the polyimide contains a repeating unit represented by Formula (4).

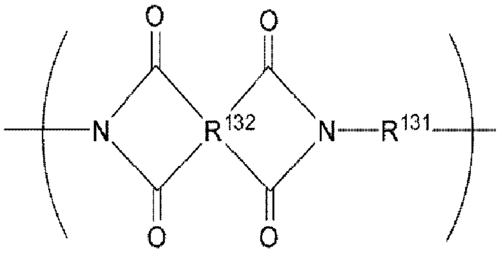

(4)

In Formula (4), $R^{131}$ represents a divalent organic group, and $R^{132}$ represents a tetravalent organic group.

Here, in the repeating unit represented by Formula (4), one imide structure may be ring-opened as in a structure represented by Formula (4-A). In the structure represented by Formula (4-A), the left side of the two imide rings is ring-opened, but the right side may also be ring-opened. Similarly, in Formula (4-1), Formula (4-2), and Formula (1-1), one imide structure may be ring-opened.

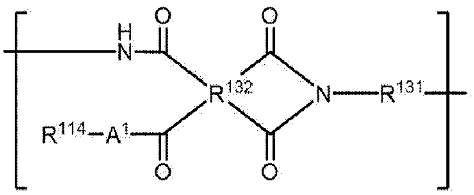

(4-A)

In Formula (4-A), $R^{131}$ represents a divalent organic group, $R^{132}$ represents a tetravalent organic group, $A^1$ represents an oxygen atom or $-NR^z-$, $R^{114}$ represents a hydrogen atom or a monovalent organic group, and $R^z$ represents a hydrogen atom or a monovalent organic group.

In Formula (4-A), preferred aspects of $R^{131}$ and $R^{132}$ are the same as the preferred aspects of $R^{131}$ and $R^{132}$ in Formula (4).

In Formula (4-A), preferred aspects of $A^1$ and $R^{114}$ are the same as the preferred aspects of $A^1$ and $R^{114}$ in Formula (2).

In a case where a polymerizable group is contained, the polymerizable group may be located at at least one of $R^{131}$ or $R^{132}$ or may be located at the terminal of the polyimide as shown in Formula (4-1) or Formula (4-2).

Formula (4-1)

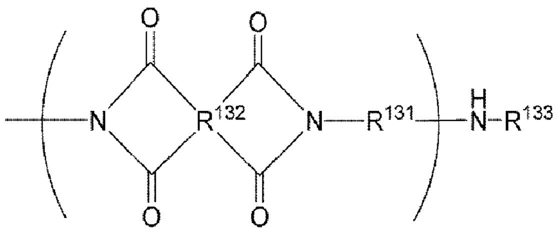

In Formula (4-1), $R^{133}$ is a polymerizable group, and the other groups respectively have the same meanings as those in Formula (4).

Formula (4-2)

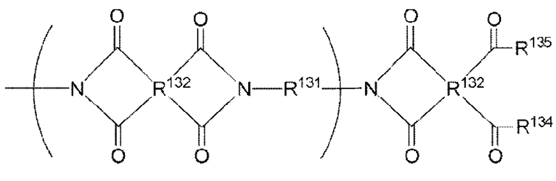

At least one of $R^{134}$ or $R^{135}$ is a polymerizable group, where it is an organic group in a case of not being a polymerizable group, and the other groups respectively have the same meanings as those in Formula (4).

Examples of the polymerizable group include the above-described group having an ethylenically unsaturated bond or a crosslinkable group other than the above-described group having an ethylenically unsaturated bond.

$R^{131}$ represents a divalent organic group. Examples of the divalent organic group include the same one as $R^{111}$ in Formula (2), and the same applies to the preferred range thereof.

Examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trade name) KH-511, ED-600, ED-900, ED-2003, EDR-148, EDR-176, D-200, D-400, D-2000, D-4000 (all product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

Examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and more preferred examples of $R^{132}$ include the above (DAA-1) to (DAA-5).

In addition, it is also preferable that the polyimide contains a repeating unit represented by Formula (1-1) as the repeating unit represented by Formula (4).

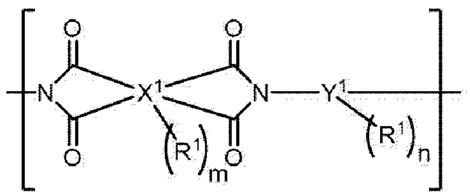 (1-1)

In Formula (1-1), $X^1$ represents an organic group having 4 or more carbon atoms, $Y^1$ represents an organic group having 4 or more carbon atoms, $R^1$'s each independently represent a structure represented by Formula (R-1), m represents an integer of 0 to 4, and n represents an integer of 1 or more.

$$*-L^1\left(-A^1\right)_{a2} \qquad \text{(R-1)}$$

In Formula (R-1), $L^1$ represents an (a2+1)-valent linking group, $A^1$ represents a polymerizable group, a2 represents an integer of 1 or more, and * represents a bonding site to $X^1$ or $Y^1$ in Formula (1-1).

$-R^1-$

$R^1$'s each independently represent a structure represented by Formula (R-1).

In Formula (R-1), $L^1$ represents an (a2+1)-valent linking group.

$L^1$ is preferably a group represented by Formula (L-1).

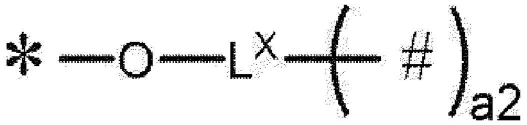

(L-1)

In Formula (L-1), $L^X$ represents an (a2+1)-valent linking group, a2 represents an integer of 1 or more, * represents a bonding site to $X^1$ or $Y^1$ in Formula (1-1), and # represents a bonding site to $Z^1$ in Formula (R-1).
$L^x$ is preferably an alkylene group, more preferably an alkylene group having 1 to 10 carbon atoms, and still more preferably an alkylene group having 1 to 4 carbon atoms.
The preferred aspect of a2 in Formula (L-1) is the same as the preferred aspect of a2 in Formula (R-1).

$-A^1-$

$A^1$ in Formula (R-1) represents a polymerizable group, and the preferred aspect of the polymerizable group is the same as the preferred aspect of the polymerizable group in the specific resin described above.
Among these, at least one of $A^1$ in Formula (R-1) included in Formula (1-1) is preferably a group having an aromatic ring directly bonded to a vinyl group, a (meth)acrylamide group, or a (meth)acryloyloxy group, and more preferably a vinylphenyl group.

-a2-

In Formula (R-1), a2 represents an integer of 1 or more, and is preferably 1 or 2 and more preferably 1.
In addition, the number of ester bonds included in Formula (R-1) is preferably 1 or 0.

$-X^1-$

In Formula (1-1), it is preferable that $X^1$ includes a structure obtained by removing two or more hydrogen atoms from a structure represented by any one of Formulae (V-1) to (V-4).

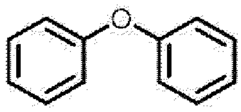

(V-1)

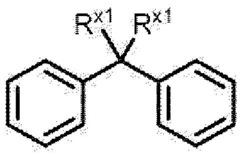

(V-2)

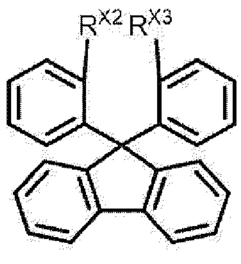

(V-3)

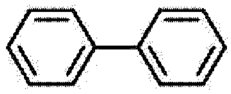

(V-4)

In Formula (V-2), $R^{X1}$'s each independently represent a hydrogen atom, an alkyl group, or a halogenated alkyl group.
In Formula (V-3), $R^{X2}$ and $R^{X3}$ each independently represent a hydrogen atom or a substituent, and $R^{X2}$ and $R^{X3}$ may be bonded to each other to form a ring structure.
In Formula (V-2), $R^{X1}$'s are each independently preferably an alkyl group or a halogenated alkyl group, more preferably an alkyl group having 1 to 4 carbon atoms or a halogenated alkyl group having 1 to 4 carbon atoms, and still more preferably a methyl group or a trifluoromethyl group. The halogenated alkyl group refers to a group in which at least one hydrogen atom of an alkyl group is substituted with a halogen atom. As the halogen atom, F or Cl is preferable, and F is more preferable.
In Formula (V-3), $R^{X2}$ and $R^{X3}$ are each independently preferably a hydrogen atom.
In a case where $R^1$ and $R^2$ are bonded to each other to form a ring structure, the structure formed by the bonding of $R^{X2}$ and $R^{X3}$ is preferably a single bond, -O-, or $-CR_2-$, more preferably -O- or $-CR_2-$, and still more preferably -O-. R represents a hydrogen atom or a monovalent organic group, preferably a hydrogen atom, an alkyl group, or an aryl group, and more preferably a hydrogen atom.
In a case where $X^1$ is a group including a structure obtained by removing two or more hydrogen atoms from a structure represented by Formula (V-1), $X^1$ is preferably a group represented by Formula (V-1-1). In the following Formula, * represents a bonding site to four carbonyl groups to which $X^1$ in Formula (1-1) is bonded, and n1 represents an integer of 0 to 5, and it is also preferable that n1 is an integer of 1 to 5. In addition, the hydrogen atom in the following structure may be

further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

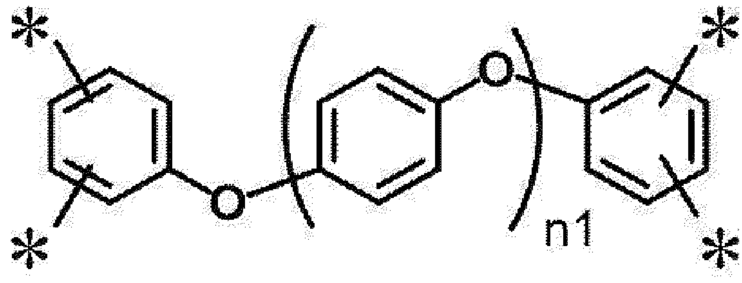

(V-1-1)

In a case where $X^1$ is a group including a structure obtained by removing two or more hydrogen atoms from a structure represented by Formula (V-2), $X^1$ is preferably a group represented by Formula (V-2-1) or Formula (V-2-2), and from the viewpoint of reducing the amine value in the resin, $X^1$ is preferably a group represented by Formula (V-2-2). In the following Formula, $L^{X1}$ represents a single bond or -O-, and * represents a bonding site to four carbonyl groups to which $X^1$ in Formula (1-1) is bonded. In addition, the definition and preferred aspect of $R^{X1}$ are as described above. In addition, the hydrogen atom in these structures may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

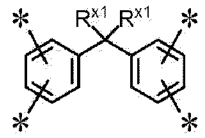

(V-2-1)

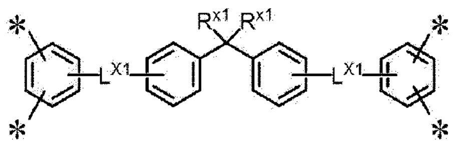

(V-2-2)

In a case where $X^1$ is a group including a structure obtained by removing two or more hydrogen atoms from a structure represented by Formula (V-3), $X^1$ is preferably a group represented by Formula (V-3-1) or Formula (V-3-2), and from the viewpoint of reducing the dielectric constant, $X^1$ is preferably a group represented by Formula (V-3-2). In the following Formula, * represents a bonding site to four carbonyl groups to which $X^1$ in Formula (1-1) is bonded. In addition, the definitions and preferred aspects of $R^{X2}$ and $R^{X3}$ are as described above. In addition, the hydrogen atom in these structures may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

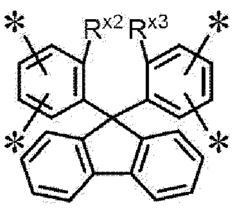

(V-3-1)

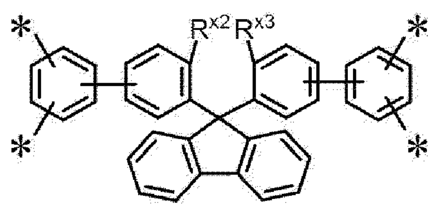

(V-3-2)

In a case where $X^1$ is a group including a structure obtained by removing two or more hydrogen atoms from a structure represented by Formula (V-4), $X^1$ is preferably a group represented by Formula (V-4-1). In the following Formula, * represents a bonding site to four carbonyl groups to which $X^1$ in Formula (1-1) is bonded, and n1 represents an integer of 0 to 5. In addition, the hydrogen atom in the following structure may be further substituted with a known substituent such as a hydroxy group or a hydrocarbon group. In addition, in a case where m in Formula (1-1) is an integer of 1 to 4, it is preferable that m hydrogen atoms are substituted with $R^1$ in Formula (1-1).

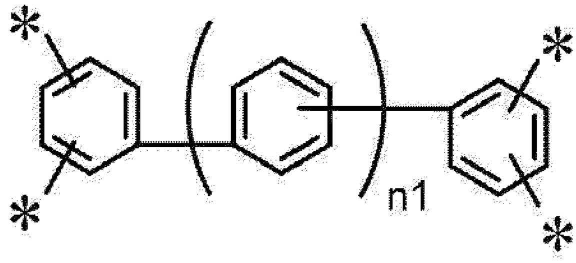

(V-4-1)

In addition, $X^1$ may be a group obtained by removing m hydrogen atoms from a group represented by $R^{132}$ in Formula (4) described above.

In addition, it is preferable that $X^1$ does not contain an imide structure in the structure.

In the present invention, the imide structure is a structure represented by -C(=O)N(-*)C(=O)-. * represents a bonding site to another structure.

In addition, it is preferable that $X^1$ does not contain a urethane bond, a urea bond, and an amide bond in the structure.

In the present invention, the urethane bond is a bond represented by *-O-C(=O)-NR$^N$-*, where $R^N$ represents a hydrogen atom or a monovalent organic group, and *'s each represent a bonding site to a carbon atom. $R^N$ is preferably a hydrogen atom, an alkyl group, or an aryl group, and more preferably a hydrogen atom.

In the present invention, the urea bond is a bond represented by *-NR$^N$-C(=O)-NR$^N$-*, where $R^N$'s each independently represent a hydrogen atom or a monovalent organic group, and *'s each represent a bonding site to a carbon atom. The preferred aspect of $R^N$ is as described above.

In the present invention, the amide bond is a bond represented by *-NR$^N$-C(=O)-*, where $R^N$ represents a hydrogen atom or a monovalent organic group, and *'s each represent a bonding site to a carbon atom. The preferred aspect of $R^N$ is as described above.

Furthermore, it is preferable that $X^1$ does not contain an ester bond in the structure.

In the present invention, the ester bond is a bond represented by *-O-C(=O)-*.

Among these, it is preferable that $X^1$ does not contain an imide structure, a urethane bond, a urea bond, and an amide bond, and it is more preferable that $X^1$ does not contain an imide structure, a urethane bond, a urea bond, an amide bond, and an ester bond.

-$Y^1$-

In Formula (1-1), $Y^1$ is preferably a group including a structure obtained by removing two or more hydrogen atoms from the structure represented by any one of Formulae (V-1) to (V-4) described above.

In a case where $Y^1$ is a group including a structure obtained by removing two or more hydrogen atoms from a structure represented by Formula (V-1), $Y^1$ is preferably a group obtained by removing n hydrogen atoms from a group represented by Formula (V-1-2). In the following Formula, * represents a bonding site to two nitrogen atoms to which $Y^1$ in Formula (1-1) is bonded, and n1 represents an integer of 1 to 5. n hydrogen atoms in the following structure are substituted with $R^1$ in Formula (1-1). n has the same meaning as n in Formula (1-1). In addition, the hydrogen atom in the following structure may be further substituted with a known substituent such as a hydroxy group or a hydrocarbon group.

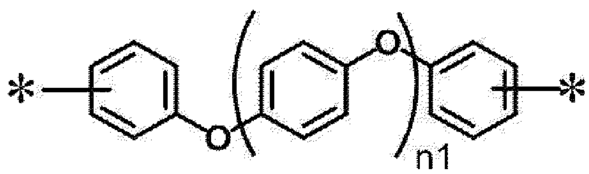

(V-1-2)

In a case where $Y^1$ is a group including a structure obtained by removing two or more hydrogen atoms from a structure represented by Formula (V-2), $Y^1$ is preferably a group represented by Formula (V-2-3) or Formula (V-2-4), and from the viewpoint of reducing the dielectric constant, $Y^1$ is preferably a group represented by Formula (V-2-4). In the following Formula, $L^{X1}$ represents a single bond or -O-, and * represents a bonding site to two nitrogen atoms to which $Y^1$ in Formula (1-1) is bonded. In addition, the preferred aspect of $R^{X1}$ is as described above. n hydrogen atoms in the following

structure are substituted with $R^1$ in Formula (1-1). n has the same meaning as n in Formula (1-1). In addition, the hydrogen atom in these structures may be further substituted with a known substituent such as a hydroxy group or a hydrocarbon group.

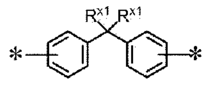
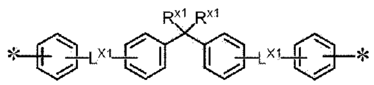

(V-2-3) (V-2-4)

In a case where $Y^1$ is a group including a structure obtained by removing two or more hydrogen atoms from a structure represented by Formula (V-3), $Y^1$ is preferably a group represented by Formula (V-3-3) or Formula (V-3-4), and from the viewpoint of reducing the dielectric constant, $Y^1$ is preferably a group represented by Formula (V-3-3). In the following Formula, * represents a bonding site to two nitrogen atoms to which $Y^1$ in Formula (1-1) is bonded. In addition, the preferred aspects of $R^{X2}$ and $R^{X3}$ are as described above. n hydrogen atoms in the following structure are substituted with $R^1$ in Formula (1-1). n has the same meaning as n in Formula (1-1). In addition, the hydrogen atom in these structures may be further substituted with a known substituent such as a hydroxy group or a hydrocarbon group.

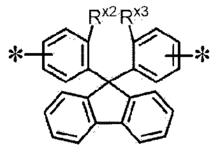
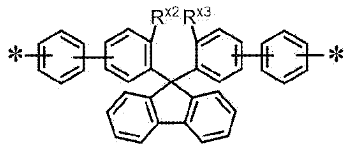

(V-3-3) (V-3-4)

In a case where $Y^1$ is a group including a structure obtained by removing two or more hydrogen atoms from a structure represented by Formula (V-4), $Y^1$ is preferably a group represented by Formula (V-4-2). In the following Formula, * represents a bonding site to two nitrogen atoms to which $Y^1$ in Formula (1-1) is bonded, and n1 represents an integer of 0 to 5. In addition, an aspect in which n1 is 0 is also one of the preferred aspects of the present invention. n hydrogen atoms in the following structure are substituted with $R^1$ in Formula (1-1). n has the same meaning as n in Formula (1-1). In addition, the hydrogen atom in the following structure may be further substituted with a known substituent such as a hydroxy group or a hydrocarbon group.

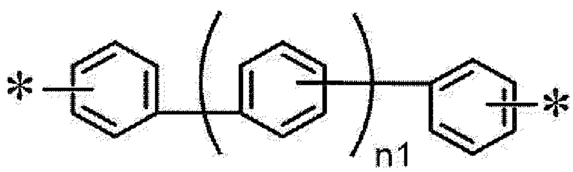

(V-4-2)

In addition, $Y^1$ may be a group obtained by removing n hydrogen atoms from a group represented by $R^{131}$ in Formula (4) described above.

In addition, it is preferable that $Y^1$ does not contain an imide structure in the structure.

In addition, it is preferable that $Y^1$ does not contain a urethane bond, a urea bond, and an amide bond in the structure.

Furthermore, it is preferable that $Y^1$ does not contain an ester bond in the structure.

Among these, it is preferable that $Y^1$ does not contain an imide structure, a urethane bond, a urea bond, and an amide bond, and it is more preferable that $Y^1$ does not contain an imide structure, a urethane bond, a urea bond, an amide bond, and an ester bond.

Among these, it is preferable that $X^1$ and $Y^1$ in Formula (1-1) each include a structure obtained by removing two or more hydrogen atoms from a structure represented by any one of Formulae (V-1) to (V-4).

In Formula (1-1), m is preferably an integer of 0 to 2, and more preferably 0 or 1. In addition, an aspect in which m is 0 is also one of the preferred aspects of the present invention.

In Formula (1-1), n is preferably 1 or 2, and more preferably 2.

It is also preferable that the polyimide has a fluorine atom in the structure. The content of fluorine atoms in the polyimide is preferably 10% by mass or more, and it is more preferably 20% by mass or less.

For the intended purpose of improving adhesiveness to a substrate, an aliphatic group having a siloxane

structure may be copolymerized with the polyimide. Specific examples of the diamine component include bis(3-aminopropyl)tetramethyldisiloxane, and bis(p-aminophenyl)octamethyl pentasiloxane.

In order to improve the storage stability of the resin composition, the terminal of the main chain of the polyimide is preferably blocked with a terminal blocking agent such as a monoamine, an acid anhydride, a monocarboxylic acid, a monoacid chloride compound, or a monoactive ester compound. Among these, it is more preferable to use monoamine. Examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

-Imidization rate (ring closure rate)-

The imidization rate (also referred to as the "ring closure rate") of the polyimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured by, for example, the following method.

The infrared absorption spectrum of polyimide is measured, and a peak intensity P1 in the vicinity of 1,377 $cm^{-1}$, which is the absorption peak derived from the imide structure, is obtained. Next, the polyimide is subjected to a heat treatment at 350°C for 1 hour, and then the infrared absorption spectrum is measured again to obtain a peak intensity P2 in the vicinity of 1,377 $cm^{-1}$. Using the obtained peak intensities P1 and P2, the imidization rate of the polyimide can be determined based on the following expression.

$$\text{Imidization rate (\%)} = (\text{peak intensity P1}/\text{peak intensity P2}) \times 100$$

The polyimide may include the repeating unit represented by Formula (4) in which the combinations of $R^{131}$ and $R^{132}$ in all the repeating units are the same, or may include the repeating unit represented by Formula (4) including two or more different combinations of $R^{131}$ and $R^{132}$. The polyimide may contain another kind of repeating unit in addition to the above repeating unit represented by Formula (4). Examples of the other kind of repeating unit include the repeating unit represented by Formula (2) described above.

The polyimide can be synthesized by utilizing, for example, a method in which a tetracarboxylic acid dianhydride is reacted with a diamine (a part thereof is substituted with a terminal blocking agent which is a monoamine) at a low temperature, a method in which a tetracarboxylic acid dianhydride (a part thereof is substituted with a terminal blocking agent which is an acid anhydride, a monoacid chloride compound, or a monoactive ester compound) is reacted with a diamine at a low temperature, a method in which a diester is obtained from a tetracarboxylic acid dianhydride and alcohol and then reacted with a diamine (a part thereof is substituted with a terminal blocking agent which is a monoamine) in the presence of a condensing agent, a method in which a polyimide precursor is obtained, for example, by using a method in which a diester is obtained from a tetracarboxylic acid dianhydride and an alcohol, the remaining dicarboxylic acid is subjected to acid chloride modification and reacted with a diamine (a part thereof is substituted with a terminal blocking agent which is a monoamine), and the polyimide precursor is subjected to full imidization using a known imidization reaction method, or, a method in which the imidization reaction is stopped in the middle of the reaction and the imide structure is partially introduced, or furthermore a method in which a fully imidized polymer is blended with the polyimide precursor, whereby the imide structure is partially introduced. In addition, another known method for synthesizing polyimide can also be applied.

The weight-average molecular weight (Mw) of the polyimide is preferably 5,000 to 100,000, more preferably 6,000 to 50,000, and still more preferably 7,000 to 20,000. The number-average molecular weight (Mn) of the polyimide is preferably 2,000 to 40,000, more preferably 3,000 to 20,000, and still more preferably 4,000 to 10,000.

The dispersivity of the molecular weight of the polyimide is preferably 1.5 or more, more preferably 1.8 or more, and still more preferably 2.0 or more. The upper limit value of the dispersivity of the molecular weight of the polyimide is not particularly limited; however, it is, for example, preferably 7.0 or less, more preferably 6.5 or less, and still more preferably 6.0 or less.

In a case where the resin composition contains a plurality of kinds of polyimides as the specific resin, it is preferable that the weight-average molecular weight, the number-average molecular weight, and the dispersivity of at least one kind of polyimide are in the above ranges. It is also preferable that the weight-average molecular weight, the number-average molecular weight, and the dispersity, calculated by using the plurality of kinds of polyimides as one resin, are within the above ranges.

[Production method for polyimide precursor and like]

The polyimide precursor the like can be obtained, for example, by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production methods, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.
Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.
Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.
Examples of the halogenating agent include thionyl chloride, oxalyl chloride, and phosphorus oxychloride.
In the production method for a polyimide precursor the like, it is preferable to use an organic solvent in a case of carrying out the reaction. One kind of organic solvent may be used, or two or more kinds thereof may be used.
The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and γ-butyrolactone.
In the production method for a polyimide precursor the like, it is preferable to add a basic compound in a case of carrying out the reaction. One kind of basic compound may be used, or two or more kinds thereof may be used.
The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

-Terminal blocking agent-

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid,3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.
In addition, in a case of blocking the amino group at the terminal of the resin, it is possible to carry out blocking with a compound having a functional group capable of reacting with the amino group. The preferred blocking agent for the

amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, benzoic anhydride, and 5-norbornene-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

-Solid precipitation-

In the production method for a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

[Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the resin in the resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

It is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure ($R^{115}$ in Formula (2) described above) derived from the dianhydride is different.

<Another resin>

The resin composition according to the embodiment of the present invention may contain the above-described specific resin and another resin (hereinafter, also simply referred to as "the other resin") that is different from the specific resin.

Examples of the other resins include other polyimide precursors different from the specific resin, polyimides, polybenzoxazole precursors, polybenzoxazole, polyamideimide precursors, polyamideimide, phenol resin, polyamide, epoxy resin, polysiloxane, resin including a siloxane structure, (meth)acrylic resin, (meth)acrylamide resin, urethane resin, butyral resin, styryl resin, polyether resin, and polyester resin.

Examples of the other polyimide precursors, the polyimides, the polybenzoxazole precursors, the polybenzoxazoles, the polyamideimide precursors, and the polyamideimides include the compounds described in paragraphs 0017 to 0138 of WO2022/145355A. The above description is incorporated in the present specification.

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

The content of the other resin in the resin composition according to the embodiment of the present invention is

preferably 80% by mass or less, more preferably 75% by mass or less, still more preferably 70% by mass or less, even still more preferably 60% by mass or less, and even further still more preferably 50% by mass or less, with respect to the total solid content of the resin composition.

As the preferred aspect of the resin composition according to the embodiment of the present invention, an aspect in which the content of the other resin is a low content can be adopted. In the above aspect, the content of the other resin is preferably 20% by mass or less, more preferably 15% by mass or less, still more preferably 10% by mass or less, even still more preferably 5% by mass or less, and even further still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. In a case where two or more kinds thereof are contained, the total amount thereof is preferably within the above range.

<Polymerizable compound>

The resin composition according to the embodiment of the present invention preferably contains a polymerizable compound.

In addition, an aspect in which the resin composition according to the embodiment of the present invention contains a polymerizable compound and a photopolymerization initiator is also one of the preferred aspects of the present invention.

Examples of the polymerizable compound include a radical crosslinking agent and another crosslinking agent.

[Radical crosslinking agent]

The resin composition according to the embodiment of the present invention preferably contains a radical crosslinking agent.

The radical crosslinking agent is a compound having a radically polymerizable group. The radically polymerizable group is preferably a group containing an ethylenically unsaturated bond. Examples of the group containing an ethylenically unsaturated bond include a vinyl group, an allyl group, a vinylphenyl group, a (meth)acryloyl group, a maleimide group, and a (meth)acrylamide group.

Among these, a (meth)acryloyl group, a (meth)acrylamide group, or a vinylphenyl group is preferable, and from the viewpoint of reactivity, a (meth)acryloyl group is more preferable and an acryloyl group is still more preferable. In a case where an acryloxy group is used, it is considered that the structure after polymerization is less likely to be depolymerized as compared to other polymerizable groups such as a methacryloxy group, and thus the flatness is more excellent.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

From the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where esters between unsaturated carboxylic acids and polyhydric alcohol compounds or amides between unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other

examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

The radical crosslinking agent is also preferably a compound having a boiling point of 100°C or higher under normal pressure. Examples of the compound having a boiling point of 100°C or higher under normal pressure include the compounds described in paragraph 0203 of WO2021/112189A. The content thereof is incorporated in the present specification.

Examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, SR-209, 231, and 239 which are a difunctional methacrylate having four ethyleneoxy chains (all of which are manufactured by manufactured by Sartomer Company Inc.), DPCA-60 which is a hexafunctional acrylate having six pentyleneoxy chains and TPA-330 which is a trifunctional acrylate having three isobutylene oxy chains (all of which are manufactured by Nippon Kayaku Co., Ltd.), UAS-10 and UAB-140 which are a urethane oligomer (all of which are manufactured by Nippon Paper Industries Co., Ltd.), NK Ester M-40G, NK Ester 4G, NK Ester M-9300, NK Ester A-9300, and UA-7200 (all of which are manufactured by Shin-Nakamura Chemical Co., Ltd.), DPHA-40H (manufactured by Nippon Kayaku Co., Ltd.), UA-306H, UA-306T, UA-306I, AH-600, T-600, and AI-600 (all of which are manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. As the radical crosslinking agent, the compounds having an amino structure or a sulfide structure in the molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

An acid value of the radical crosslinking agent having an acid group is preferably 0.1 to 300 mgKOH/g and more preferably 1 to 100 mgKOH/g. In a case where the acid value of the radical crosslinking agent is within the above-described range, excellent manufacturing handleability is exhibited, and excellent developability is exhibited. In addition, good polymerization properties are exhibited. The acid value is measured in accordance with the description of JIS K 0070: 1992.

The radical crosslinking agent is also preferably a radical crosslinking agent having at least one selected from the group consisting of a urea bond and a urethane bond (hereinafter, also referred to as a "crosslinking agent U").

In the present invention, the urea bond is a bond represented by *-NR$^N$-C(=O)-NR$^N$-*, where R$^N$'s each independently represent a hydrogen atom or a monovalent organic group, and *'s each represent a bonding site to a carbon atom.

In the present invention, the urethane bond is a bond represented by *-O-C(=O)-NR$^N$-*, where R$^N$ represents a hydrogen atom or a monovalent organic group, and *'s each represent a bonding site to a carbon atom.

In a case where the resin composition contains a crosslinking agent U, chemical resistance, resolution, and the

like may be improved.

The mechanism by which the above-described effect is obtained is not revealed; however, it is considered that, for example, a part of the crosslinking agent U undergoes thermal decomposition during curing by heating or the like to generate an amine or the like, and the amine or the like accelerates the cyclization of the precursor of the cyclization resin such as the polyimide precursor.

The crosslinking agent U may have only one urea bond or urethane bond, may have one or more urea bonds and one or more urethane bonds, may have two or more urea bonds without having a urethane bond, or may have two or more urethane bonds without having a urea bond.

The total number of urea bonds and urethane bonds in the crosslinking agent U is 1 or more, and it is preferably 1 to 10, more preferably 1 to 4, and still more preferably 1 or 2.

in a case where the crosslinking agent U does not have a urethane bond, the number of urea bonds in the crosslinking agent U is 1 or more, and it is preferably 1 to 10, more preferably 1 to 4, and still more preferably 1 or 2.
in a case where the crosslinking agent U does not have a urea bond, the number of urethane bonds in the crosslinking agent U is 1 or more, and it is preferably 1 to 10, more preferably 1 to 4, and still more preferably 1 or 2.

The radically polymerizable group in the crosslinking agent U is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

In a case where the crosslinking agent U has two or more radically polymerizable groups, the structures of the respective radically polymerizable groups may be the same or different from each other.

The number of radically polymerizable groups in the crosslinking agent U may be only one or may be two or more, and it is preferably 1 to 10, more preferably 1 to 6, and particularly preferably 1 to 4.

The radically polymerizable group value (the mass of the compound per 1 mol of the radically polymerizable group) in the crosslinking agent U is preferably 150 to 400 g/mol.

From the viewpoint of the chemical resistance of the cured substance, the lower limit of the above-described radically polymerizable group value is more preferably 200 g/mol or more, still more preferably 210 g/mol or more, even more preferably 220 g/mol or more, even still more preferably 230 g/mol or more, even still more preferably 240 g/mol or more, and particularly preferably 250 g/mol or more.

From the viewpoint of developability, the upper limit of the above-described radically polymerizable group value is more preferably 350 g/mol or less, still more preferably 330 g/mol or less, and particularly preferably 300 g/mol or less.

Among the above, the polymerizable group value of the crosslinking agent U is preferably 210 to 400 g/mol and more preferably 220 to 400 g/mol.

The crosslinking agent U has preferably, for example, a structure represented by Formula (U-1).

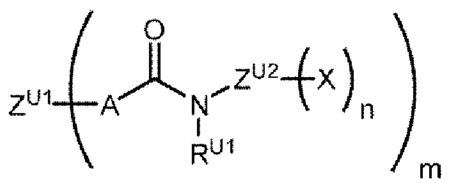

(U-1)

In Formula (U-1), $R^{U1}$ is a hydrogen atom or a monovalent organic group, A is -O-, or -$NR^N$-, $R^N$ is a hydrogen atom or a monovalent organic group, $Z^{U1}$ is an m-valent organic group, $Z^{U2}$ is an (n+1)-valent organic group, X is a radically polymerizable group, n is an integer of 1 or more, and m is an integer of 1 or more.

$R^{U1}$ is preferably a hydrogen atom, an alkyl group, or an aromatic hydrocarbon group, and more preferably a hydrogen atom.

$R^N$ is preferably a hydrogen atom, an alkyl group, or an aromatic hydrocarbon group, and more preferably a hydrogen atom.

$Z^{U1}$ is preferably a hydrocarbon group, -O-, -C(=O)-, -S-, $-S(=O)_2-$, -$NR^N$-, or a group in which two or more of these are bonded, and more preferably a hydrocarbon group or a group in which a hydrocarbon group is bonded to at least one group selected from the group consisting of -O-, -C(=O)-, -S-, $-S(=O)_2-$, and -$NR^N$-.

As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. $R^N$ represents a hydrogen atom or a monovalent organic group, and it is preferably a hydrogen atom or a hydrocarbon group, more

preferably a hydrogen atom or an alkyl group, and still more preferably a hydrogen atom or a methyl group.

$Z^{U2}$ is preferably a hydrocarbon group, -O-, -C(=O)-, -S-, -S(=O)$_2$-, -NR$^N$-, or a group in which two or more of these are bonded, and more preferably a hydrocarbon group or a group in which a hydrocarbon group is bonded to at least one group selected from the group consisting of -O-, -C(=O)-, -S-, -S(=O)$_2$-, and -NR$^N$-.

Examples of the hydrocarbon group include the same ones as those exemplified as $Z^{U1}$, and the same applies to the preferred aspect thereof.

X is not particularly limited; however, examples thereof include a vinyl group, an allyl group, a (meth)acryloyl group, a (meth)acryloxy group, a (meth)acrylamide group, a vinylphenyl group, and a maleimide group, where a (meth) acryloxy group, a (meth)acrylamide group, a vinylphenyl group, or a maleimide group is preferable, and a (meth)acryloxy group is more preferable.

n is preferably an integer of 1 to 10, more preferably an integer of 1 to 4, still more preferably 1 or 2, and particularly preferably 1.

m is preferably an integer of 1 to 10, more preferably an integer of 1 to 4, and still more preferably 1 or 2.

It is also preferable that the crosslinking agent U has at least one of a hydroxy group, an alkyleneoxy group, an amide group, or a cyano group.

From the viewpoint of the chemical resistance of the cured film to be obtained, the hydroxy group may be an alcoholic hydroxy group or a phenolic hydroxy group; however, it is preferably an alcoholic hydroxy group.

From the viewpoint of the chemical resistance of the cured film to be obtained, the alkyleneoxy group is preferably an alkyleneoxy group having 2 to 20 carbon atoms, more preferably an alkyleneoxy group having 2 to 10 carbon atoms, still more preferably an alkyleneoxy group having 2 to 4 carbon atoms, even still more preferably an ethylene group or a propylene group, and particularly preferably an ethylene group.

The alkyleneoxy group may be contained in the crosslinking agent U as a polyalkyleneoxy group. The number of repetitions of the alkyleneoxy group in this case is preferably 2 to 10 and more preferably 2 to 6.

The amide group refers to a bond represented by -C(=O)-NR$^N$-. $R^N$ is as described above. In a case where the crosslinking agent U has an amide group, the crosslinking agent U can include, for example, a group represented by R-C(=O)-NR$^N$-* or a group represented by *-C(=O)-NR$^N$-R. R represents a hydrogen atom or a monovalent substituent, and it is preferably a hydrogen atom or a hydrocarbon group and more preferably a hydrogen atom, an alkyl group, or an aromatic hydrocarbon group.

The crosslinking agent U may have, in the molecule, two or more structures selected from the group consisting of a hydroxy group, an alkyleneoxy group (however, a polyalkyleneoxy group in a case of constituting a polyalkyleneoxy group), an amide group, and a cyano group; however, an aspect in which only one structure is contained in the molecule is also preferable.

The hydroxy group, the alkyleneoxy group, the amide group, and the cyano group may be present at any position of the crosslinking agent U. However, from the viewpoint of chemical resistance, it is also preferable that the crosslinking agent U is such that at least one selected from the group consisting of the hydroxy group, the alkyleneoxy group, the amide group, and the cyano group, and at least one radically polymerizable group contained in the crosslinking agent U are linked by a linking group (hereinafter, also referred to as a "linking group L2-1") containing a urea bond or a urethane bond.

In particular, in a case where the crosslinking agent U contains only one radically polymerizable group, it is preferable that the radically polymerizable group contained in the crosslinking agent U and at least one selected from the group consisting of a hydroxy group, an alkyleneoxy group, an amide group, and a cyano group are linked by a linking group including a urea bond or a urethane bond (hereinafter, also referred to as a "linking group L2-2").

In a case where the crosslinking agent U contains an alkyleneoxy group (however, a polyalkyleneoxy group in a case of constituting a polyalkyleneoxy group) and has the above-described linking group L2-1 or the above-described linking group L2-2, a structure that is bonded to a side of the alkyleneoxy group (however, a polyalkyleneoxy group in a case of constituting a polyalkyleneoxy group) opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. In addition, the preferred aspect of the radically polymerizable group is the same as the preferred aspect of the radically polymerizable group in the above-described crosslinking agent U.

In a case where the crosslinking agent U contains an amide group and has the linking group L2-1 or the linking group L2-2, a structure that is bonded to a side of the amide group opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. In addition, examples of the above-described hydrocarbon

group include a saturated aliphatic hydrocarbon group, an aromatic hydrocarbon group, and a group obtained by bonding of these groups. The preferred aspect of the radically polymerizable group is the same as the preferred aspect of the radically polymerizable group in the above-described crosslinking agent U. In addition, in the above aspect, a carbon atom side of the amide group may be bonded to the linking group L2-1 or the linking group L2-2, or a nitrogen atom side of the amide group may be bonded to the linking group L2-1 or the linking group L2-2.

Among these, from the viewpoint of the adhesiveness to the base material, the chemical resistance, and the Cu void suppression, the crosslinking agent U preferably has a hydroxy group.

From the viewpoint of the compatibility with the specific resin and the like, the crosslinking agent U preferably contains an aromatic group.

The aromatic group is preferably directly bonded to a urea bond or a urethane bond contained in the crosslinking agent U. In a case where the crosslinking agent U contains two or more urea bonds or two or more urethane bonds, it is preferable that one of the urea bonds or urethane bonds is directly bonded to the aromatic group.

The aromatic group may be an aromatic hydrocarbon group or an aromatic heterocyclic group and may have a structure in which these groups form a fused ring; however, an aromatic hydrocarbon group is preferable.

The aromatic hydrocarbon group is preferably an aromatic hydrocarbon group having 6 to 30 carbon atoms, more preferably an aromatic hydrocarbon group having 6 to 20 carbon atoms, and still more preferably a group obtained by removing two or more hydrogen atoms from a benzene ring structure.

The aromatic heterocyclic group is preferably a 5-membered or 6-membered aromatic heterocyclic group. Examples of the aromatic heterocyclic ring in such an aromatic heterocyclic group include pyrrole, imidazole, triazole, tetrazole, pyrazole, furan, thiophene, oxazole, isoxazole, thiazole, pyridine, pyrazine, pyrimidine, pyridazine, and triazine. These rings may be further fused with another ring, for example, as in the case of indole or benzimidazole.

The heteroatom contained in the aromatic heterocyclic group is preferably a nitrogen atom, an oxygen atom, or a sulfur atom.

It is preferable that the aromatic group is included in, for example, a linking group that links two or more radically polymerizable groups and links a linking group having a urea bond or a urethane bond, or at least one selected from the group consisting of a hydroxy group, an alkyleneoxy group, an amide group, and a cyano group, to at least one radically polymerizable group contained in the crosslinking agent U.

The number of atoms (linking chain length) between the urea bond or urethane bond and the radically polymerizable group in the crosslinking agent U is not particularly limited; however, it is preferably 30 or less, more preferably 2 to 20, and still more preferably 2 to 10.

In a case where the crosslinking agent U contains two or more urea bonds or urethane bonds in total, the minimum number of atoms (linking chain length) between the urea bond or urethane bond and the radically polymerizable group is sufficient to be within the above-described range in a case where the crosslinking agent U contains two or more radically polymerizable groups, or in a case where the crosslinking agent U contains two or more urea bonds or two or more urethane bonds and two or more radically polymerizable groups,

In the present specification, the phrase "number of atoms (linking chain length) between the urea bond or urethane bond and the polymerizable group" refers to the smallest number of atoms (minimum number of atoms) for linking targets among the number of atoms for atomic chains on a path that links two atoms or atomic groups between the linking targets. For example, in a structure represented by the following Formula, the number of atoms (linking chain length) between the urea bond and the radically polymerizable group (methacryloyloxy group) is 2.

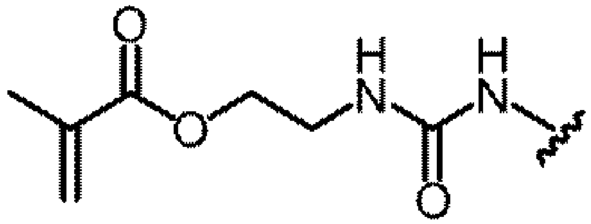

[Symmetry axis]

It is also preferable that the crosslinking agent U is a compound having a structure which does not have a symmetry axis.

The fact that the crosslinking agent U does not have a symmetry axis refers to that the crosslinking agent U is a left-right asymmetric compound which does not have an axis that generates the same molecule as the original molecule in a case where the entire compound is rotated. In addition, in a case where the structural formula of the crosslinking agent U is shown on the paper surface, the fact that the crosslinking agent U does not have a symmetry axis refers to that the

structural formula of the crosslinking agent U cannot be shown in a form having a symmetry axis.

It is considered that the aggregation of the crosslinking agents U is suppressed in the composition film in a case where the crosslinking agent U does not have a symmetry axis.

[Molecular weight]

The molecular weight of the crosslinking agent U is preferably 100 to 2,000, more preferably 150 to 1,500, and still more preferably 200 to 900.

A manufacturing method for the crosslinking agent U is not particularly limited; however, the crosslinking agent U can be obtained, for example, by reacting a radically polymerizable compound with a compound having an isocyanate group and a compound having at least one of a hydroxy group or an amino group.

Specific examples of the crosslinking agent U are shown below; however, the crosslinking agent U is not limited thereto.

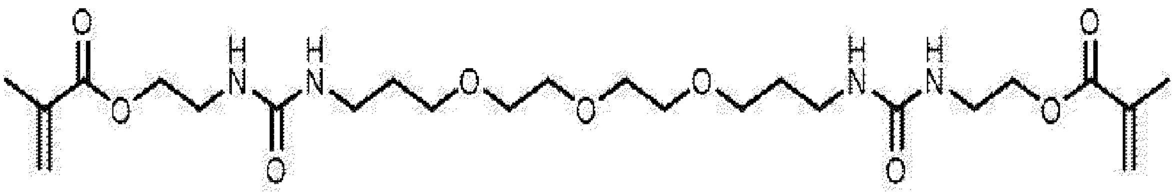

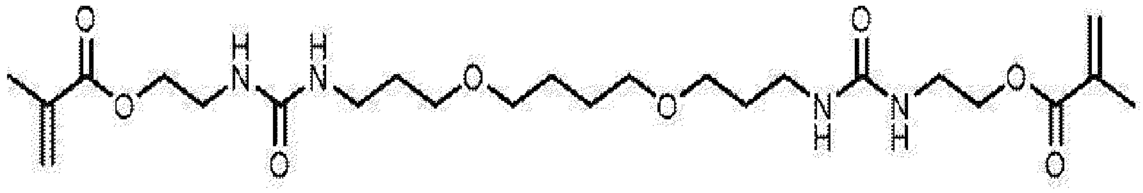

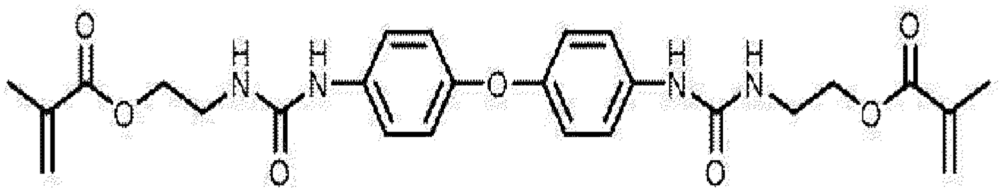

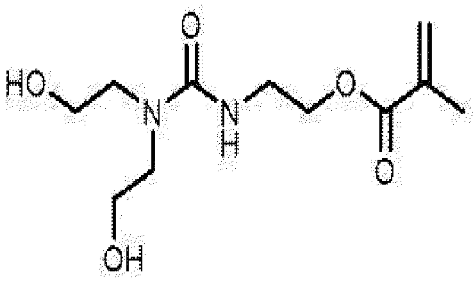

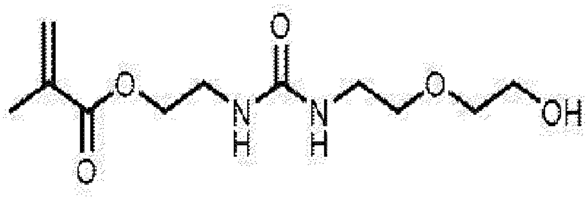

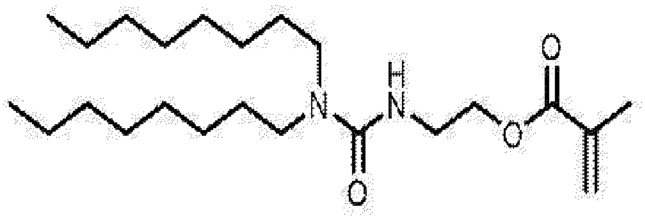

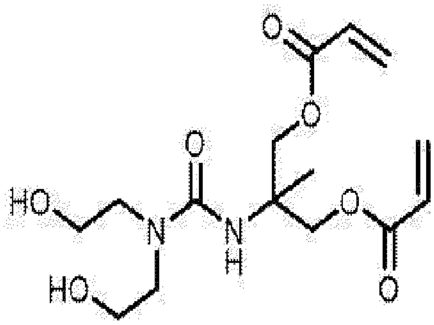

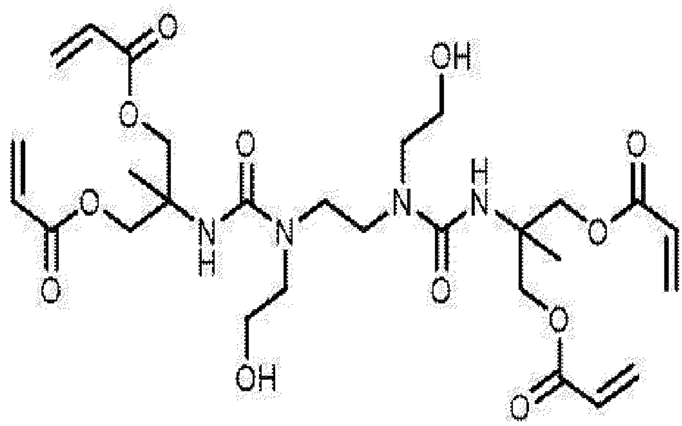

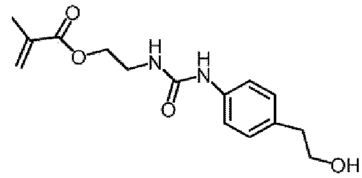

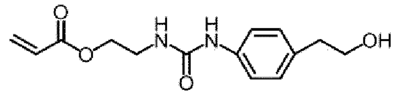

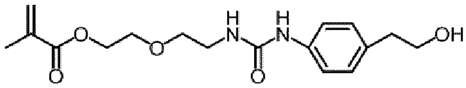

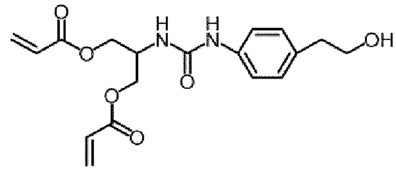

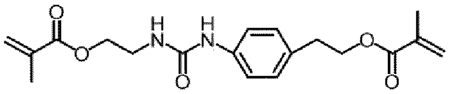

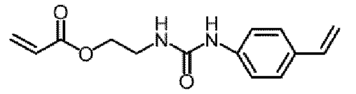

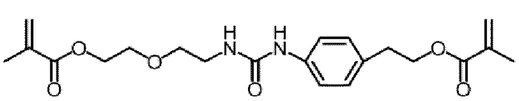

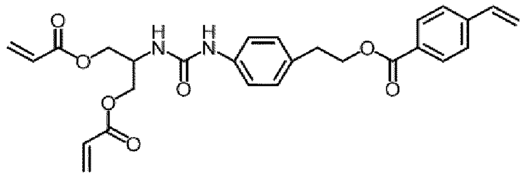

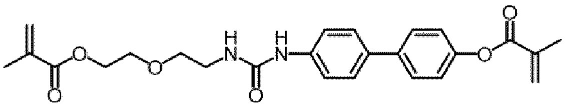

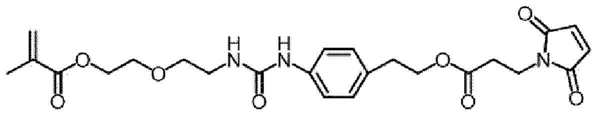

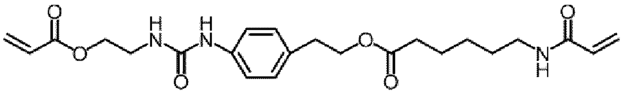

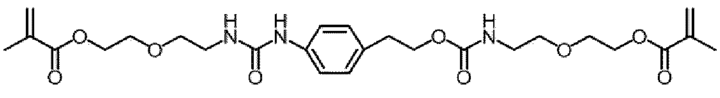

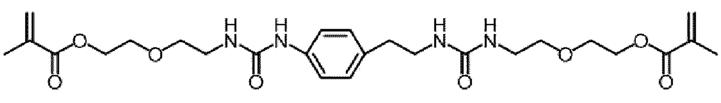

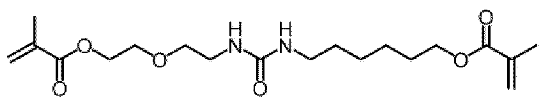

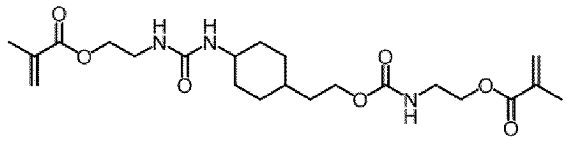

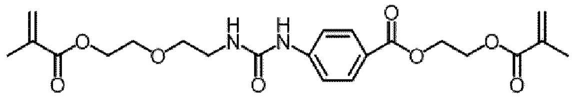

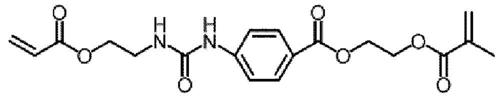

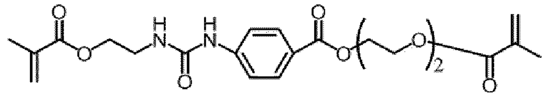

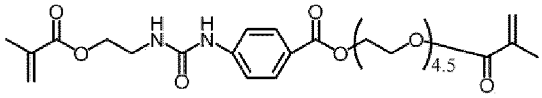

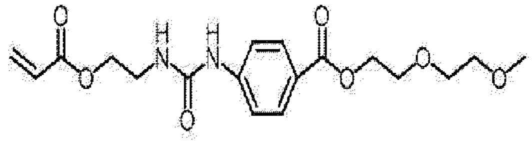

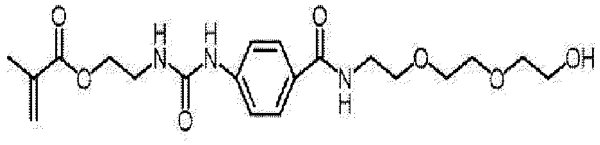

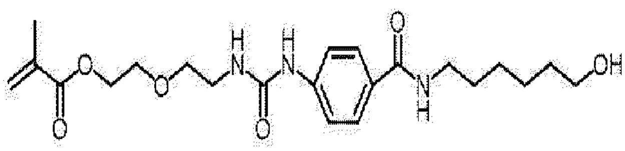

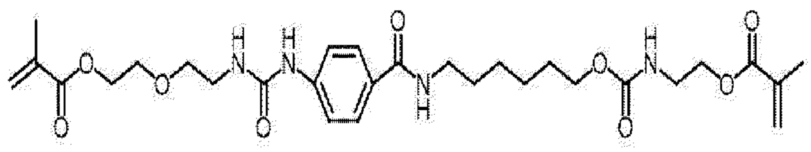

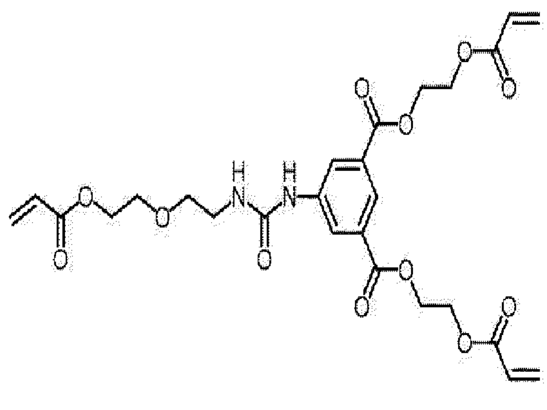

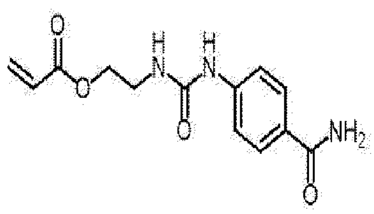

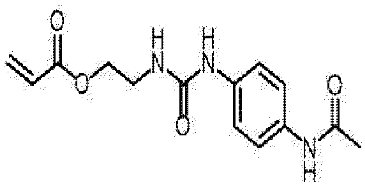

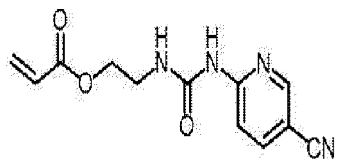

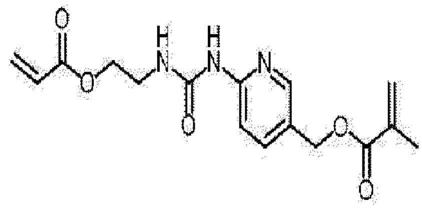

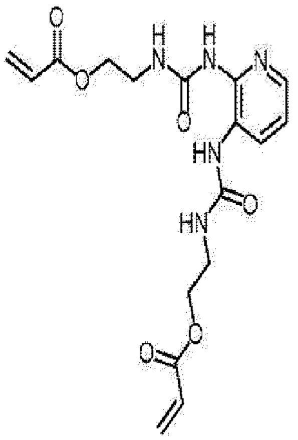

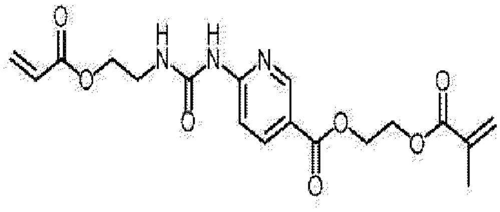

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, dipropylene glycol diacrylate, tripropylene glycol diacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid EO-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain Formula weight of about 200.

In the photocurable resin composition according to the embodiment of the present invention, a monofunctional radical crosslinking agent can be preferably used as the radical crosslinking agent from the viewpoint of suppressing the warping of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate; butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under normal pressure is also preferable in order to suppress volatilization before exposure.

In addition, examples of the bi- or higher functional radical crosslinking agent include allyl compounds such as diallyl phthalate and triallyl trimellitate.

In a case where a radical crosslinking agent is contained, the content of the radical crosslinking agent is preferably more than 0% by mass and 60% by mass or less with respect to the total solid content of the resin composition. The lower limit thereof is more preferably 5% by mass or more. The upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

[Another crosslinking agent]

The photocurable resin composition according to the embodiment of the present invention also preferably contains another crosslinking agent different from the radical crosslinking agent described above.

The other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is preferably a compound having a plurality of groups, in the molecule, which accelerates a reaction of forming a covalent bond between other compounds in the composition or reaction products thereof, by the action of the acid or the base.

The acid or the base is preferably an acid or a base, which is generated from a photoacid generator or a photobase generator in the exposure step.

The other crosslinking agent is preferably a compound having at least one group selected from the group consisting of an acyloxymethyl group, a methylol group, an ethylol group, and an alkoxymethyl group, and more preferably a compound having a structure in which at least one group selected from the group consisting of an acyloxymethyl group, a methylol group, an ethylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, an ethylol group, or an alkoxymethyl group. The production method for these compounds is not particularly limited, and any compound having the same structure as the compound produced by the above method may be used. Oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, more preferably 2 or 3 carbon atoms, and still more preferably 2 carbon atoms.

The total number of alkoxymethyl groups and acyloxymethyl groups which are contained in the above compound is preferably 1 to 10, more preferably 2 to 8, and particularly preferably 3 to 6.

The molecular weight of the above compound is preferably 1500 or less, and more preferably 180 to 1200.

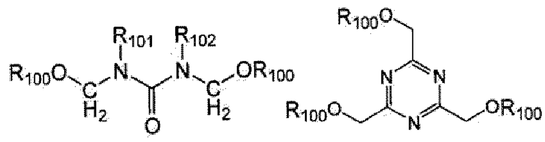

$R_{100}$ represents an alkyl group or an acyl group.

$R_{101}$ and $R_{102}$ each independently represent a monovalent organic group, and they may be bonded to each other to form a ring.

Examples of the compound in which an alkoxymethyl group or an acyloxymethyl group is directly substituted on an aromatic group include compounds such as those represented by the following general Formulae.

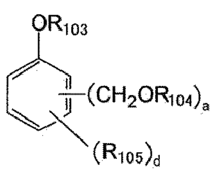

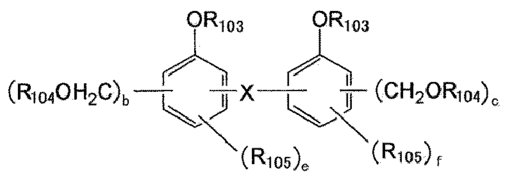

In Formula, X represents a single-bonded or divalent organic group, each $R_{104}$ independently represents an alkyl or acyl group, and $R_{103}$ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)).

Each $R_{105}$ independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of $R^5$ in the group that decomposes under the action of an acid to generate an alkali-soluble group, a group that is eliminated under the action of acid, and a group represented by $-C(R^4)_2COOR^5$, include $-C(R_{36})(R_{37})(R_{38})$, $-C(R_{36})(R_{37})(OR_{39})$, and $-C(R_{01})(R_{02})(OR_{39})$.

In Formulae, $R_{36}$ to $R_{39}$ each independently represent an alkyl group, a cycloalkyl group, an aryl group, an aralkyl group, or an alkenyl group. $R_{36}$ and $R_{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

These groups may further have a publicly known substituent.

$R_{01}$ and $R_{02}$ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

**In** addition, a compound having at least one group selected from the group consisting of a urea bond and a urethane bond is also preferable as the compound having at least one group selected from the group consisting of an acyloxymethyl group, a methylol group, an ethylol group, and an alkoxymethyl group. A preferred aspect of the above compound is the same as the preferred aspect of the crosslinking agent U described above, except that the polymerizable group is not a radically polymerizable group but at least one group selected from the group consisting of an acyloxymethyl group, a methylol group, an ethylol group, and an alkoxymethyl group.

Specific examples of the compound having at least one group selected from the group consisting of an acyloxymethyl group, a methylol group, and an ethylol group include the following structures. Examples of the compound having an acyloxymethyl group include compounds in which the alkoxymethyl group of the following compounds is changed to an acyloxymethyl group. Examples of the compound having an alkoxymethyl group or an acyloxymethyl group in the molecule include such compounds as follows; however, the compound is not limited thereto.

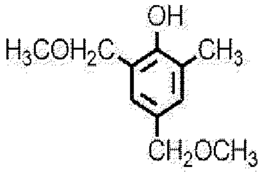
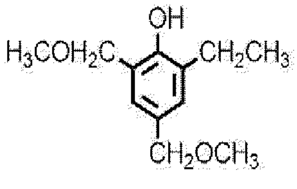
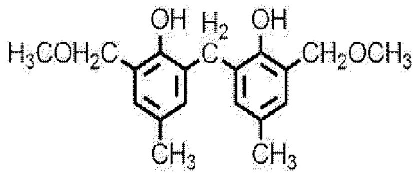

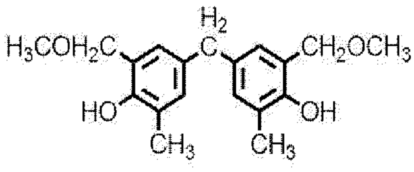
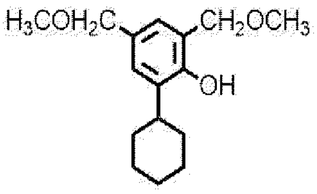
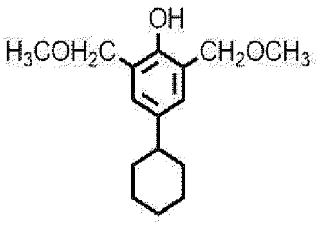

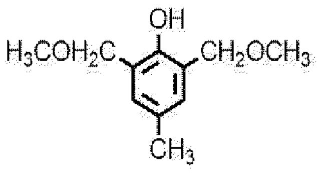
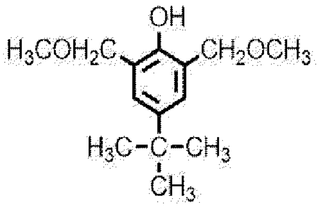
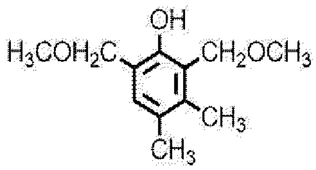

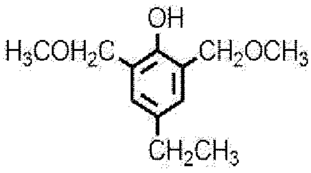
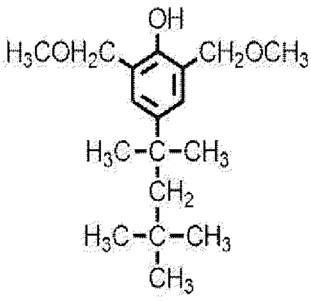
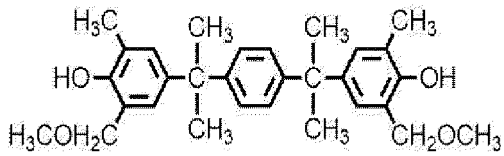

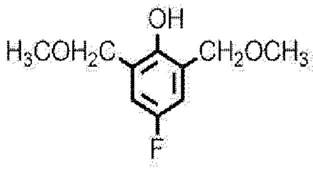
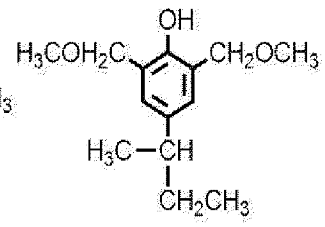
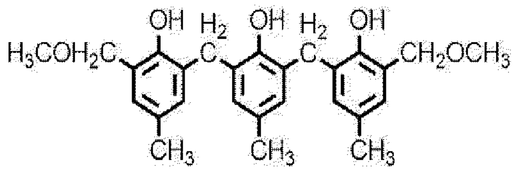

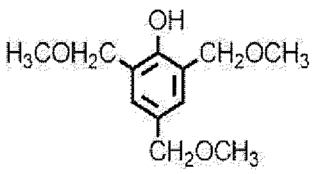
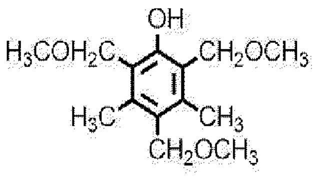
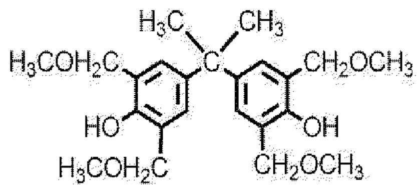

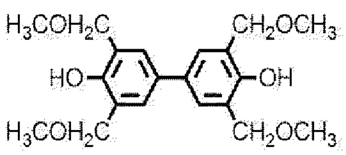
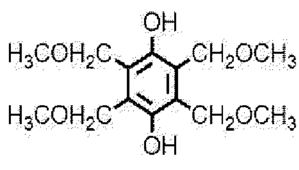
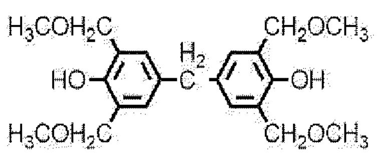

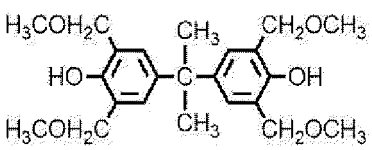
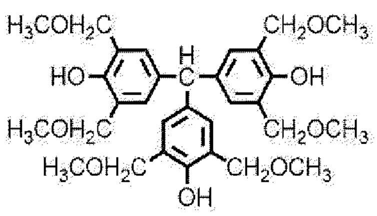
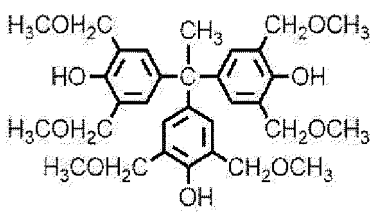

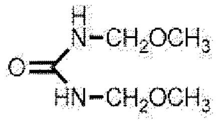
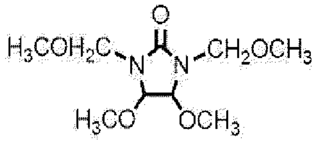
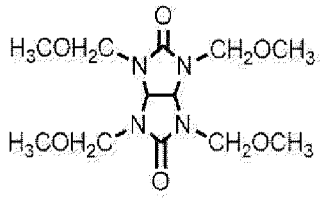

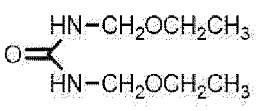
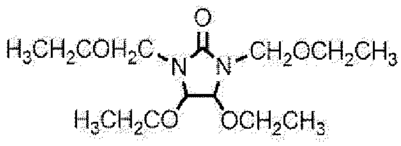
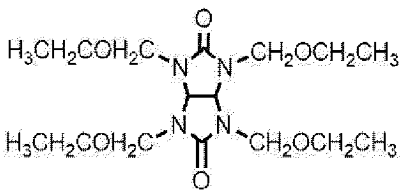

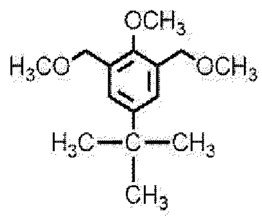
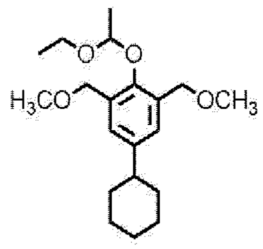
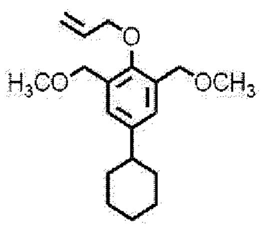
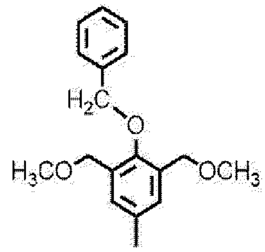

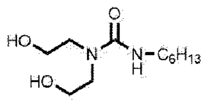
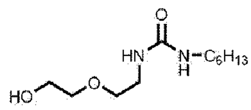
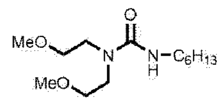

As the compound containing at least one of an alkoxymethyl group or an acyloxymethyl group, a commercially available compound may be used, or a compound synthesized by a publicly known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monoethoxymethylated glycoluril, diethoxymethylated glycoluril, triethoxymethylated glycoluril, tetramethoxymethylated glycoluril, monomethoxymethylated glycoluril, dimethoxymethylated glycoluril, trimethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril,

urea-based crosslinking agents such as bismethoxymethyl urea, bisethoxymethyl urea, bispropoxymethyl urea, and bisbutoxymethyl urea, ethylene urea-based crosslinking agents such as monohydroxymethylated ethylene urea or dihydroxymethylated ethylene urea, monoethoxymethylated ethylene urea, diethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, or dibutoxymethylated ethylene urea, propylene urea-based crosslinking agents such as monohydroxymethylated propylene urea, dihydroxymethylated propylene urea, monoethoxymethylated propylene urea, diethoxymethylated propylene urea, monoethoxymethylated propylene urea, diethoxymethylated propylene urea, monopropoxymethylated propylene urea, dipropoxymethylated propylene urea, monobutoxymethylated propylene urea, or dibutoxymethylated propylene urea, and 1,3-di(methoxymethyl)-4,5-dihydroxy-2-imidazolidinone, 1,3-di(methoxymethyl)-4,5-dimethoxy-2-imidazolidinone, and the like.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monomethoxymethylated benzoguanamine, dimethoxymethylated benzoguanamine, trimethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine,

monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5,5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trademark, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

The resin composition according to the embodiment of the present invention preferably contains, as the other crosslinking agent, at least one compound selected from the group consisting of an epoxy compound, an oxetane compound, and a benzoxazine compound.

-Epoxy compound (compound having epoxy group)-

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition and the suppression of warping.

The epoxy compound preferably contains a polyethylene oxide group. This makes it possible to further reduce the elastic modulus and suppress the warpage. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trademark, the same applies hereinafter) 850-S, EPICLON HP-4032, EPICLON HP-7200, EPICLON HP-820, EPICLON HP-4700, EPICLON HP-4770, EPICLON EXA-830LVP, EPICLON EXA-8183, EPICLON EXA-8169, EPICLON N-660, EPICLON N-665-EXP-S, and EPICLON N-740 (all of which are trade names, manufactured by DIC Corporation), RIKARESIN (registered trademark, the same applies hereinafter) BEO-20E, RIKARESIN BEO-60E, RIKARESIN HBE-100, RIKARESIN DME-100, and RIKARESIN L-200 (all of which are trade names, manufactured by New Japan Chemical Co., Ltd.), EP-4003S, EP-4000S, EP-4088S, and EP-3950S (all of which are trade names, manufactured by ADEKA Corporation), CELLOXIDE (registered trademark, the same applies hereinafter) 2021P, CELLOXIDE 2081, CELLOXIDE 2000, EHPE3150, EPOLEAD (registered trademark, the same applies hereinafter) GT401, EPOLEAD PB4700, and EPOLEAD PB3600 (all of which are trade names, manufactured by Daicel Corporation), and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all of which are trade names, manufactured by Nippon Kayaku Co., Ltd.). In addition, the following compounds are also suitably used.

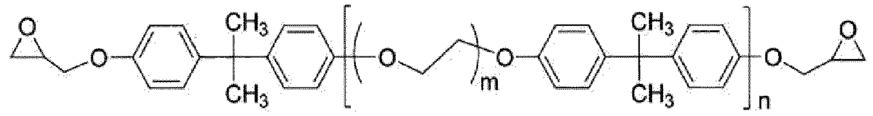

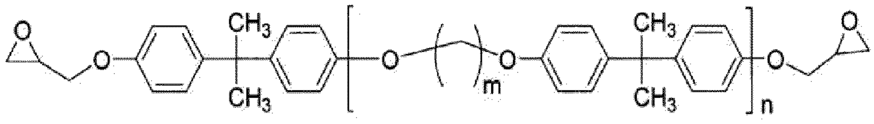

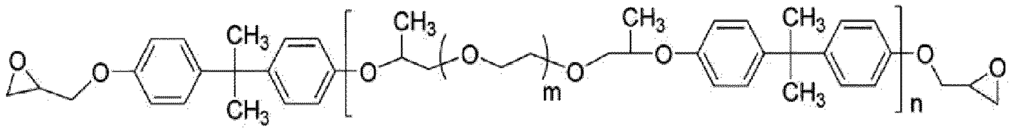

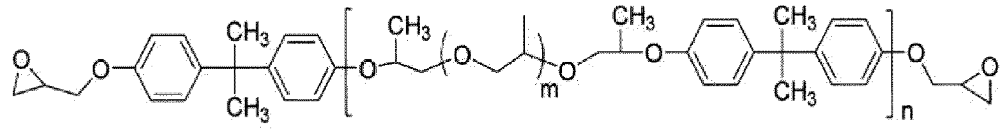

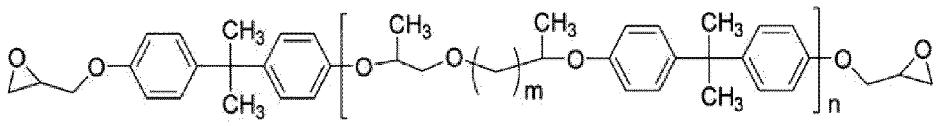

In Formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

-Oxetane compound (compound having oxetanyl group)-

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl)oxetane, and 1,4-benzenedicarboxylic acid-bis[(3-ethyl-3-oxetanyl)methyl]ester. As specific examples thereof, the ARON OXETANE series (for example, OXT-121 and OXT-221) manufactured by Toagosei Co., Ltd., can be suitably used, and these can be used alone or two or more thereof may be mixedly used.

-Benzoxazine compound (compound having benzoxazolyl group)-

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include P-d type benzoxazine, F-a type benzoxazine (trade names, all of which are manufactured by Shikoku Chemicals Corporation), a benzoxazine adduct of polyhydroxystyrene resin, and a phenol novolac type dihydrobenzoxazine compound. These may be used alone, or two or more thereof may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition. One kind of the other crosslinking agent may be contained, or two or more kinds thereof may be contained. In a case where two or more kinds of the other crosslinking agents are contained, the total thereof is preferably within the above-described range.

[Polymerization initiator]

The resin composition according to the embodiment of the present invention contains a polymerization initiator. The polymerization initiator may be a thermal polymerization initiator or a photopolymerization initiator; however, it is

particularly preferable to contain a photopolymerization initiator.

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from the ultraviolet ray range to the visible light range is preferable. In addition, it may be an activator that acts with a sensitizing agent to generate an active radical.

In addition, the polymerization initiator is preferably a photoacid generator. The photoacid generator is preferably a photoacid generator that generates a radical.

The photoradical polymerization initiator preferably contains at least one compound having a molar absorption coefficient of at least about 50 $L \cdot mol^{-1} \cdot cm^{-1}$ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an $\alpha$-amino ketone compound such as aminoacetophenone, an $\alpha$-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313A, the contents of which are incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification.

As the $\alpha$-hydroxy ketone-based initiator, Omnirad 184, Omnirad 1173, Omnirad 2959, Omnirad 127 (all of which manufactured by IGM Resins B.V), IRGACURE 184 (IRGACURE is a registered trademark), DAROCUR 1173, IRGACURE 500, IRGACURE-2959, and IRGACURE 127 (all of which manufactured by BASF SE) can be used.

As the $\alpha$-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1-one, 2-(benzoyloxy(imino))-1-phenylpropan-1-one, 3-((4-toluenesulfonyloxy) imino)butan-2-one, and 2-(ethoxycarbonyloxy(imino))-1-phenylpropan-1-one. In the resin composition, it is preferable to use an oxime compound, particularly as a photoradical polymerization initiator. The oxime compound as a photoradical polymerization initiator has a linking group of >C=N-O-C(=O)- in the molecule.

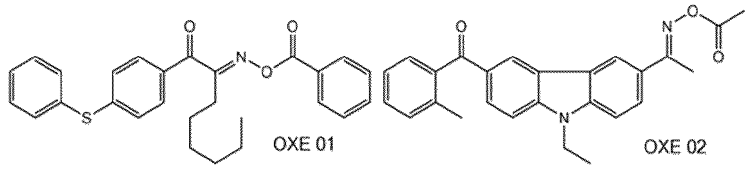

OXE 01 OXE 02

Examples of the commercially available product of the oxime compound include IRGACURE OXE 01, IRGACURE OXE 02, IRGACURE OXE 03, and IRGACURE OXE 04 (all of which are manufactured by BASF SE), ADEKA OPTOMER N-1919 (manufactured by ADEKA Corporation, the photoradical polymerization initiator 2 described in JP2012-014052A), TR-PBG-304, TR-PBG-305, and TR-PBG-3057 (all of which are manufactured by Changzhou Tronly New Electronic Materials Co., Ltd.), ADEKA ARKLS NCI-730, NCI-831, and ADEKA ARKLS NCI-930 (all of which are manufactured by ADEKA Corporation), DFI-091 (manufactured by DAITO CHEMIX Co., Ltd.), and SpeedCure PDO (manufactured by SARTOMER ARKEMA). In addition, oxime compounds having the following structures can also be used.

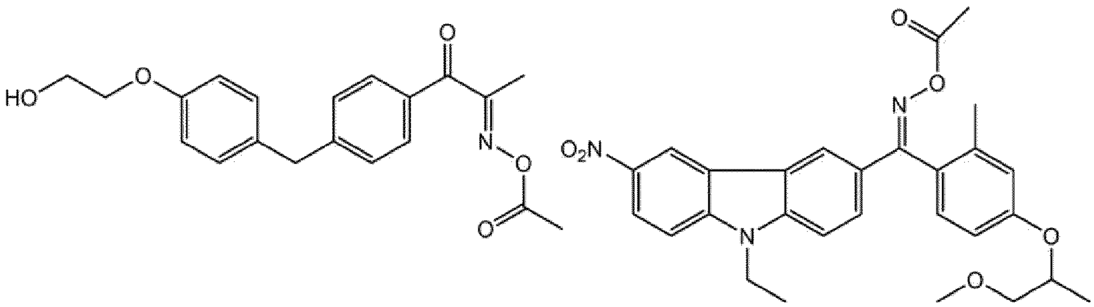

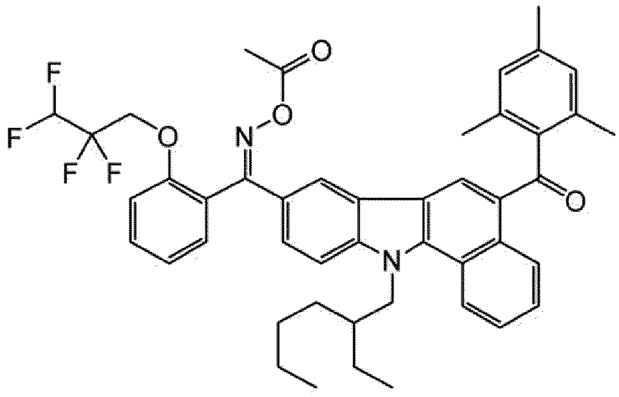

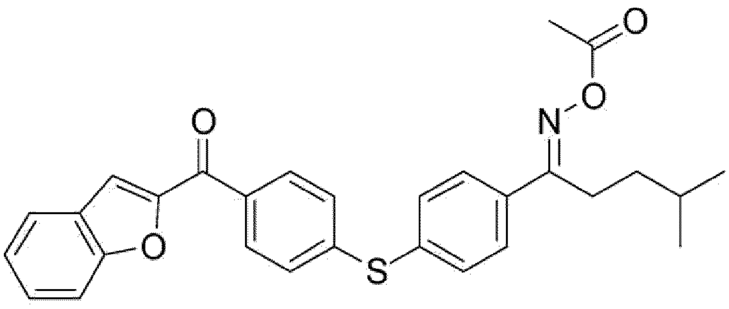

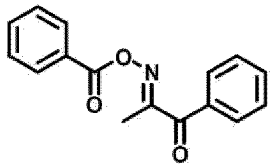

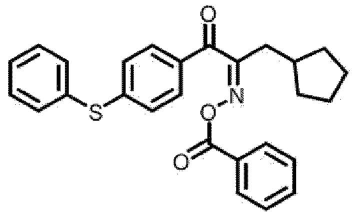

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom.

In addition, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The content thereof is incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX1) or a compound represented by Formula (OX2), and more preferably a compound represented by Formula (OX2).

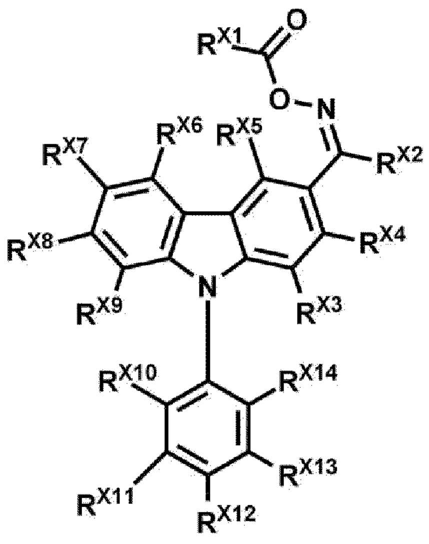

(OX1)

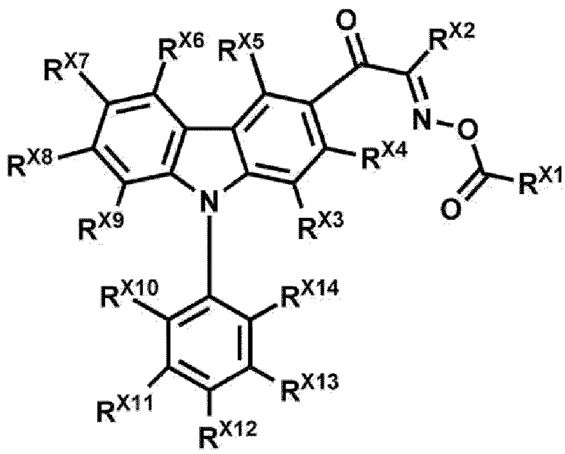

(OX2)

In Formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group, $R^{X2}$ represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy

group, or an amino group, and $R^{X3}$ to $R^{X14}$ each independently represent a hydrogen atom or a substituent.

However, at least one of $R^{X10}$, ..., or $R^{X14}$ is an electron withdrawing group.

In the above Formulae, it is preferable that $R^{X12}$ is an electron withdrawing group, and $R^{X10}$, $R^{X11}$, $R^{X13}$, and $R^{X14}$ are a hydrogen atom.

Specific examples of the oxime compound OX include the compounds described in paragraph Nos. 0083 to 0105 of JP4600600B, the content of which is incorporated in the present specification.

Examples of the particularly preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an $\alpha$-hydroxy ketone compound, an $\alpha$-aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

In addition, the photoradical polymerization initiator is a trihalomethyltriazine compound, an $\alpha$-aminoketone compound, an acylphosphine compound, a phosphine oxide compound, a metallocene compound, an oxime compound, a triaryl imidazole dimer, an onium salt compound, a benzophenone compound, or an acetophenone compound. It is more preferably at least one compound selected from the group consisting of a trihalomethyltriazine compound, an $\alpha$-aminoketone compound, a metallocene compound, an oxime compound, a triaryl imidazole dimer, and a benzophenone compound, and still more preferably a metallocene compound or an oxime compound.

As the photoradical polymerization initiator, the compounds described in paragraphs 0175 to 0179 of WO2021/020359A and the compounds described in paragraphs 0048 to 0055 of WO2015/125469A can also be used, the contents of which are incorporated in the present specification.

As the photoradical polymerization initiator, a photoradical polymerization initiator which is difunctional or tri- or higher functional may be used. In a case where such a photoradical polymerization initiator is used, two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, which makes it possible to improve the temporal stability of the resin composition. Specific examples of the photoradical polymerization initiator which is difunctional or tri- or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in WO2016/034963A, the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, and the oxime ester photoinitiator described in JP6469669B, the contents of which are incorporated in the present specification.

In a case where the resin composition contains a photopolymerization initiator, the content thereof is preferably 0.1% to 30% by mass, more preferably 0.1% to 20% by mass, still more preferably 0.5% to 15% by mass, and even still more preferably 1.0% to 10% by mass with respect to the total solid content of the resin composition with respect to the total solid content of the resin composition. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further allowed to proceed by heating an oven, a hot plate, or the like.

[Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a

cyanine-based, a phenothiazine-based, a pyrrolopyrazole azomethine-based, a xanthene-based, a phthalocyanine-based, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition. One kind of chain transfer agent may be used alone, or two or more kinds thereof may be used. In a case where two or more kinds of chain transfer agents are used, the total thereof is preferably within the above-described range.

<Base generator>

The resin composition according to the embodiment of the present invention may contain a base generator. Here, the base generator is a compound that is capable of generating a base under a physical or chemical action. Examples of the preferred base generator include a thermal base generator and a photobase generator.

In particular, in a case where the resin composition contains a precursor of a cyclization resin, it is preferable that the resin composition contains a base generator. In a case where the resin composition contains a thermal-base generator, it is possible to, for example, accelerate the cyclization reaction of the precursor by heating, whereby the mechanical properties and chemical resistance of the cured substance are improved and for example, the performance as an interlayer insulating film for a re-distribution layer, included in a semiconductor package, is improved.

The base generator may be an ionic base generator or may be a nonionic base generator. Examples of the base that is generated from the base generator include a secondary amine and a tertiary amine.

The base generator is not particularly limited, and a publicly known base generator can be used. Examples of the publicly known base generator include a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an $\alpha$-aminoacetophenone derivative compound, a quaternary

ammonium salt derivative compound, an iminium salt, a pyridinium salt, an $\alpha$-lactone ring derivative compound, a phthalimide derivative compound, and an acyloxyimino compound.

Specific examples of the compound of the nonionic base generator include compounds represented by Formula (B1), Formula (B2), or Formula (B3).

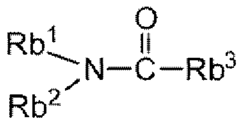 (B1) 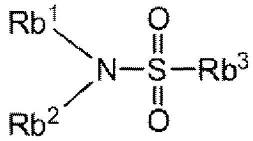 (B2)

In Formulae (B1) and (B2), $Rb^1$, $Rb^2$, and $Rb^3$ each independently represent an organic group that does not have a tertiary amine structure, a halogen atom, or a hydrogen atom. However, $Rb^1$ and $Rb^2$ are not hydrogen atoms at the same time. Further, none of $Rb^1$, $Rb^2$, and $Rb^3$ have a carboxy group. In the present specification, the tertiary amine structure refers to a structure in which all three bonding sites of a trivalent nitrogen atom are covalently bonded to carbon atoms of the hydrocarbon group. Therefore, in a case where the carbon atom bonded to the trivalent nitrogen atom is a carbon atom constituting a carbonyl group, that is, in a case where an amide group is formed together with the nitrogen atom, it is not a tertiary amine structure.

In Formula (B1) and Formula (B2), a cyclic structure is preferably contained in at least one of $Rb^1$, $Rb^2$, or $Rb^3$ and is more preferably contained in at least two thereof. The cyclic structure may be any one of a monocyclic ring or a fused ring and is preferably a monocyclic ring or a fused ring in which two monocyclic rings are fused. The monocyclic ring is preferably a 5-membered ring or a 6-membered ring, and more preferably a 6-membered ring. The monocyclic ring is preferably a cyclohexane ring or a benzene ring, and more preferably a cyclohexane ring.

More specifically, $Rb^1$ and $Rb^2$ are preferably a hydrogen atom, an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 25 carbon atoms, more preferably having 7 to 19 carbon atoms, and still more preferably having 7 to 12 carbon atoms). These groups may have a substituent. $Rb^1$ and $Rb^2$ may be bonded to each other to form a ring. The ring to be formed is preferably a 4- to 7-membered nitrogen-containing heterocycle. $Rb^1$ and $Rb^2$ are preferably a linear, branched, or cyclic alkyl groups (preferably having 1 to 24 carbon atoms, more preferably 2 to 18 carbon atoms, and still more preferably having 3 to 12 carbon atoms) which may have a substituent, more preferably a cycloalkyl group (preferably having 3 to 24 carbon atoms, more preferably having 3 to 18 carbon atoms, and still more preferably having 3 to 12 carbon atoms) which may have a substituent, and still more preferably a cyclohexyl group which may have a substituent.

Examples of $Rb^3$ include an alkyl group (preferably having 1 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), an alkenyl group (preferably having 2 to 24 carbon atoms, more preferably having 2 to 12 carbon atoms, and still more preferably having 2 to 6 carbon atoms), an arylalkyl group (preferably having 7 to 23 carbon atoms, more preferably having 7 to 19 carbon atoms, and still more preferably having 7 to 12 carbon atoms), an arylalkenyl group (preferably having 8 to 24 carbon atoms, more preferably having 8 to 20 carbon atoms, and still more preferably having 8 to 16 carbon atoms), an alkoxyl group (preferably having 1 to 24 carbon atoms, more preferably having 2 to 18 carbon atoms, and still more preferably having 3 to 12 carbon atoms), an aryloxy group (preferably having 6 to 22 carbon atoms, more preferably having 6 to 18 carbon atoms, and still more preferably having 6 to 12 carbon atoms), and an arylalkyloxy group (preferably having 7 to 23 carbon atoms, more preferably having 7 to 19 carbon atoms, and still more preferably having 7 to 12 carbon atoms). Among the above, a cycloalkyl group (preferably having 3 to 24 carbon atoms, more preferably 3 to 18 carbon atoms, and still more preferably 3 to 12 carbon atoms), an arylalkenyl group, or an arylalkyloxy group is preferable. $Rb^3$ may further have a substituent.

The compound represented by Formula (B1) is preferably a compound represented by Formula (B1-1) or Formula (B1-2).

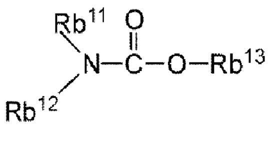 (B1-1) 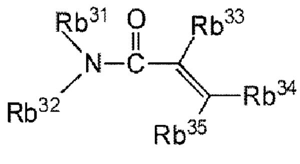 (B1-2)

In Formula, $Rb^{11}$ and $Rb^{12}$, and $Rb^{31}$ and $Rb^{32}$ are each the same as $Rb^1$ and $Rb^2$ in Formula (B1).

$Rb^{13}$ is an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and may have a substituent. Among the above, $Rb^{13}$ is preferably an arylalkyl group.

$Rb^{33}$ and $Rb^{34}$ are each independently a hydrogen atom, an alkyl group (preferably having 1 to 12 carbon atoms, more preferably having 1 to 8 carbon atoms, and still more preferably having 1 to 3 carbon atoms), an alkenyl group (preferably having 2 to 12 carbon atoms, more preferably having 2 to 8 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom.

$Rb^{35}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and is preferably an aryl group.

The compound represented by Formula (B1-1) is preferably a compound represented by Formula (B1-1a).

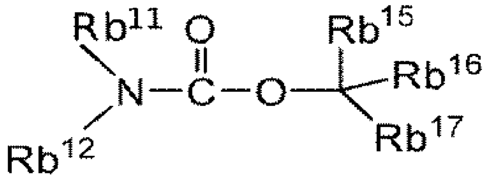

(B1-1a)

$Rb^{11}$ and $Rb^{12}$ respectively have the same meanings as $Rb^{11}$ and $Rb^{12}$ in Formula (B1-1).

$Rb^{15}$ and $Rb^{16}$ are a hydrogen atom, an alkyl group (preferably having 1 to 12 carbon atoms, more preferably having 1 to 6 carbon atoms, and still more preferably having 1 to 3 carbon atoms), an alkenyl group (preferably having 2 to 12 carbon atoms, more preferably having 2 to 6 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom or a methyl group.

$Rb^{17}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and among the above, is preferably an aryl group.

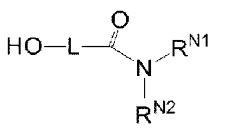

(B3)

In Formula (B3), L represents a hydrocarbon group which is a divalent hydrocarbon group having a saturated hydrocarbon group on a path of a linking chain that links adjacent oxygen atom and carbon atom and in which the number of the atoms on the path of the linking chain is 3 or more. Further, $R^{N1}$ and $R^{N2}$ each independently represent a monovalent organic group.

**In** the present specification, the "linking chain" refers to an atomic chain which interconnects linking targets shortest (with the minimum number of atoms) among the atomic chains on the path, which interconnects two atoms or a group of atoms to be linked. For example, in the compound represented by the following Formula, L is composed of a phenylene ethylene group, has an ethylene group as a saturated hydrocarbon group, and the linking chain is composed of four carbon atoms, and the number of atoms (that is, the number of atoms constituting the linking chain, and hereinafter,

also referred to as the "linking chain length" or the "length of linking chain") on the path of the linking chain is 4.

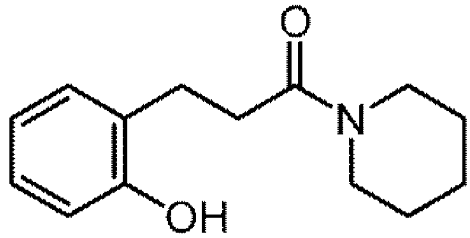

The number of carbon atoms in L in Formula (B3) (including carbon atoms other than the carbon atoms in the linking chain) is preferably 3 to 24. The upper limit thereof is more preferably 12 or less, still more preferably 10 or less, and particularly preferably 8 or less. The lower limit thereof is more preferably 4 or more. From the viewpoint of rapidly advancing the intramolecular cyclization reaction, the upper limit of the linking chain length of L is preferably 12 or less, more preferably 8 or less, still more preferably 6 or less, and particularly preferably 5 or less. In particular, the linking chain length of L is preferably 4 or 5 and most preferably 4. Specific preferred compounds of the base generator include the compounds described in paragraphs 0102 to 0168 of WO2020/066416A and the compounds described in paragraphs 0143 to 0177 of WO2018/038002A.

In addition, it is also preferable that the base generator includes a compound represented by Formula (N1).

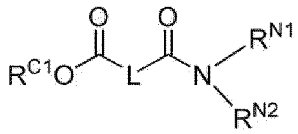

(N 1)

In Formula (N1), $R^{N1}$ and $R^{N2}$ each independently represent a monovalent organic group, $R^{C1}$ represents a hydrogen atom or a protective group, and L represents a divalent linking group.

L is a divalent linking group, and it is preferably a divalent organic group. The linking chain length of the linking group is preferably 1 or more and more preferably 2 or more. The upper limit thereof is preferably 12 or less, more preferably 8 or less, and still more preferably 5 or less. The linking chain length is the number of atoms present in the atom sequence that is the shortest route between the two carbonyl groups in Formula.

$R^{N1}$ and $R^{N2}$ in Formula (N1) each independently represent a monovalent organic group (preferably having 1 to 24 carbon atoms, more preferably 2 to 18 carbon atoms, and still more preferably 3 to 12 carbon atoms), more preferably a hydrocarbon group (preferably having 1 to 24 carbon atoms, more preferably 1 to 12 carbon atoms, and still more preferably 1 to 10 carbon atoms), and specific examples thereof include an aliphatic hydrocarbon group (preferably having 1 to 24 carbon atoms, more preferably 1 to 12 carbon atoms, and still more preferably 1 to 10 carbon atoms) and an aromatic hydrocarbon group (preferably having 6 to 22 carbon atoms, more preferably 6 to 18 carbon atoms, and still more preferably 6 to 10 carbon atoms), and an aliphatic hydrocarbon group is preferable. As $R^{N1}$ and $R^{N2}$, an aliphatic hydrocarbon group is preferably used since the basicity of the base to be generated is high. It is noted that the aliphatic hydrocarbon group and the aromatic hydrocarbon group may have a substituent, and the aliphatic hydrocarbon group and the aromatic hydrocarbon group may have an oxygen atom in an aliphatic hydrocarbon chain, in an aromatic ring, or in a substituent. In particular, an aspect in which the aliphatic hydrocarbon group has an oxygen atom in a hydrocarbon chain is exemplified.

Examples of the aliphatic hydrocarbon group constituting $R^{N1}$ and $R^{N2}$ include a linear or branched chain-like alkyl group, a cyclic alkyl group, a group including a combination of a chain-like alkyl group and a cyclic alkyl group, and an alkyl group having an oxygen atom in the chain. The linear or branched chain-like alkyl group preferably has 1 to 24 carbon atoms, more preferably 2 to 18, and still more preferably 3 to 12 carbon atoms. Examples of the linear or branched chain-like alkyl group include a methyl group, an ethyl group, a propyl group, a butyl group, a pentyl group, a hexyl group, a heptyl group, an octyl group, a nonyl group, a decyl group, an undecyl group, a dodecyl group, an isopropyl group, an isobutyl group, a secondary butyl group, a tertiary butyl group, an isopentyl group, a neopentyl group, a tertiary pentyl group, and an isohexyl group.

The cyclic alkyl group preferably has 3 to 12 carbon atoms and more preferably 3 to 6 carbon atoms. Examples of the cyclic alkyl group include a cyclopropyl group, a cyclobutyl group, a cyclopentyl group, a cyclohexyl group, and a cyclooctyl group.

The group including a combination of a chain-like alkyl group and a cyclic alkyl group preferably has 4 to 24 carbon atoms, more preferably 4 to 18 carbon atoms, and still more preferably 4 to 12 carbon atoms. Examples of the group including a combination of a chain-like alkyl group and a cyclic alkyl group include a cyclohexylmethyl group, a

cyclohexylethyl group, a cyclohexylpropyl group, a methylcyclohexylmethyl group, and an ethylcyclohexylethyl group.

The alkyl group having an oxygen atom in the chain preferably has 2 to 12 carbon atoms, more preferably 2 to 6 carbon atoms, and still more preferably 2 to 4 carbon atoms. The alkyl group having an oxygen atom in the chain may be chain-like or cyclic or may be linear or branched.

Among the above, from the viewpoint of increasing the boiling point of the decomposition-generated base described later, $R^{N1}$ and $R^{N2}$ are preferably an alkyl group having 5 to 12 carbon atoms. However, in a prescription in which adhesiveness in a case of carrying out lamination with a metal (for example, copper) layer is important, a group having a cyclic alkyl group or an alkyl group having 1 to 8 carbon atoms is preferable.

$R^{N1}$ and $R^{N2}$ may be linked to each other to form a cyclic structure. The cyclic structure may have an oxygen atom or the like in the chain. The cyclic structure formed by $R^{N1}$ and $R^{N2}$ can be a monocyclic ring or may be a fused ring, but is preferably a monocyclic ring. The cyclic structure to be formed is preferably a 5-membered ring or a 6-membered ring containing a nitrogen atom in Formula (N1), examples thereof include a pyrrole ring, an imidazole ring, a pyrazole ring, a pyrroline ring, a pyrrolidine ring, an imidazolidine ring, a pyrazolidine ring, a piperidine ring, a piperazine ring, and a morpholine ring, and preferred examples thereof include a pyrroline ring, a pyrrolidine ring, a piperidine ring, a piperazine ring, and a morpholine ring.

$R^{C1}$ represents a hydrogen atom or a protective group, and it is preferably a hydrogen atom.

The protective group is preferably a protective group that decomposes under the action of an acid or a base, and examples thereof preferably include a protective group that decomposes by an acid.

Specific examples of the protective group include a chain-like or cyclic alkyl group and a chain-like or cyclic alkyl group having an oxygen atom in the chain. Examples of the chain-like or cyclic alkyl group include a methyl group, an ethyl group, an isopropyl group, a tert-butyl group, and a cyclohexyl group. Examples of the chain-like alkyl group having an oxygen atom in the chain include an alkyloxyalkyl group, and a methyloxymethyl (MOM) group and an ethyloxyethyl (EE) group are preferable. Examples of the cyclic alkyl group having an oxygen atom in the chain include an epoxy group, a glycidyl group, an oxetanyl group, a tetrahydrofuranyl group, and a tetrahydropyranyl (THP) group.

In Formula (N1), the divalent linking group constituting L is not particularly limited, but is preferably a hydrocarbon group and more preferably an aliphatic hydrocarbon group. The hydrocarbon group may have a substituent or may have an atom other than a carbon atom in the hydrocarbon chain. The divalent linking group is more preferably a divalent hydrocarbon linking group which may have an oxygen atom in the chain, still more preferably a divalent aliphatic hydrocarbon group which may have an oxygen atom in the chain, a divalent aromatic hydrocarbon group, or a group including a combination of a divalent aliphatic hydrocarbon group which may have an oxygen atom in the chain and a divalent aromatic hydrocarbon group, and even still more preferably a divalent aliphatic hydrocarbon group which may have an oxygen atom in the chain. These groups may not have an oxygen atom.

The divalent hydrocarbon linking group preferably has 1 to 24 carbon atoms, more preferably 2 to 12 carbon atoms, and still more preferably 2 to 6 carbon atoms. The divalent aliphatic hydrocarbon group preferably has 1 to 12 carbon atoms, more preferably 2 to 6 carbon atoms, and still more preferably 2 to 4 carbon atoms. The divalent aromatic hydrocarbon group preferably has 6 to 22 carbon atoms, more preferably 6 to 18 carbon atoms, and still more preferably 6 to 10 carbon atoms. The group including a combination of a divalent aliphatic hydrocarbon group and a divalent aromatic hydrocarbon group (for example, an arylene alkyl group) preferably has 7 to 22 carbon atoms, more preferably 7 to 18 carbon atoms, and still more preferably 7 to 10 carbon atoms.

Specifically, the linking group L is preferably a linear or branched chain-like alkylene group, a cyclic alkylene group, a group including a combination of a chain-like alkylene group and a cyclic alkylene group, an alkylene group having an oxygen atom in the chain, a linear or branched chain-like alkenylene group, a cyclic alkenylene group, an arylene group, or an arylene alkylene group.

The linear or branched chain-like alkylene group preferably has 1 to 12 carbon atoms, more preferably 2 to 6 carbon atoms, and still more preferably 2 to 4 carbon atoms.

The cyclic alkylene group preferably has 3 to 12 carbon atoms and more preferably 3 to 6 carbon atoms.

The group including a combination of a chain-like alkylene group and a cyclic alkylene group preferably has 4 to 24 carbon atoms, more preferably 4 to 12 carbon atoms, and still more preferably 4 to 6 carbon atoms.

The alkylene group having an oxygen atom in the chain may be chain-like or cyclic or may be linear or branched. The alkylene group having an oxygen atom in the chain preferably has 1 to 12 carbon atoms, more preferably 1 to 6 carbon atoms, and still more preferably 1 to 3 carbon atoms.

The linear or branched chain-like alkenylene group preferably has 2 to 12 carbon atoms, more preferably 2 to 6 carbon atoms, and still more preferably 2 to 3 carbon atoms. The number of C=C bonds in the linear or branched chain-like alkenylene group is preferably 1 to 10, more preferably 1 to 6, and still more preferably 1 to 3.

The cyclic alkenylene group preferably has 3 to 12 carbon atoms and more preferably 3 to 6 carbon atoms. In the cyclic alkenylene group, the number of C=C bonds is preferably 1 to 6, more preferably 1 to 4, and still more preferably 1 to 2.

The arylene group preferably has 6 to 22 carbon atoms, more preferably 6 to 18 carbon atoms, and still more

preferably 6 to 10 carbon atoms.

The arylene alkylene group preferably has 7 to 23 carbon atoms, more preferably 7 to 19, and still more preferably 7 to 11 carbon atoms.

Among the above, a preferred one is a chain-like alkylene group, a cyclic alkylene group, an alkylene group having an oxygen atom in the chain, a chain-like alkenylene group, an arylene group, or an arylene alkylene group, and more preferred one is a 1,2-ethylene group, a propanediyl group (particularly a 1,3-propanediyl group), a cyclohexanediyl group (particularly a 1,2-cyclohexanediyl group), a vinylene group (particularly a cisvinylene group), a phenylene group (a 1,2-phenylene group), a phenylene methylene group (particularly a 1,2-phenylene methylene group) or an ethyleneoxyethylene group (particularly a 1,2-ethyleneoxy-1,2-ethylene group).

Examples of the base generator include the following compounds; however, the base generator is not limited thereto.

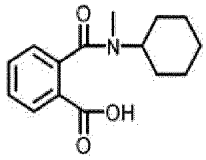
(B-1)

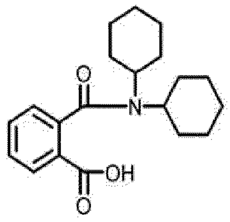
(B-2)

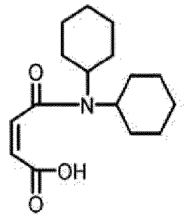
(B-3)

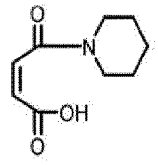
(B-4)

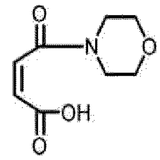
(B-5)

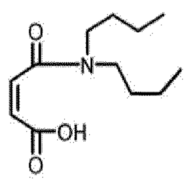
(B-6)

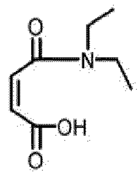
(B-7)

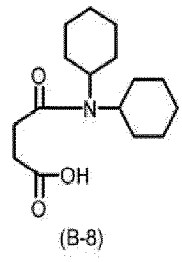
(B-8)

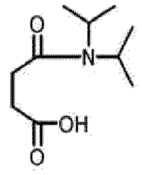
(B-9)

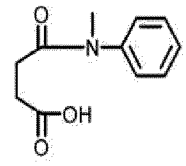
(B-10)

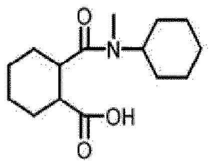
(B-11)

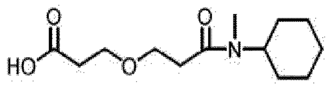
(B-12)

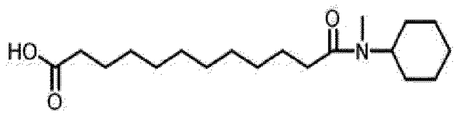
(B-13)

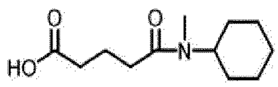
(B-14)

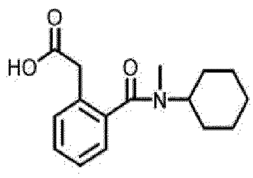
(B-15)

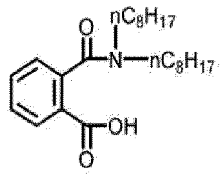
(B-16)

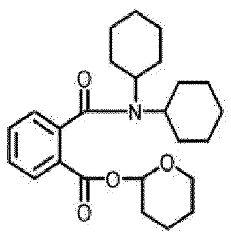
(B-17)

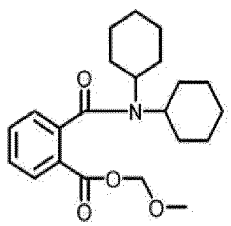
(B-18)

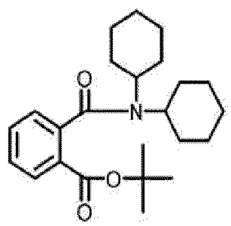
(B-19)

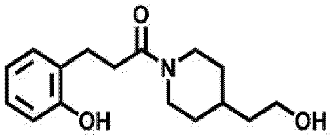

(B-20)

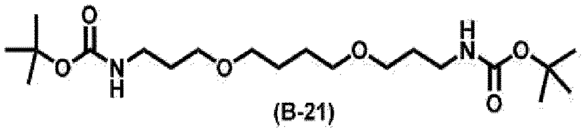

(B-21)

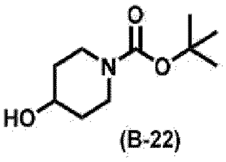

(B-22)

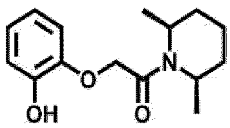

(B-23)

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/038002A.

Specific examples of the ammonium salt include the following compounds; however, the ammonium salt is not limited thereto.

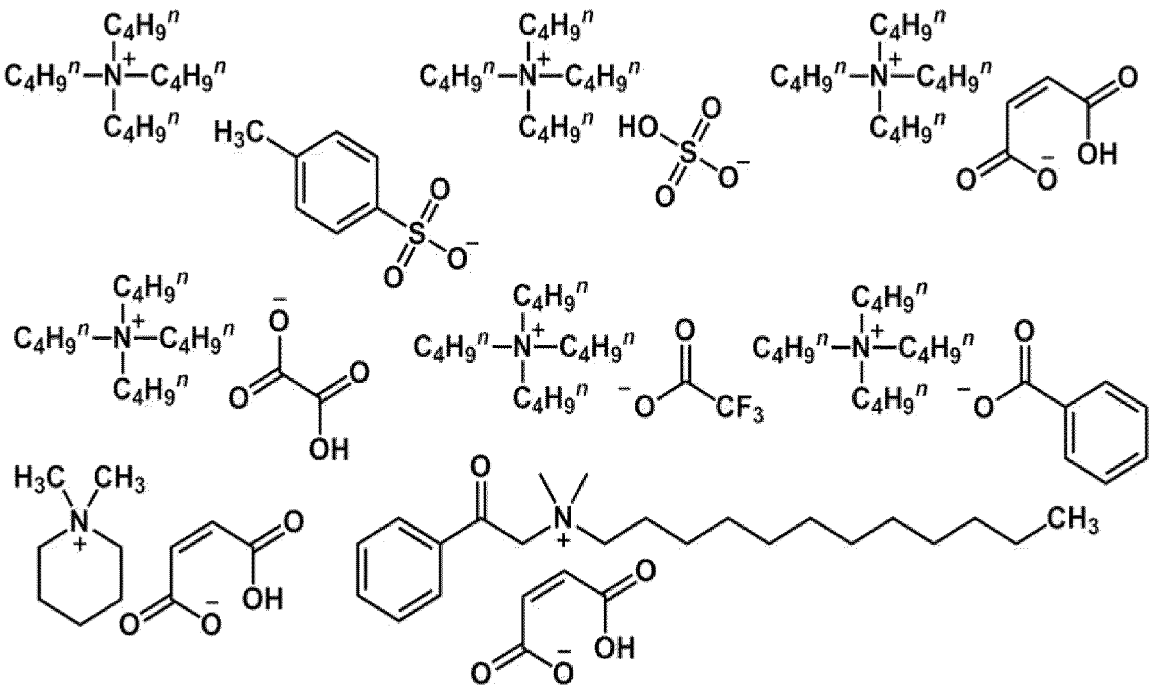

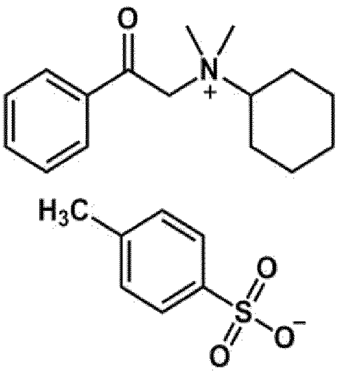

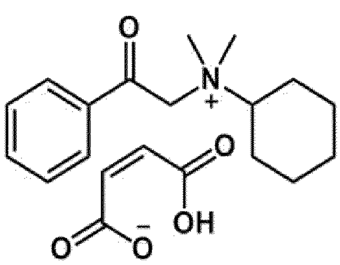

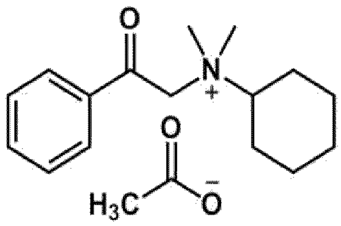

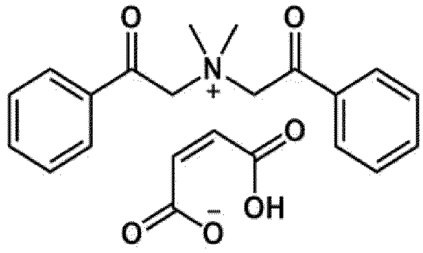

Specific examples of the iminium salt include the following compounds; however, the iminium salt is not limited thereto.

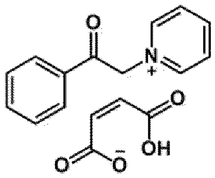

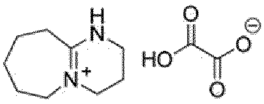

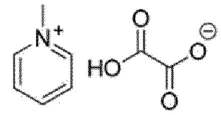

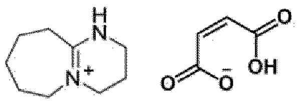

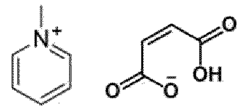

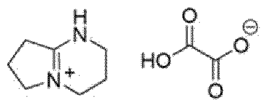

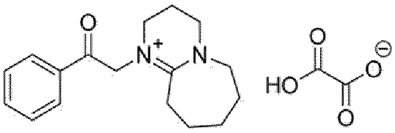

In addition, from the viewpoint of storage stability and generation of a base by deprotection during curing, the base generator is preferably an amine in which an amino group is protected by a t-butoxycarbonyl group.

Examples of the amine compound protected by a t-butoxycarbonyl group include ethanolamine, 3-amino-1-propanol, 1-amino-2-propanol, 2-amino-1-propanol, 4-amino-1-butanol, 2-amino-1-butanol, 1-amino-2-butanol, 3-amino-2,2-dimethyl-1-propanol, 4-amino-2-methyl-1-butanol, valinol, 3-amino-1,2-propanediol, 2-amino-1,3-propanediol, tyramine, norephedrine, 2-amino-1-phenyl-1,3-propanediol, 2-aminocyclohexanol, 4-aminocyclohexanol, 4-aminocyclohexanethanol, 4-(2-aminoethyl)cyclohexanol, N-methylethanolamine, 3-(methylamino)-1-propanol, 3-(isopropylamino)propanol, N-cyclohexylethanolamine, α-[2-(methylamino)ethyl]benzyl alcohol, diethanolamine, diisopropanolamine, 3-pyrrolidinol, 2-pyrrolidinomethanol, 4-hydroxypiperidine, 3-hydroxypiperidine, 4-hydroxy-4-phenylpiperidine, 4-(3-hydroxyphenyl)piperidine, 4-piperidinemethanol, 3-piperidinemethanol, 2-piperidinemethanol, 4-piperidinetanol, 2-piperidinetanol, 2-(4-piperidyl)-2-propanol, 1,4-butanol bis(3-aminopropyl)ether, 1,2-bis(2-aminoethoxy)ethane, 2,2'-oxybis(ethylamine), 1, 14-diamino-3,6,9,12-tetraoxatetradecane, 1-aza-15-crown 5-ether, diethylene glycol bis(3-aminopropyl)ether, 1,11-diamino-3,6,9-trioxaundecane, or a compound in which an amino group of an amino acid and a derivative thereof is protected by a t-butoxycarbonyl group, but the present invention is not limited to these examples.

In a case where the resin composition contains a base generator, the content of the base generator is preferably 0.1 to 50 parts by mass with respect to 100 parts by mass of the resin in the resin composition. The lower limit thereof is more preferably 0.3 parts by mass or more and still more preferably 0.5 parts by mass or more. The upper limit thereof is more preferably 30 parts by mass or less, still more preferably 20 parts by mass or less, even still more preferably 10 parts by mass or less, even further still more preferably 5 parts by mass or less, and particularly preferably 4 parts by mass or less.

One kind or two or more kinds of base generators can be used. **In** a case where two or more kinds thereof are used, the total amount is preferably within the above-described range.

<Solvent>

The resin composition according to the embodiment of the present invention preferably contains a solvent.

As the solvent, any publicly known solvent can be used. The solvent is preferably an organic solvent. Examples of the organic solvent include compounds such as esters, ethers, ketones, cyclic hydrocarbons, sulfoxides, carbonates,

amides, ureas, and alcohols.

Suitable examples of the esters include ethyl acetate, n-butyl acetate, isobutyl acetate, hexyl acetate, amyl formate, isoamyl acetate, cyclohexyl acetate, butyl propionate, isopropyl butyrate, ethyl butyrate, butyl butyrate, methyl lactate, ethyl lactate, γ-butyrolactone, ε-caprolactone, δ-valerolactone, γ- valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, cycloheptanone, 2-heptanone, 3-heptanone, 3-methylcyclohexanone, 4-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the carbonates include propylene carbonate.

Suitable examples of the amides include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropanamide, 3-butoxy-N,N-dimethylpropanamide, 2-hydroxy-N,N-dimethylpropanamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, γ- valerolactone, 3-methoxy-N,N-dimethylpropanamide, toluene, dimethyl sulfoxide, ethyl carbitol acetate, butyl carbitol acetate, N-methyl-2-pyrrolidone, propylene glycol methyl ether, and propylene glycol methyl ether acetate, as well as levoglucosenone and dihydrolevoglucosenone, or a mixed solvent composed of two or more of these. A combined use of dimethyl sulfoxide and γ-butyrolactone, a combined use of dimethyl sulfoxide and γ-valerolactone, a combined use of 3-methoxy-N,N-dimethylpropanamide and γ-butyrolactone, a combined use of 3-methoxy-N,N-dimethylpropanamide and dimethyl sulfoxide, or, a combined use of N-methyl-2-pyrrolidone and ethyl lactate is particularly preferable. An aspect in which an amount of about 1% to 10% by mass of toluene with respect to the total mass of the solvent is further added to these combinedly used solvents is also one of the preferred aspects of the present invention.

In particular, from the viewpoint of the storage stability of the resin composition, an aspect in which γ-valerolactone is included as the solvent is also one of the preferred aspects of the present invention. In such an aspect, the content of γ-valerolactone with respect to the total mass of the solvent is preferably 50% by mass or more, more preferably 60% by mass or more, and still more preferably 70% by mass or more. In addition, the upper limit of the above-described content is not particularly limited, and it may be 100% by mass. The above-described content may be

determined in consideration of the solubility or the like of the component contained in the resin composition, such as the specific resin.

In addition, in a case where dimethyl sulfoxide and γ-valerolactone are used in combination, with respect to the total mass of the solvent, it is preferable to contain 60% to 90% by mass of γ-valerolactone and 10% to 40% by mass of dimethyl sulfoxide, it is more preferable to contain 70% to 90% by mass of γ-valerolactone and 10% to 30% by mass of dimethyl sulfoxide, and it is still more preferable to contain 75% to 85% by mass of γ-valerolactone and 15% to 25% by mass of dimethyl sulfoxide.

Here, from the viewpoint that the solvent is easily removed during drying, the film contraction during the heating step due to the volatilization of the remaining solvent is suppressed, and the flatness of the cured substance is improved, the resin composition according to the embodiment of the present invention preferably contains a solvent having a boiling point of 180°C or lower.

Examples of the solvent having a boiling point of 180°C or lower include ethyl lactate, cyclopentanone, cyclohexanone, cycloheptanone, 4-methylcyclohexanone, 3-methylcyclohexanone, anisole, and cyclohexyl acetate.

The solvent having a boiling point of 180°C or lower may be used alone or in combination of two or more kinds thereof.

In addition, from the viewpoint of improving the in-plane wafer coating uniformity by adjusting the drying rate, it is also preferable that the solvent includes a solvent having a boiling point of 180°C or lower and a solvent having a boiling point of higher than 180°C.

Examples of such an aspect include a combination of N-methyl-2-pyrrolidone and ethyl lactate, a combination of N-methyl-2-pyrrolidone and cyclopentanone, a combination of γ-butyrolactone and cyclopentanone, a combination of γ-valerolactone and cyclopentanone, and a combination of propylene carbonate and cyclopentanone.

In the above-described aspect, it is preferable that a solvent having a boiling point of 180°C or lower in an amount of 40% to 90% by mass and a solvent having a boiling point of higher than 180°C in an amount of 10% to 60% by mass are contained, more preferable that a solvent having a boiling point of 180°C or lower in an amount of 50% to 90% by mass and a solvent having a boiling point of higher than 180°C in an amount of 10% to 50% by mass are contained, and still more preferable that a solvent having a boiling point of 180°C or lower in an amount of 60% to 85% by mass and a solvent having a boiling point of higher than 180°C in an amount of 15% to 40% by mass are contained, with respect to the total mass of the solvent.

In the above-described aspect, the solvent having a boiling point of 180°C or lower may be used alone or in combination of two or more kinds thereof. In a case where two or more types thereof are used in combination, it is preferable that the total amount thereof is within the above-described range.

In the above-described aspect, the solvent having a boiling point of higher than 180°C may be used alone or in combination of two or more kinds thereof. In a case where two or more types thereof are used in combination, it is preferable that the total amount thereof is within the above-described range.

Regarding the content of the solvent, the amount of the solvent is such that, from the viewpoint of coatability, the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method. In a case where two or more kinds of solvents are contained, the total thereof is preferably within the above-described range.

<Metal adhesiveness improving agent>

From the viewpoint of improving adhesiveness to a metal material used for an electrode, a wire, or the like, the resin composition according to the embodiment of the present invention preferably contains a metal adhesiveness improving agent. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

[Silane coupling agent]

Examples of the silane coupling agent include the compounds described in paragraph 0316 of WO2021/112189A and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. It is also preferable to use the following compound as the silane coupling agent. In the following Formulae, Me represents a methyl group, and Et represents an ethyl group. In addition, examples of R shown below include a structure derived from a blocking agent in a

blocked isocyanate group. The blocking agent may be selected depending on the desorption temperature; however, examples thereof include an alcohol compound, a phenol compound, a pyrazole compound, a triazole compound, a lactam compound, and an active methylene compound. It is preferably caprolactam or the like, for example, from the viewpoint of setting the desorption temperature to 160°C to 180°C. Examples of the commercially available product of such a compound include X-12-1293 (manufactured by Shin-Etsu Chemical Co., Ltd.).

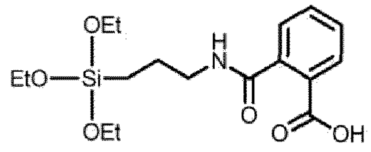
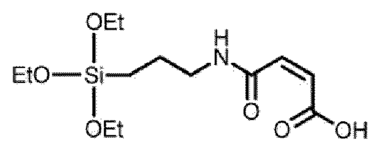

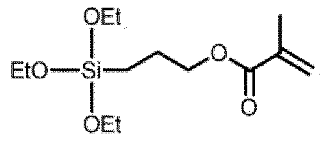
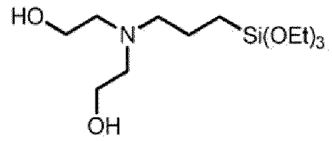
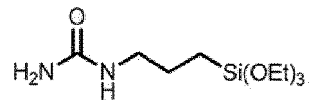

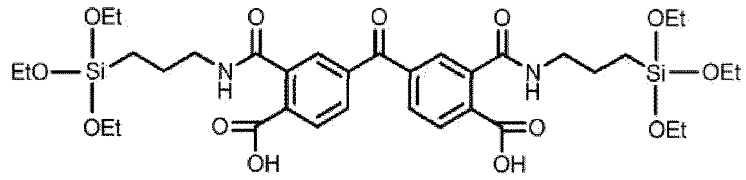

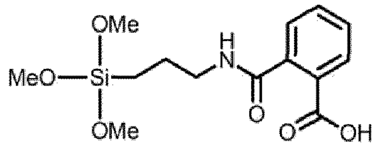
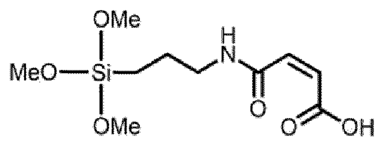

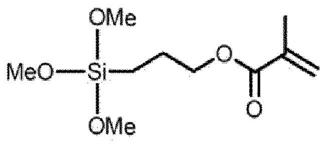
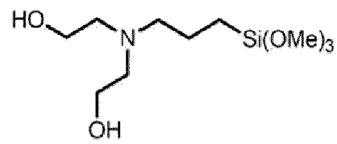
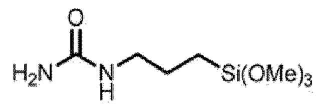

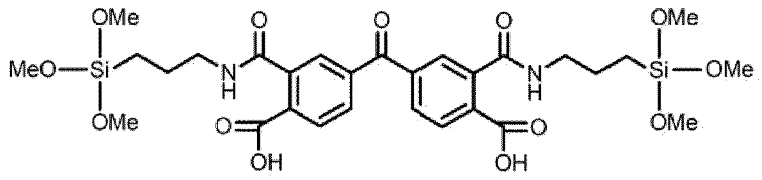

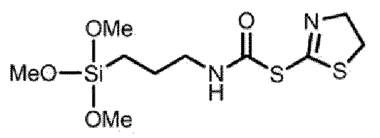
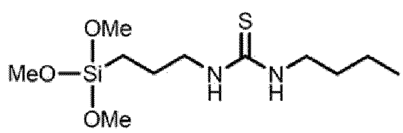

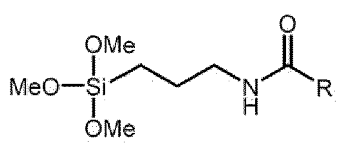
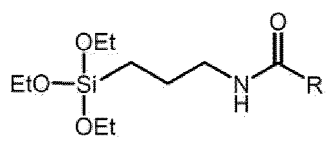

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. These can be used alone or in a combination of two or more thereof.

In addition, an oligomer type compound having a plurality of alkoxysilyl groups can also be used as the silane coupling agent.

Examples of such an oligomer type compound include a compound containing a repeating unit represented by Formula (S-1).

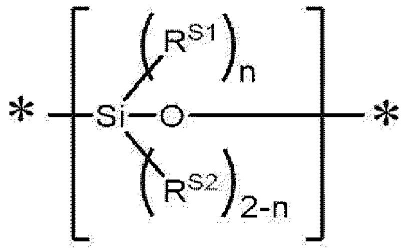

(S-1)

In Formula (S-1), $R^{S1}$ represents a monovalent organic group, $R^{S2}$ represents a hydrogen atom, a hydroxy group, or an alkoxy group, and n represents an integer of 0 to 2.

$R^{S1}$ preferably has a structure including a polymerizable group. Examples of the polymerizable group include a group having an ethylenically unsaturated bond, an epoxy group, an oxetanyl group, a benzoxazolyl group, a blocked isocyanate group, and an amino group. Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth) acryloyloxy group is more preferable, and a (meth)acryloyloxy group is still more preferable.

$R^{S2}$ is preferably an alkoxy group, and more preferably a methoxy group or an ethoxy group.

n represents an integer of 0 to 2, and it is preferably 1.

Here, structures of a plurality of repeating units represented by Formula (S-1) may be the same, where the plurality of repeating units are contained in the oligomer type compound.

Here, among a plurality of repeating units represented by Formula (S-1), which are contained in the oligomer type compound, it is preferable that at least one repeating unit has n of 1 or 2, it is more preferable that at least two repeating units have n of 1 or 2, and it is still more preferable that at least two repeating units have n of 1.

As such an oligomer type compound, a commercially available product can be used, and examples thereof include KR-513 (manufactured by Shin-Etsu Chemical Co., Ltd.).

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

As another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably 0.01 to 30 parts by mass, more preferably 0.1 to 10 parts by mass, and still more preferably 0.5 to 5 parts by mass with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical characteristics are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. For example, in a case where the resin composition is applied to a metal layer (or a metal wiring line) to form a film, it is possible to effectively suppress the migration of metal ions derived from the metal layer (or the metal wiring line) into the film, in a case where a migration suppressing agent is contained.

The migration suppressing agent is not particularly limited; however, examples thereof include a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

As the migration suppressing agent, an ion trap agent that captures an anion such as a halogen ion can also be used.

the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used as the other migration suppressing agents, the contents of which are incorporated in the present specification.

Specific examples of the migration suppressing agent include the following compounds.

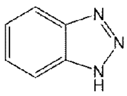

M-1

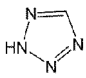

M-2

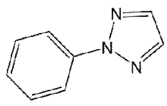

M-3

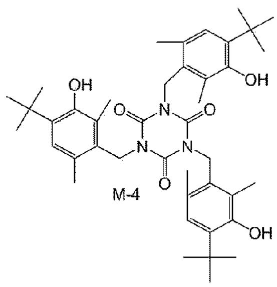

M-4

In a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition.

One kind of migration suppressing agent may be used alone, or two or more kinds thereof may be used. In a case where two or more kinds of migration suppressing agents are used, the total thereof is preferably within the above-described range.

<Light absorbing agent>

The resin composition according to the embodiment of the present invention also preferably contains a compound (a light absorbing agent) having a small absorbance at an exposure wavelength thereof upon exposure.

Whether or not a certain compound a contained in the resin composition corresponds to a light absorbing agent (that is, whether or not the absorbance thereof at the exposure wavelength decreases upon exposure) can be determined by the following method.

First, a solution of the compound a having the same concentration as the concentration contained in the resin composition is prepared, and the molar absorption coefficient of the compound a at the wavelength of the exposure light ($mol^{-1} \cdot L \cdot cm^{-1}$; also referred to as a "molar absorption coefficient 1") is measured. The above measurement is carried out quickly so that an influence of a change such as a decrease in the molar absorption coefficient of the compound a is small. As a solvent in the above solution, a solvent of the resin composition is used in a case where the resin composition contains a solvent, and N-methyl-2-pyrrolidone is used in a case where the resin composition does not contain a solvent.

Next, the solution of the compound a is irradiated with exposure light. The exposure amount is 500 mJ, in terms of the integrated amount, with respect to 1 mol of the compound a.

Then, using the exposed solution of the compound a, the molar absorption coefficient of the compound a at the wavelength of the exposure light ($mol^{-1} \cdot L \cdot cm^{-1}$; also referred to as a "molar absorption coefficient 2") is measured.

From the above-described molar absorption coefficient 1 and molar absorption coefficient 2, a decay rate (%) is calculated based on the following expression, and in a case where the decay rate (%) is 5% or more, it is determined that the compound a is a compound (that is, a light absorbing agent) in which the absorbance at the exposure wavelength decreases due to the exposure.

Attenuation rate (%) = 1 - molar absorption coefficient 2/molar absorption coefficient 1 $\times$ 100

The attenuation rate is preferably 10% or more and more preferably 20% or more. In addition, the lower limit of the attenuation rate is not particularly limited, and it may be any attenuation rate of 0% by mass or more.

In a case where the resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the resin composition has sensitivity. The fact that the photopolymerization initiator has sensitivity to a certain wavelength refers to that a polymerization initiation species is generated in a case where the photopolymerization initiator is exposed at a certain wavelength.

Examples of the wavelength of the exposure light, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high-pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet (EUV) ray (wavelength: 13.6 nm); (6) an electron beam; and (7) a second harmonic wave of 532 nm and a third harmonic wave of 355 nm of a YAG laser.

As the wavelength of the exposure light, for example, any wavelength at which the photopolymerization initiator has sensitivity may be selected; however, an h-line (wavelength: 405 nm) or an i-line (wavelength: 365 nm) is preferable, and an i-line (wavelength: 365 nm) is more preferable.

The light absorbing agent may be a compound that generates a radical polymerization initiation species upon exposure; however, it is preferably a compound that does not generate a radical polymerization initiation species upon exposure from the viewpoint of resolution and chemical resistance.

Whether or not the light absorbing agent is a compound that generates a radical polymerization initiation species upon exposure is determined according to the following method.

A solution, which contains the light absorbing agent having the same concentration as the concentration contained in the resin composition and contains a radical crosslinking agent, is prepared. In a case where the resin composition contains a radical crosslinking agent, as the radical crosslinking agent in the solution, the same compound as the radical crosslinking agent contained in the resin composition is used at the same concentration. In a case where the resin composition does not contain a radical crosslinking agent, methyl methacrylate is used at a concentration 5 times that of the light absorbing agent.

Then, the irradiation with the exposure light is carried out. The exposure amount is 500 mJ in terms of the integrated amount.

After the exposure, the polymerization of the polymerizable compound is determined by, for example, high performance liquid chromatography, and in a case where the proportion of the molar amount of the polymerized polymerizable compound to the total molar amount of the polymerizable compound is 10% or less, it is determined that the light absorbing agent is a compound that does not generate a radical polymerization initiation species upon exposure.

The proportion of the molar amount is preferably 5% or less and more preferably 3% or less. In addition, the lower limit of the proportion of the molar amount is not particularly limited and may be 0%.

In a case where the resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the resin composition has sensitivity.

Examples of the compound that generates a radical polymerization initiation species upon exposure include the same compound as the photoradical polymerization initiator described above. In a case where the composition contains a photoradical polymerization initiator as the light absorbing agent, the light absorbing agent shall be a compound, where a radical species generated from the compound has the lowest polymerization initiation ability, and the photopolymerization initiator shall be the other ones.

Examples of the compound that does not generate a radical polymerization initiation species upon exposure include a photoacid generator, a photobase generator, and a coloring agent having a changed absorption wavelength upon exposure.

Among these, the light absorbing agent is preferably a naphthoquinone diazide compound or a coloring agent

having a changed absorbance upon exposure, and it is more preferably a naphthoquinone diazide compound.

In addition, for example, it is also conceivable to use, as the light absorbing agent, a photoacid generator or photobase generator in combination with a compound of which an absorbance is reduced at the exposure wavelength depending on the pH.

[Naphthoquinone diazide compound]

Examples of the naphthoquinone diazide compound include a compound of which an absorbance is reduced at an exposure wavelength due to generation of an indene carboxylic acid upon exposure, where a compound having a 1,2-naphthoquinone diazide structure is preferable.

The naphthoquinone diazide compound is preferably a naphthoquinone diazide sulfonic acid ester of a hydroxy compound.

The hydroxy compound is preferably a compound represented by any one of Formulae (H1) to (H6).

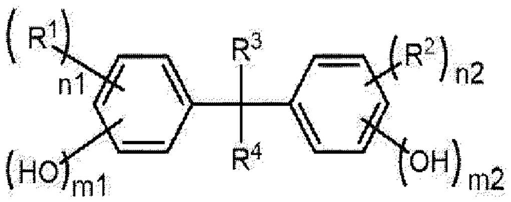

(H1)

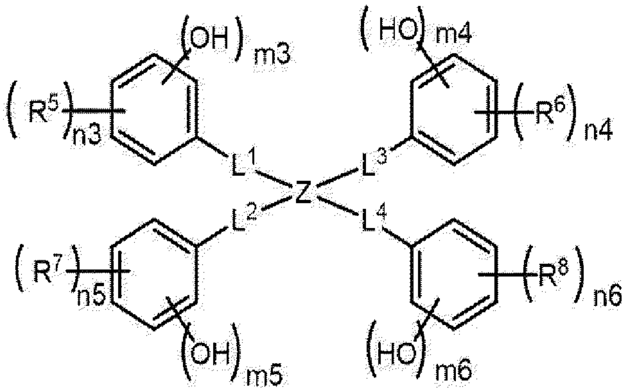

(H2)

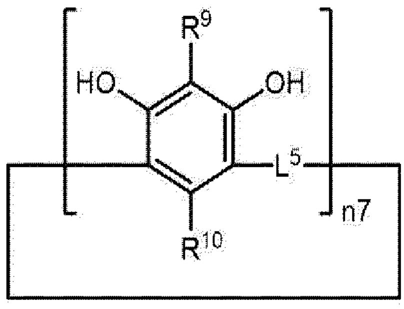

(H3)

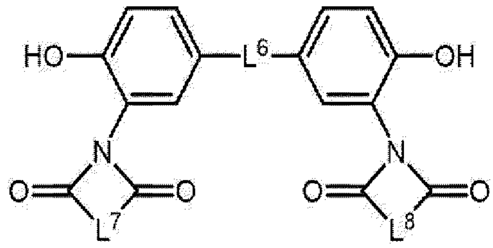

(H4)

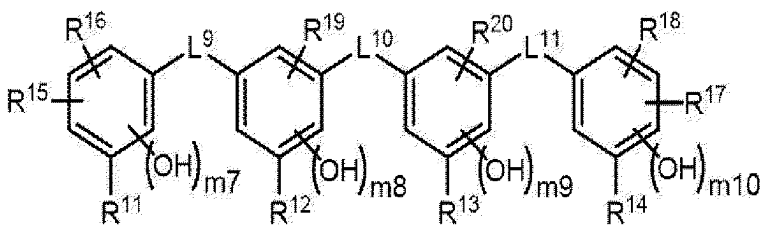

(H5)

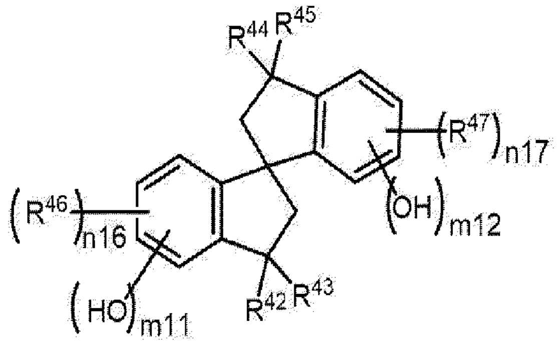

(H6)

In Formula (H1), $R^1$ and $R^2$ each independently represent a monovalent organic group, $R^3$ and $R^4$ each independently represent a hydrogen atom or a monovalent organic group, and n1, n2, m1, and m2 are each independently an integer of 0 to 5, where at least one of m1 or m2 is an integer of 1 to 5.

In Formula (H2), Z represents a tetravalent organic group, $L^1$, $L^2$, $L^3$, and $L^4$ each independently represent a single bond or a divalent organic group, $R^5$, $R^6$, and $R^7$ and $R^8$ each independently represent a monovalent organic group, n3, n4, n5, and n6 are each independently an integer of 0 to 3, and m3, m4, m5, and m6 are each independently an integer of 0 to 2 where at least one of m3, m4, m5, or m6 is 1 or 2.

In Formula (H3), $R^9$ and $R^{10}$ each independently represent a hydrogen atom or a monovalent organic group, $L^5$'s each independently represent a divalent organic group, and n7 represents an integer of 3 to 8.

In Formula (H4), $L^6$ represents a divalent organic group, and $L^7$ and $L^8$ each independently represent a divalent organic group containing an aliphatic tertiary or quaternary carbon.

In Formula (H5), $R^{11}$, $R^{12}$, $R^{13}$, $R^{14}$, $R^{15}$, $R^{16}$, $R^{17}$, $R^{18}$, $R^{19}$, and $R^{20}$ each independently represent a hydrogen atom, a halogen atom, or a monovalent organic group, $L^9$, $L^{10}$, and $L^{11}$ each independently represent a single bond or a divalent organic group, and m7, m8, m9, and m10 each independently represent an integer of 0 to 2, where at least one of m7, m8, m9, or m10 is 1 or 2.

In Formula (H6), $R^{42}$, $R^{43}$, $R^{44}$, and $R^{45}$ each independently represent a hydrogen atom or a monovalent organic group, $R^{46}$ and $R^{47}$ each independently represent a monovalent organic group, n16 and n17 each independently represent an integer of 0 to 4, and m11 and m12 each independently represent an integer of 0 to 4, where at least one of m11 or m12 is an integer of 1 to 4.

In Formula (H1), $R^1$ and $R^2$ are each independently preferably a monovalent organic group having 1 to 60 carbon atoms, and more preferably a monovalent organic group having 1 to 30 carbon atoms. Examples of the monovalent organic group as $R^1$ and $R^2$ include a hydrocarbon group which may have a substituent, and examples of the hydrocarbon group include an aromatic hydrocarbon group which may have a substituent such as a hydroxy group.

In Formula (H1), $R^3$ and $R^4$ are each independently preferably a monovalent organic group having 1 to 60 carbon atoms, and more preferably a monovalent organic group having 1 to 30 carbon atoms. Examples of the monovalent organic group as $R^3$ and $R^4$ include a hydrocarbon group which may have a substituent, and examples of the hydrocarbon group include a hydrocarbon group which may have a substituent such as a hydroxy group.

In Formula (H1), n1 and n2 are each independently preferably 0 or 1, and more preferably 0.

In Formula (H1), both m1 and m2 are preferably 1.

The compound represented by Formula (H1) is preferably a compound represented by any one of Formula (H1-1) to (H1-5).

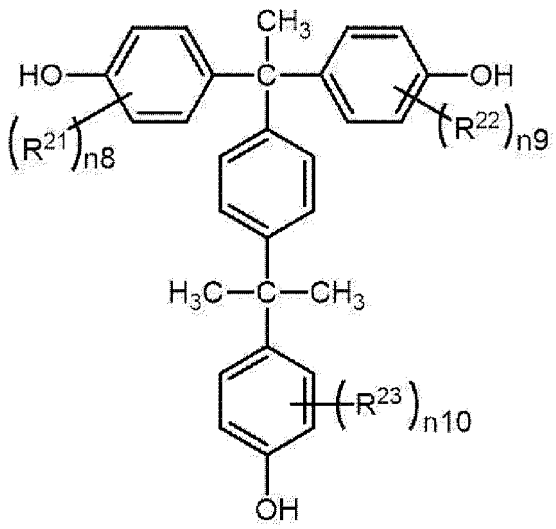

(H1-1)

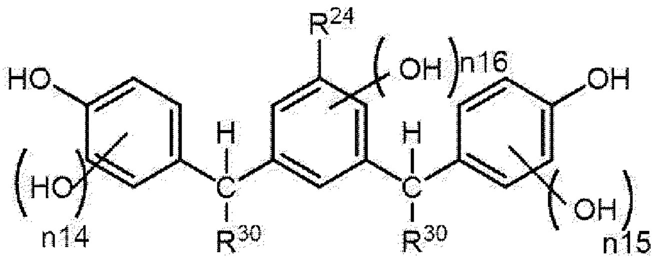

(H1-2)

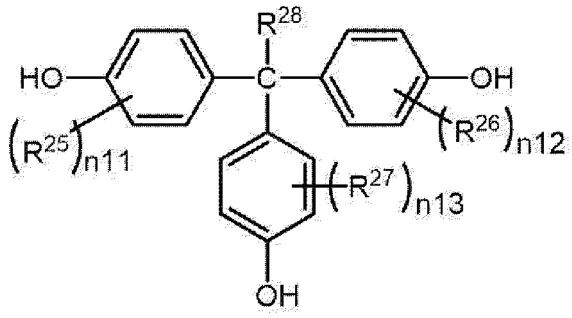

(H1-3)

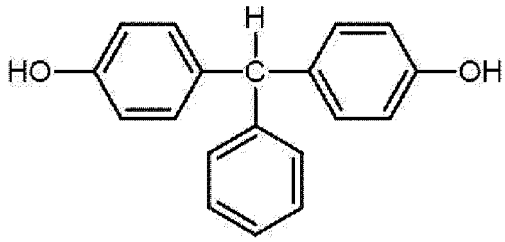

(H1-4)

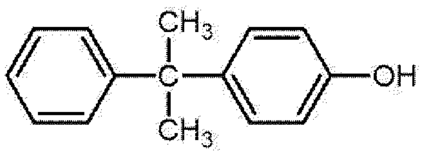

(H1-5)

In Formula (H1-1), $R^{21}$, $R^{22}$, and $R^{23}$ each independently represent a hydrogen atom or a monovalent organic group, and it is preferably a hydrogen atom or a monovalent organic group having 1 to 20 carbon atoms, and more preferably a hydrogen atom or a group represented by Formula (R-1).

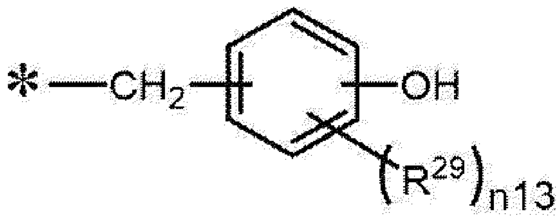

(R-1)

In Formula (R-1), $R^{29}$ represents a hydrogen atom, an alkyl group, or an alkoxy group, n13 represents an integer of 0 to 2, and * represents a bonding site to another structure.

In Formula(H1-1), n8, n9, and n10 each independently represent an integer of 0 to 2, where 0 or 1 is preferable.

In Formula (H1-2), $R^{24}$ represents a hydrogen atom or a monovalent organic group, and it is preferably a hydrogen atom, an alkyl group having 1 to 20 carbon atoms, or an alkoxy group having 1 to 20 carbon atoms. n14, n15, and n16 each independently represent an integer of 0 to 2. $R^{30}$ represents a hydrogen atom or an alkyl group.

In Formula (H1-3), $R^{25}$, $R^{26}$, $R^{27}$, and $R^{28}$ each independently represent a monovalent organic group, and they are preferably a hydrogen atom, an alkyl group, or a group represented by Formula (R-1).

In Formula (H1-3), n11, n12, and n13 each independently represent an integer of 0 to 2, where 0 or 1 is preferable.

The compound represented by Formula (H1-1) is preferably a compound represented by any one of Formulae (H1-1-1) to (H1-1-4).

The compound represented by Formula (H1-2) is preferably a compound represented by Formula (H1-2-1) or (H1-2-2).

The compound represented by Formula (H1-3) is preferably a compound represented by Formulae (H1-3-1) to (H1-3-3).

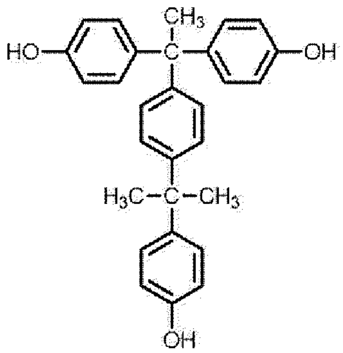

(H1-1-1)

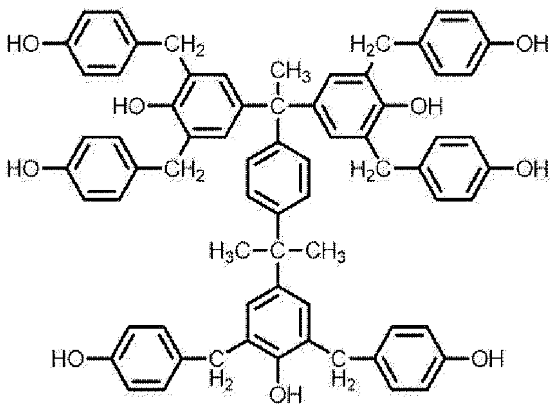

(H1-1-2)

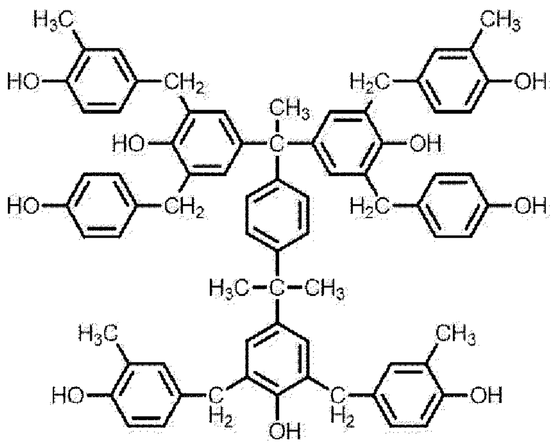

(H1-1-3)

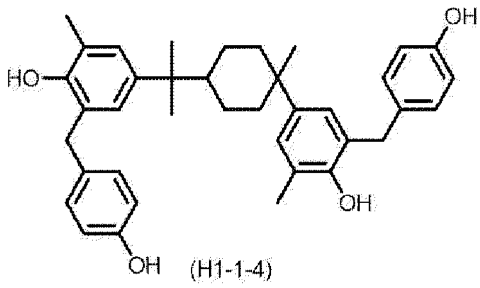

(H1-1-4)

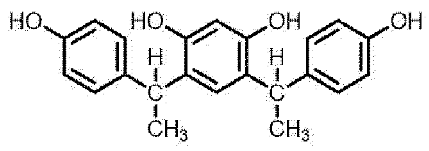

(H1-2-1)

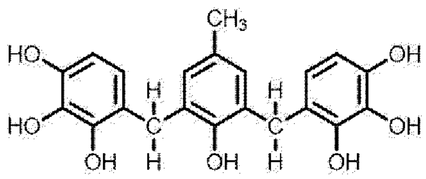

(H1-2-2)

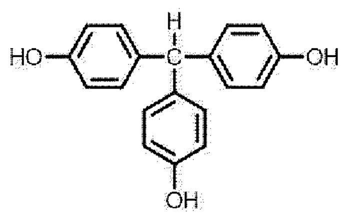

(H1-3-1)

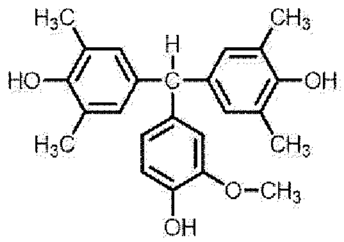

(H1-3-2)

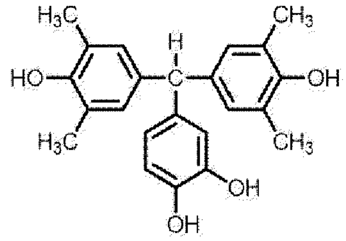

(H1-3-3)

In Formula (H2), Z is preferably a tetravalent group having 1 to 20 carbon atoms, and more preferably a group represented by any one of Formula (Z-1) to (Z-4). In Formulae (Z-1) to (Z-4), * represents a bonding site to another structure.

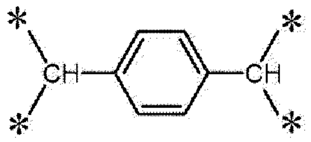

(Z-1)

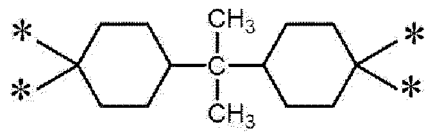

(Z-2)

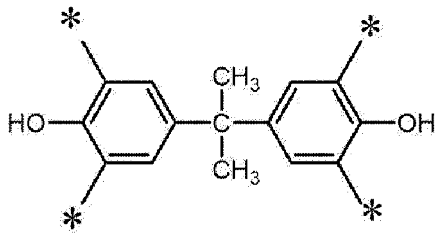

(Z-3)

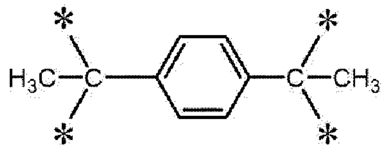

(Z-4)

In Formula (H2), $L^1$, $L^2$, $L^3$, and $L^4$ are each independently preferably a single bond or a methylene group.

In Formula (H2), $R^5$, $R^6$, $R^7$, and $R^8$ are each independently preferably an organic group having 1 to 30 carbon atoms.

In Formula (H2), n3, n4, n5, and n6 are each independently preferably an integer of 0 to 2, and more preferably 0 or 1.

In Formula (H2), m3, m4, m5, and m6 are each independently preferably 1 or 2, and more preferably 1.

Examples of the compound represented by Formula (H2) include compounds having the following structures.

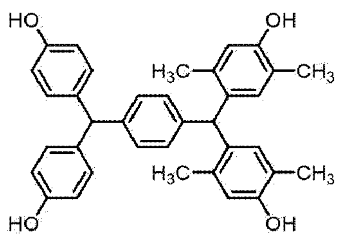

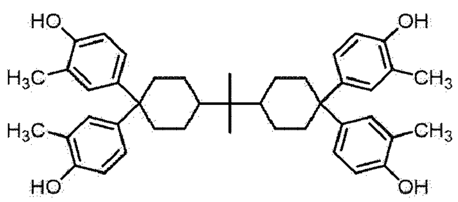

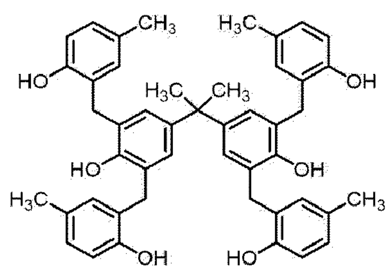

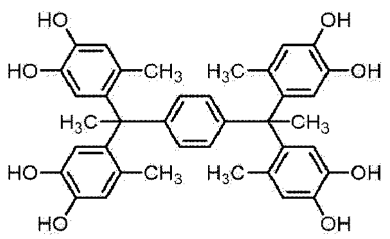

In Formula (H3), $R^9$ and $R^{10}$ each independently preferably represent a hydrogen atom or a monovalent organic group having 1 to 20 carbon atoms.

In Formula (H3), $L^5$'s are each independently preferably a group represented by Formula (L-1).

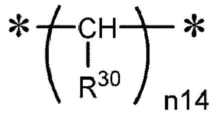

(L-1)

In Formula (L-1), $R^{30}$ represents a monovalent organic group having 1 to 20 carbon atoms, n14 represents an integer of 1 to 5, and * represents a bonding site to another structure.

In Formula (H3), n7 is preferably an integer of 4 to 6.

Examples of the compound represented by Formula (H3) include the following compounds. In the following Formula, n's each independently represent an integer of 0 to 9.

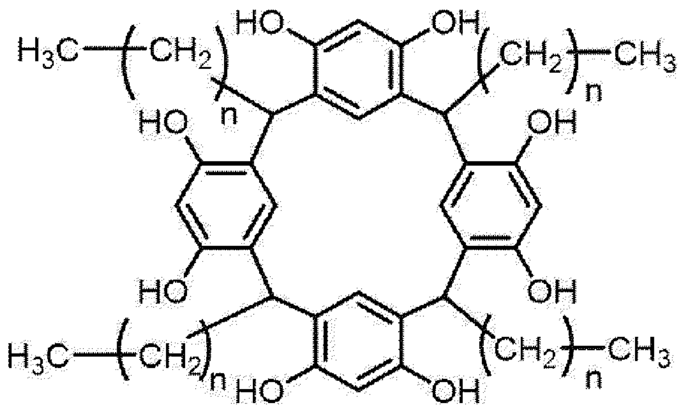

In Formula (H4), $L^6$ is preferably $-C(CF_3)_2-$, $-S(=O)_2-$, or $-C(=O)-$.

In Formula (H4), $L^7$ and $L^8$ are each independently preferably a divalent organic group having 2 to 20 carbon atoms.

Examples of the compound represented by Formula (H4) include the following compounds.

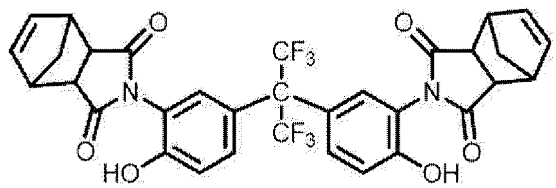

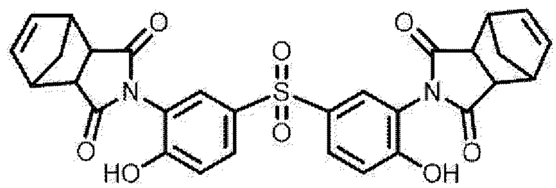

In Formula (H5), $R^{11}$, $R^{12}$, $R^{13}$, $R^{14}$, $R^{15}$ , $R^{16}$, $R^{17}$, $R^{18}$, $R^{19}$, and $R^{20}$ are each independently preferably a hydrogen atom, a halogen atom, an alkyl group, an alkenyl group, an alkoxy group, an allyl group, or an acyl group.

In Formula (H5), $L^9$, $L^{10}$, and $L^{11}$ are each independently preferably a single bond, -O-, -S-, $-S(=O)_2-$,-C(=O)-,-C(=O)O-, cyclopentylidene, cyclohexylidene, phenylene, or a divalent organic group having 1 to 20 carbon atoms, and they are more preferably a group represented by any one of Formula (L-2) to (L-4).

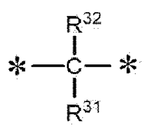

(L-2)

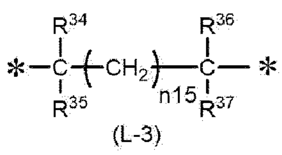

(L-3)

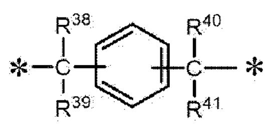

(L-4)

In Formulae (L-2) to (L-4), $R^{31}$ and $R^{32}$ each independently represent a hydrogen atom, an alkyl group, an alkenyl group, or an aryl group, $R^{34}$, $R^{35}$, $R^{36}$, and $R^{37}$ each independently represent a hydrogen atom or an alkyl group, n15 is an integer of 1 to 5, $R^{38}$, $R^{39}$, $R^{40}$, and $R^{41}$ each independently represent a hydrogen atom or an alkyl group, and * represents a

bonding site to another structure.

Examples of the compound represented by Formula (H5) include the following compounds.

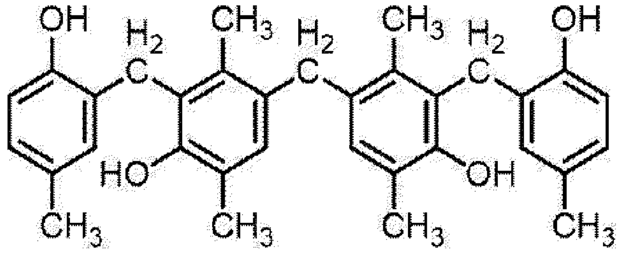

In Formula (H6), $R^{42}$, $R^{43}$, $R^{44}$, and $R^{45}$ each independently represent a hydrogen atom or a monovalent organic group and are preferably a hydrogen atom or a monovalent organic group having 1 to 20 carbon atoms, more preferably a hydrogen atom or an alkyl group having 1 to 20 carbon atoms, and still more preferably an alkyl group having 1 to 4 carbon atoms.

In Formula (H6), $R^{46}$ and $R^{47}$ are each independently preferably an alkyl group, an alkoxy group, or an aryl group, and more preferably an alkyl group.

In Formula (H6), n16 and n17 are each independently preferably an integer of 0 to 2, and more preferably 0 or 1.

In Formula (H6), n16 and n17 are each independently preferably an integer of 1 to 3, and more preferably 2 or 3.

Examples of the compound represented by Formula (H6) include the following compounds.

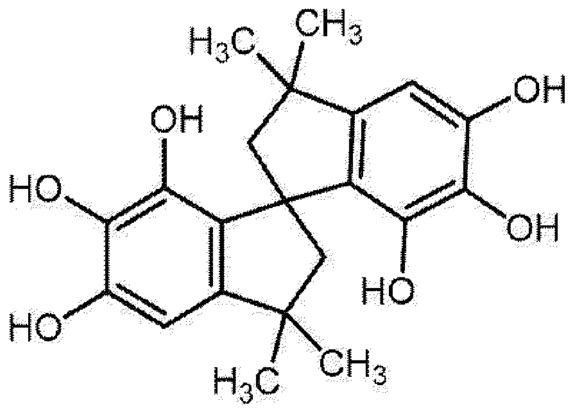

In addition, examples of the hydroxy compound include polyhydroxybenzophenones such as 2,3,4-trihydroxybenzophenone, 2,4,4'-trihydroxybenzophenone, 2,4,6-trihydroxybenzophenone, 2,3,4-trihydroxy-2'-methylbenzophenone, 2,3,4,4'-tetrahydroxybenzophenone, 2,2',4,4'-tetrahydroxybenzophenone, 2,4,6,3',4'-pentahydroxybenzophenone, 2,3,4,2',4'-pentahydroxybenzophenone, 2,3,4,2',5'-pentahydroxybenzophenone, 2,4,6,3',4',5'-hexahydroxybenzophenone, and 2,3,4,3',4',5'-hexahydroxybenzophenone; polyhydroxyphenylalkyl ketones such as 2,3,4-trihydroxyacetophenone, 2,3,4-trihydroxyphenylpentyl ketone, and 2,3,4-trihydroxyphenylhexyl ketone; bis((poly)hydroxyphenyl) alkanes such as bis(2,4-dihydroxyphenyl)methane, bis(2,3,4-trihydroxyphenyl)methane, bis(2,4-dihydroxyphenyl)propane-1, bis(2,3,4-trihydroxyphenyl)propane-1, nordihydroguaiaretic acid, and 1,1-bis(4-hydroxyphenyl)cyclohexane; polyhydroxybenzoic acid esters such as 3,4,5-trihydroxybenzoic acid propyl, 2,3,4-trihydroxybenzoic acid phenyl, and 3,4,5-trihydroxybenzoic acid phenyl;

bis(polyhydroxybenzoyl) alkanes or bis(polyhydroxybenzoyl) aryls such as bis(2,3,4-trihydroxybenzoyl)methane, bis(3-acetyl-4,5,6-trihydroxyphenyl)-methane, bis(2,3,4-trihydroxybenzoyl)benzene, and bis(2,4,6-trihydroxybenzoyl)benzene, alkylene-di(polyhydroxybenzoate) such as ethylene glycol-di(3,5-dihydroxybenzoate) or ethylene glycol-di(3,4,5-trihydroxybenzoate), polyhydroxybiphenyl such as 2,3,4-biphenyltriol, 3,4,5-biphenyltriol, 3,5,3',5'-biphenyltetrol, 2,4,2',4'-biphenyltetrol, 2,4,6,3',5'-biphenylpentol, 2,4,6,2',4',6'-biphenylhexol, or 2,3,4,2',3',4'-biphenylhexol, bis(polyhydroxy) sulfide such as 4,4'-thiobis(1,3-dihydroxy)benzene, bis(polyhydroxyphenyl) ether such as 2,2',4,4'-tetrahydroxydiphenyl ether, bis(polyhydroxyphenyl)sulfoxide such as 2,2',4,4'-tetrahydroxydiphenylsulfoxide, bis(polyhydroxyphenyl)sulfone such as 2,2',4,4'-diphenylsulfone,

polyhydroxytriphenylmethanes such as tris(4-hydroxyphenyl)methane, 4,4',4"-trihydroxy-3,5,3',5'-tetramethyltriphenylmethane, 4,4',3",4"-tetrahydroxy-3,5,3',5'-tetramethyltriphenylmethane, 4-[bis(3,5-dimethyl-4-hydroxyphenyl)methyl]-2-methoxy-phenol, 4,4'-(3,4-diol-benzylidene)bis[2,6-dimethylphenol], 4,4'-[(2-hydroxy-phenyl)methylene]bis[2-cyclohexyl-5-methylphenol], 4,4',2",3",4"-pentahydroxy-3,5,3',5'-tetramethyltriphenylmethane, 2,3,4,2',3',4'-hexahydroxy-5,5'-diacetyltriphenylmethane, 2,3,4,2',3',4',3",4"-octahydroxy-5,5'-diacetyltriphenylmethane, and 2,4,6,2',4',6'-hexahydroxy-5,5'-dipropionyltriphenylmethane, polyhydroxytriphenylethanes such as 4,4'-(phenylmethylene)bisphenol, 4,4'-(1-phenyl-ethylidene)bis[2-methylphenol], and 4,4',4"-ethylidene-trisphenol, polyhydroxyspirobiindanes such as 3,3,3',3'-tetramethyl-1,1'-spirobiindane-5,6,5',6'-tetrol, 3,3,3',3'-tetramethyl-1,1'-spirobiindane-5,6,7,5',6',7'-hexool, 3,3,3',3'-tetramethyl-1,1'-spirobiindane-4,5,6,4',5',6'-hexool, and 3,3,3',3'-tetramethyl-1,1'-spirobiindane-4,5,6,5',6',7'-hexool, polyhydroxyflavans such as 2,4,4-trimethyl-2',4',7'-trihydroxyflavan, polyhydroxyphthalides such as 3,3-bis(3,4-dihydroxyphenyl)phthalide, 3,3-bis(2,3,4-trihydroxyphenyl)phthalide, and 3',4',5',6'-tetrahydroxyspiro[phthalido-3,9'-xanthene], flavono coloring agents such as morin, quercetin, and rutin,

α,α',α"-tris(4-hydroxyphenyl) 1,3,5-triisopropylbenzene, α,α',α"-tris(3,5-dimethyl-4-hydroxyphenyl) 1,3,5-triisopropylbenzene, α,α',α"-tris(3,5-diethyl-4-hydroxyphenyl) 1,3,5-triisopropylbenzene, α,α',α"-tris(3,5-di-n-propyl-4-hydroxyphenyl) 1,3,5-triisopropylbenzene, α,α',α"-tris(3,5-diisopropyl-4-hydroxyphenyl) 1,3,5-triisopropylbenzene, α,α',α"-tris(3,5-di-n-butyl-4-hydroxyphenyl) 1,3,5-triisopropylbenzene, α,α',α"-tris(3-methyl-4-hydroxyphenyl) 1,3,5-triisopropylbenzene, α,α',α"-tris(3-methoxy-4-hydroxyphenyl) 1,3,5-triisopropylbenzene, α,α',α"-tris(2,4-dihydroxyphenyl) 1,3,5-triisopropylbenzene, 1,3,5-tris(3,5-dimethyl-4-hydroxyphenyl)benzene, 1,3,5-tris(5-methyl-2-hydroxyphenyl)benzene, 2,4,6-tris(3,5-dimethyl-4-hydroxyphenylthiomethyl)mesitylene, 1-[α-methyl-α-(4'-hydroxyphenyl)ethyl]-4-[α,α'-bis(4"-hydroxyphenyl)ethyl]benzene,polyhyd roxy compounds described in JP1992-253058A (JP-H4-253058A) such as 1-[α-methyl(4'-hydroxyphenyl)ethyl]-3-[α,α'-bis(4"-hydroxyphenyl) ethyl]benzene, 1-[α-methyl-α-(3',5'-dimethyl-4'-hydroxyphenyl)ethyl]-4-[α,α'-bis(3",5"-dimethyl-4"-hydroxy phenyl) ethyl]benzene, 1-[α-methyl(3'-methyl-4'-hydroxyphenyl)ethyl]-4-[α',α'-bis(3"-methyl-4"-hydroxyphenyl)ethy l]benzene, 1-[α-methyl-α-(3'-methoxy-4'-hydroxyphenyl)ethyl]-4-[α',α'-bis(3"-methoxy-4"-hydroxyphen yl)ethyl]benzene, 1-[α-methyl-α-(2',4'-dihydroxyphenyl)ethyl]-4-[α',α'-bis(4"-hydroxyphenyl)ethyl]benzene, and 1-[α-methyl(2',4'-dihydroxyphenyl)ethyl]-3-[α',α'-bis(4"-hydroxyphenyl)ethyl]benzene, polyhydroxy compounds described in JP1993-224410A (JP-H5-224410A) such as α,α,α',α',α",α"-hexakis-(4-hydroxyphenyl)-1,3,5-triethylbenzene, and poly(hydroxyphenyl)alkanes described in JP1993-303200A (JP-H5-303200A) and EP-530148 such as 1,2,2,3-tetra(p-hydroxyphenyl)propane and 1,3,3,5-tetra(p-hydroxyphenyl)pentane,

p-bis(2,3,4-trihydroxybenzoyl)benzene, p-bis(2,4,6-trihydroxybenzoyl)benzene, m-bis(2,3,4-trihydroxybenzoyl) benzene, m-bis(2,4,6-trihydroxybenzoyl)benzene, p-bis(2,5-dihydroxy-3-bromobenzoyl)benzene, p-bis(2,3,4-trihydroxy-5-methylbenzoyl)benzene, p-bis(2,3,4-trihydroxy-5-methoxybenzoyl)benzene, p-bis(2,3,4-trihydroxy-5-nitrobenzoyl)benzene, p-bis(2,3,4-trihydroxy-5-cyanobenzoyl)benzene, 1,3,5-tris(2,5-dihydroxybenzoyl)benzene, 1,3,5-tris(2,3,4-trihydroxybenzoyl)benzene, 1,2,3-tris(2,3,4-trihydroxybenzoyl)benzene, 1,2,4-tris(2,3,4-trihydroxybenzoyl)benzene, 1,2,4,5-tetrakis(2,3,4-trihydroxybenzoyl)benzene, α,α'-bis(2,3,4-trihydroxybenzoyl)p-xylene, α,α',α'-tris(2,3,4-trihydroxybenzoyl)mesilene,

2,6-bis-(2-hydroxy-3,5-dimethylbenzyl)-p-cresol, 2,6-bis-(2-hydroxy-5'-methylbenzyl)-p-cresol, 2,6-bis-(2,4,6-trihydroxybenzyl)-p-cresol, 2,6-bis-(2,3,4-trihydroxybenzyl)-p-cresol, 2,6-bis(2,3,4-trihydroxybenzyl)-3,5-dimethyl-phenol, 4,6-bis-(4-hydroxy-3,5-dimethylbenzyl)-pyrogallol, 2,6-bis-(4-hydroxy-3,5-dimethylbenzyl)-1,3,4-trihydroxyphenol, 4,6-bis-(2,4,6-trihydroxybenzyl)-2,4-dimethyl-phenol, 4,6-bis-(2,3,4-trihydroxybenzyl)-2,5-dimethyl-phenol, 2,6-bis-(4-hydroxybenzyl)-p-cresol, 2,6-bis(4-hydroxybenzyl)-4-cyclohexylphenol, 2,6-bis(4-hydroxy-3-methylbenzyl)-p-cresol, 2,6-bis(4-hydroxy-3,5-dimethylbenzyl)-p-cresol,2,6-bis(4-hydroxy-2,5-dimethylbenzyl)-p-cres ol, 2,6-bis(4-hydroxy-3-methylbenzyl)-4-phenyl-phenol, 2,2',6,6'-tetrakis[(4-hydroxyphenyl)methyl]-4,4'-methylenediphenol, 2,2',6,6'-tetrakis[(4-hydroxy-3,5-dimethylphenyl)methyl]-4,4'-methylenediphenol, 2,2',6,6'-tetrakis[(4-hydroxy-3-methylphenyl)methyl]-4,4'-methylenediphenol, 2,2'-bis[(4-hydroxy-3,5-dimethylphenyl)methyl]6,6'-dimethyl-4,4'-methylenediphenol, 2,2',3,3'-tetrahydro-3,3,3',3'-tetramethyl-1,1'-spiropbi(1H-inden)-5,5',6,6',7,7'-hexanol, bis(4-hydroxy-3,5-dimethylphenyl)-(4-hydroxy-3-methoxyphenyl)methane, and the like.

In addition, a hyponuclear form of a phenol resin, such as a novolak resin, can also be used.

Examples of the naphthoquinone diazide sulfonic acid include 6-diazo 5,6-dihydro-5-oxo-1-naphthalenesulfonic acid and 1,2-naphthoquinone-(2)-diazo-5-sulfonic acid, where these may be mixedly used.

A production method for a naphthoquinone diazide sulfonic acid ester of a hydroxy compound is not particularly limited. However, it is obtained, for example, by converting naphthoquinone diazide sulfonic acid into a sulfonyl chloride with chlorosulfonic acid or thionyl chloride, and subjecting the obtained naphthoquinone diazide sulfonyl chloride to a condensation reaction with the hydroxy compound.

For example, it can be obtained by subjecting a hydroxy compound and a predetermined amount of naphthoquinone diazide sulfonyl chloride to a reaction in a solvent such as dioxane, acetone, or tetrahydrofuran, in the presence of a basic catalyst such as triethylamine to carry out esterification, washing the obtained product with water, and carrying out drying.

The esterification rate for the naphthoquinone diazide sulfonic acid ester is not particularly limited; however, it is

preferably 10% or more, and more preferably 20% or more. The upper limit of the esterification rate is not particularly limited and may be 100%.

The esterification rate can be checked by $^1$H-NMR or the like as a proportion of the esterified groups among the hydroxy groups contained in the hydroxy compound.

In addition, as the light absorbing agent, compounds described in paragraphs 0088 to 0108 of JP2019-206689A can also be used.

The content of the light absorbing agent with respect to the total solid content of the resin composition according to the embodiment of the present invention is not particularly limited, but is preferably 0.1% to 20% by mass, more preferably 0.5% to 10% by mass, and still more preferably 1% to 5% by mass.

In particular, from the viewpoint of improving the adhesiveness to the base material, the resin composition according to the embodiment of the present invention preferably further contains the above-described azole compound and the above-described silane coupling agent. By containing these compounds, particularly, the adhesiveness to the base material is likely to be maintained even after the cured substance is exposed to high temperature and high humidity conditions.

<Polymerization inhibitor>

The resin composition according to the embodiment of the present invention preferably contains a polymerization inhibitor. Examples of the polymerization inhibitor include a phenol-based compound, a quinone-based compound, an amino-based compound, an N-oxyl-free radical-based compound, a nitro-based compound, a nitroso-based compound, a heteroaromatic ring-based compound, and a metal compound.

Specific examples of the polymerization inhibitor include the compounds described in paragraph 0310 of WO2021/112189A, p-hydroquinone, o-hydroquinone, a 4-hydroxy-2,2,6,6-tetramethylpiperidine-1-oxyl free radical, phenoxazine, and 1,4,4-trimethyl-2,3-diazabicyclo[3.2.2]nona-2-en-N,N-dioxide. The content thereof is incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition.

One kind of polymerization inhibitor may be used, or two or more kinds thereof may be used. In a case where two or more kinds of polymerization inhibitors are used, the total thereof is preferably within the above-described range.

<Other additives>

The resin composition according to the embodiment of the present invention may contain various additives as necessary, for example, a surfactant, a higher fatty acid derivative, a thermal polymerization initiator, inorganic particles, an ultraviolet absorbing agent, an organic titanium compounds, an antioxidant, a photoacid generator, an aggregation inhibitor, a phenol-based compound, another polymer compound, a plasticizer, and other auxiliary agents (for example, an anti-foaming agent, and a flame retardant) within the scope in which the effect of the present invention is obtained. By appropriately containing these components, properties such as film properties can be adjusted. The details of the components can be found in, for example, paragraph "0183" and subsequent paragraphs of JP2012-003225A (corresponding to paragraph 0237 of US2013/0034812A) and paragraphs 0101 to 0104 and 0107 to 0109 of JP2008-250074A, the contents of which are incorporated in the present specification. In a case where these additives are blended, the total content thereof is preferably 3% by mass or less of the solid content of the resin composition according to the embodiment of the present invention.

[Surfactant]

From the viewpoint of exhibiting leveling properties during drying, suppressing coating film defects, and improving flatness, the resin composition preferably contains a surfactant.

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

Among these, a compound containing a silicon atom is preferable, and a silicone-based surfactant is more preferable.

In a case where a surfactant is contained in the photosensitive resin composition according to the embodiment of the present invention, the liquid characteristics (particularly, the fluidity) in a case where a coating liquid composition is prepared are further improved, and thus the uniformity of the coating thickness and the liquid saving property can be further improved. That is, in a case where a film is formed using a coating liquid containing a surfactant, the interfacial tension

between a surface to be coated and a coating liquid is reduced, the wettability to the surface to be coated is improved, and thus the coatability to the surface to be coated is improved. Therefore, it is possible to more suitably form a uniform film having a small thickness unevenness.

Examples of the fluorine-based surfactant include the compounds described in paragraph 0328 of WO2021/112189A, the contents of which are incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples thereof include the following compounds.

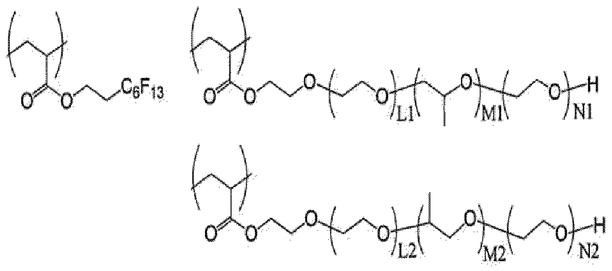

L1+N1+L2+N2=14
M1+M2=17

62% 38%

The weight-average molecular weight of the above-described compound is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specific examples thereof include the compounds described in paragraphs "0050" to "0090" and "0289" to "0295" of JP2010-164965A, the content of which is incorporated in the present specification. Further, examples of the commercially available product thereof include MEGAFACE RS-101, RS-102, and RS-718K, all manufactured by DIC Corporation.

The content of fluorine in the fluorine-based surfactant is preferably 3% to 40% by mass, more preferably 5% to 30% by mass, and particularly preferably 7% to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of the silicone-based surfactant, the hydrocarbon-based surfactant, the nonionic surfactant, the cationic surfactant, and the anionic surfactant include the compounds described in paragraphs 0329 to 0334 of WO2021/112189A, the contents of which are incorporated in the present specification.

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the resin composition according to the embodiment of the present invention, in order to prevent polymerization inhibition due to oxygen, a higher fatty acid derivative such as behenic acid or behenic acid amide may be added and be caused to be present at a higher density on the surface of the resin composition according to the embodiment of the present invention in the process of drying after coating.

In addition, as the higher fatty acid derivative, the compounds described in paragraph 0155 of WO2015/199219A can also be used, the content of which is incorporated in the present specification.

In a case where the resin composition has a higher fatty acid derivative, the content of the higher fatty acid derivative is preferably 0.1% to 10% by mass with respect to the total solid content of the resin composition. One kind of higher fatty acid derivative may be used, or two or more kinds thereof may be used. In a case where two or more kinds of higher fatty acid derivatives are used, the total thereof is preferably within the above-described range.

[Thermal polymerization initiator]

Examples of the thermal polymerization initiator include a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and

thus the solvent resistance can be further improved. In addition, there is a case where the photopolymerization initiator also has a function of initiating polymerization by heat, and thus there is a case where it can be added as a thermal polymerization initiator.

Specific examples of thermal radical polymerization initiator include compounds described in paragraphs 0074 to 0118 of JP2008-063554A, the content of which is incorporated in the present specification.

In a case where a thermal polymerization initiator is contained, the content thereof is preferably 0.1% to 30% by mass, more preferably 0.1% to 20% by mass, and still more preferably 0.5% to 15% by mass with respect to the total solid content of the resin composition. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.

The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.

The average particle diameter of the inorganic particles is the primary particle diameter and the volume average particle diameter. The volume average particle diameter can be measured by, for example, a dynamic light scattering method with Nanotrac WAVE II EX-150 (manufactured by Nikkiso Co., Ltd.).

In a case where the above measurement is difficult, the measurement can also be carried out by a centrifugal sedimentation light transmission method, an X-ray transmission method, or a laser diffraction/light scattering method.

[Ultraviolet absorbing agent]

Examples of the ultraviolet absorbing agent include a salicylate-based ultraviolet absorbing agent, a benzophenone-based ultraviolet absorbing agent, a benzotriazole-based ultraviolet absorbing agent, a substituted acrylonitrile-based ultraviolet absorbing agent, and a triazine-based ultraviolet absorbing agent.

Specific examples of the ultraviolet absorbing agent include the compounds described in paragraphs 0341 and 0342 of WO2021/112189A, the contents of which are incorporated in the present specification.

One kind of the ultraviolet absorbing agent may be used alone, or two or more kinds thereof may be used in combination.

In a case where the resin composition contains an ultraviolet absorbing agent, the content of the ultraviolet absorbing agent is preferably 0.001% by mass or more and 1% by mass or less, and more preferably 0.01% by mass or more and 0.1% by mass or less with respect to the total solid content mass of the resin composition.

[Organic titanium compound]

In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.

I) Titanium chelate compounds: a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).

II) Tetraalkoxytitanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), titanium tetrastearyloxide, and titanium tetrakis[bis{2,2-(aryloxymethyl)butoxide}].

III) Titanocene compounds: examples thereof include pentamethylcyclopentadienyl titanium trimethoxide, bis(η5-2,4-cyclopentadien-1-yl)bis(2,6-difluorophenyl)titanium, and bis(η5-2,4-cyclopentadien-1-yl)bis(2,6-difluoro-3-(1H-pyrrol-1-yl)phenyl)titanium.

IV) Monoalkoxytitanium compounds: examples thereof include titanium tris(dioctyl phosphate)isopropoxide, and titanium tris(dodecylbenzene sulfonate)isopropoxide.

V) Titanium oxide compounds: examples thereof include titanium oxide bis(pentanedionate), titanium oxide bis(tetramethylheptandionate), and phthalocyanine titanium oxide.

VI) Titanium tetraacetylacetonate compounds: examples thereof include titanium tetraacetylacetonate.

VII) Titanate coupling agents: examples thereof include isopropyltridodecylbenzenesulfonyl titanate.

Among these, it is preferable that the organic titanium compound is at least one compound selected from the group consisting of the above-described I) titanium chelate compound, II) tetraalkoxytitanium compound, and III) titanocene compound, from the viewpoint of more favorable chemical resistance. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In addition, it is also preferable that a compound represented by Formula (T-1) is contained as the organic titanium compound or instead of the organic titanium compound.

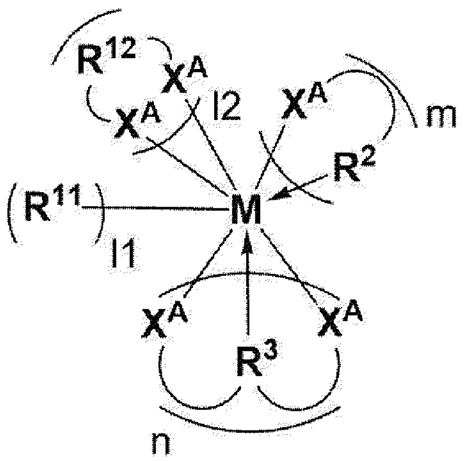

(T-1)

In Formula (T-1), M is titanium, zirconium, or hafnium, 11 is an integer of 0 to 2, l2 is 0 or 1, 11 + 12 × 2 is an integer of 0 to 2, m is an integer of 0 to 4, n is an integer of 0 to 2, 11 + l2 + m + n × 2 = 4 is satisfied, $R^{11}$'s are each independently a substituted or unsubstituted cyclopentadienyl group, a substituted or unsubstituted alkoxy group, or a substituted or unsubstituted phenoxy group, $R^{12}$ is a substituted or unsubstituted hydrocarbon group, $R^{2}$'s are each independently a group including a structure represented by Formula (T-2), $R^{3}$'s are each independently a group including a structure represented by Formula (T-2), and $X^{A}$'s are each independently an oxygen atom or a sulfur atom.

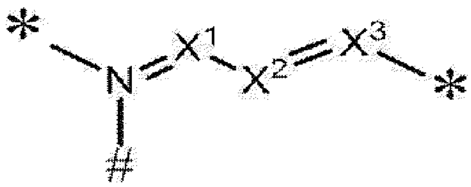

(T-2)

In Formula (T-2), $X^1$ to $X^3$ each independently represent -C(-*)= or -N=, *'s each represent a bonding site to another structure, and # represents a bonding site to a metal atom.

In Formula (T-1), it is preferable that M represents titanium from the viewpoint of the storage stability of the composition.

An aspect in which l1 and l2 in Formula (T-1) are 0 is also one of the preferred aspects of the present invention.

In Formula (T-1), m is preferably 2 or 4, and more preferably 2.

In Formula (T-1), n is preferably 1 or 2, and more preferably 1.

Here, in Formula (T-1), it is also preferable that 11 and l2 are 0 and m is 0, 2, or 4.

In Formula (T-1), $R^{11}$ is preferably a substituted or unsubstituted cyclopentadienyl ligand from the viewpoint of the stability of the specific metal complex.

In addition, the cyclopentadienyl group, the alkoxy group, and the phenoxy group as $R^{11}$ may be substituted; however, an aspect in which these are unsubstituted is also one of the preferred aspects of the present invention.

In Formula (T-1), $R^{12}$ is preferably a hydrocarbon group having 1 to 20 carbon atoms and more preferably a hydrocarbon group having 2 to 10 carbon atoms.

The hydrocarbon group as $R^{12}$ may be any of an aliphatic hydrocarbon group or an aromatic hydrocarbon group;

however, it is preferably an aromatic hydrocarbon group.

The aliphatic hydrocarbon group may be a saturated aliphatic hydrocarbon group or an unsaturated aliphatic hydrocarbon group; however, it is preferably a saturated aliphatic hydrocarbon group.

The aromatic hydrocarbon group is preferably an aromatic hydrocarbon group having 6 to 20 carbon atoms, more preferably an aromatic hydrocarbon group having 6 to 10 carbon atoms, and still more preferably a phenylene group.

The substituent as $R^{12}$ is preferably a monovalent substituent, and examples thereof include a halogen atom. In addition, in a case where $R^{12}$ is an aromatic hydrocarbon group, it may have an alkyl group as a substituent.

Among these, in Formula (T-1), $R^{12}$ is preferably an unsubstituted phenylene group. In addition, the phenylene group as $R^{12}$ is preferably a 1,2-phenylene group.

In Formula (T-1), in a case where m is 2 or more and two or more $R^2$'s contained, the structures of the two or more $R^2$'s may be the same or different from each other.

In Formula (T-1), in a case where n is 2 or more and two or more $R^3$'s contained, the structures of the two or more $R^3$'s may be the same or different from each other.

In Formula (T-2), $X^1$ to $X^3$ each independently represent -C(-*)= or -N=. It is preferable that at least one thereof represents -C(-*)=, and it is more preferable that at least two thereof represent -C(-*)=.

Specific examples of the compound represented by Formula (T-1) include compounds corresponding to I-5 to I-8 in Examples, but the present invention is not limited thereto.

In a case of containing an organic titanium compound, the content thereof is preferably 0.05 to 10 parts by mass and more preferably 0.1 to 5 parts by mass with respect to 100 parts by mass of the specific resin. In a case where the content thereof is 0.05 parts by mass or more, the heat resistance and the chemical resistance of the cured pattern to be obtained are further improved, and in a case where the content thereof is 10 parts by mass or less, the storage stability of the composition is more excellent.

[Antioxidant]

In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. Specific examples of the antioxidant include the compounds described in paragraphs 0348 to 0357 of WO2021/112189A, the contents of which are incorporated in the present specification.

The content of the antioxidant is preferably 0.1 to 10 parts by mass and more preferably 0.5 to 5 parts by mass with respect to 100% parts by mass of the specific resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Aggregation inhibitor]

Examples of the aggregation inhibitor include sodium polyacrylate.

One kind of the aggregation inhibitor may be used alone, or two or more kinds thereof may be used in combination.

In a case where the resin composition contains an aggregation inhibitor, the content of the aggregation inhibitor is preferably 0.01% by mass or more and 10% by mass or less, and more preferably 0.02% by mass or more and 5% by mass or less with respect to the total solid content mass of the resin composition.

[Phenol-based compound]

Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all of which are trade names, manufactured by Honshu Chemical Industry Co., Ltd.), BIP-PC, BIR-PC, BIR-PTBP, and BIR-BIPC-F (all of which are trade names, manufactured by ASAHI YUKIZAI Corporation).

One kind of the phenol-based compound may be used alone, or two or more kinds thereof may be used in combination.

In a case where the resin composition contains a phenol-based compound, the content of the phenol-based compound is preferably 0.01% by mass or more and 30% by mass or less and more preferably 0.02% by mass or more and 20% by mass or less with respect to the total solid content mass of the resin composition.

[Other polymer compound A]

Examples of the other polymer compound include a siloxane resin, a (meth)acrylic polymer obtained by copolymerizing (meth)acrylic acid, a novolac resin, a resol resin, a polyhydroxystyrene resin, and a copolymer thereof. The other polymer compound may be a modified product into which a crosslinking group such as a methylol group, an alkoxymethyl group, or an epoxy group has been introduced.
One kind of the other polymer compound may be used alone, or two or more kinds thereof may be used in combination.
In a case where the resin composition contains the other polymer compound, the content of the other polymer compound is preferably 0.01% by mass or more and 30% by mass or less and more preferably 0.02% by mass or more and 20% by mass or less with respect to the total solid content mass of the resin composition.

<Characteristics of resin composition>

The viscosity of the resin composition according to the embodiment of the present invention can be adjusted by adjusting the concentration of solid contents of the resin composition. From the viewpoint of the coating film thickness, it is preferably 1,000 $mm^2/s$ to 12,000 $mm^2/s$, more preferably 2,000 $mm^2/s$ to 10,000 $mm^2/s$, and still more preferably 2,500 $mm^2/s$ to 8,000 $mm^2/s$. Within the above range, it is easy to obtain a coating film having high uniformity. In a case of being 1,000 $mm^2/s$ or more, it is easy to carry out coating at a film thickness to be required as, for example, an insulating film for redistribution of a wiring line, and in a case of being 12,000 $mm^2/s$ or less, a coating film having an excellent coating surface shape is obtained.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.
Examples of the method of maintaining the moisture content include adjusting the humidity under storage conditions and reducing the void ratio of the storage container during storage.
From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.
In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.
In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.
Preferred examples of the method of adjusting the content of halogen atoms include ion exchange treatment.
A storage container publicly known in the related art can be used as a storage container for the resin composition according to the embodiment of the present invention. As the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

<Cured substance of resin composition>

In a case of curing the resin composition according to the embodiment of the present invention, it is possible to obtain a cured substance of the resin composition.

The cured substance according to the embodiment of the present invention is a cured substance formed by curing the resin composition.

The curing of the resin composition is preferably carried out by heating. The heating temperature is more preferably 120°C to 400°C, still more preferably 140°C to 380°C, and particularly preferably 170°C to 350°C. The form of the cured substance of the resin composition is not particularly limited and can be selected depending on the use application, where the form includes a film shape, a rod shape, a spherical shape, a pellet shape, and the like. In the present invention, the cured substance preferably has a film shape. The shape of the cured substance can also be selected depending on the use application by the pattern processing of the resin composition, where the use application includes the formation of a protective film on a wall surface, formation of via holes for conduction, adjustment of impedance, electrostatic capacity, or internal stress, and impartment of heat radiation function. The film thickness of the cured substance (the film consisting of the cured substance) is preferably 0.5 μm or more and 150 μm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.

$$\text{Shrinkage ratio [\%]} = 100 - (\text{volume after curing/volume before curing}) \times 100$$

<Characteristics of cured substance of resin composition>

The imidization reaction rate of the cured substance of the resin composition according to the embodiment of the present invention is preferably 70% or more, more preferably 80% or more, and still more preferably 90% or more. In a case of being 70% or more, a cured substance having excellent mechanical properties may be obtained.

The breaking elongation of the cured substance of the resin composition according to the embodiment of the present invention is preferably 30% or more, more preferably 40% or more, and still more preferably 50% or more.

The glass transition temperature (Tg) of the cured substance of the resin composition according to the embodiment of the present invention is preferably 180°C or higher, more preferably 210°C or higher, and still more preferably 230°C or higher.

<Preparation of resin composition>

The resin composition according to the embodiment of the present invention can be prepared by mixing the above-described components. The mixing method is not particularly limited, and mixing can be carried out by methods publicly known in the related art.

Examples of the mixing method include mixing with a stirring blade, mixing with a ball mill, and mixing by rotating a tank.

The temperature during the mixing is preferably 10°C to 30°C, and more preferably 15°C to 25°C.

It is preferable to carry out filtration using a filter for the intended purpose of removing foreign substances such as dust and fine particles in the resin composition according to the embodiment of the present invention. The filter pore diameter is, for example, preferably 5 μm or less, more preferably 1 μm or less, still more preferably 0.5 μm or less, and even still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case of carrying out pressurization to carry out filtration, the pressure for pressurization is, for example, preferably 0.01 MPa or more and 1.0 MPa or less, more preferably 0.03 MPa or more and 0.9 MPa or less, still more preferably 0.05 MPa or more and 0.7 MPa or less, and even still more preferably 0.05 MPa or more and 0.5 MPa or less.

In addition to filtration using a filter, impurity removal treatment using an adsorbing material may be carried out.

The filtration using a filter and the impurity removal treatment using an adsorbing material may be combined. As the adsorbing material, a publicly known adsorbing material can be used. Examples thereof include an inorganic adsorbing material such as silica gel and zeolite and an organic adsorbing material such as activated carbon.

After filtration using a filter, a step of placing a bottle filled with the resin composition under reduced pressure to carry out degassing may be provided.

(Manufacturing method for cured substance)

The first aspect of the manufacturing method for a cured substance according to the embodiment of the present invention (hereinafter, also referred to as "manufacturing method for a first cured substance") preferably includes a film forming step of applying the resin composition onto a base material to form a film.

It is preferable that the manufacturing method for the first cured substance includes a drying step after the film forming step.

The manufacturing method for a first cured substance more preferably includes the above-described film forming step, an exposure step of selectively exposing the film (optionally, the film after the drying step) formed by the film forming step, and a development step of developing the film exposed by the exposure step with a developer to form a pattern.

It is more preferable that the manufacturing method for a first cured substance includes the film forming step, the exposure step, the development step, and at least one of a heating step of heating a pattern obtained by the development step or a post-development exposure step of exposing the pattern obtained by the development step.

In addition, it is also preferable that the manufacturing method for a first cured substance includes the above-described film forming step and a step of heating the film.

Hereinafter, details of each step will be described.

<Film forming step>

The resin composition according to the embodiment of the present invention can be applied onto a base material, thereby being used in a film forming step of forming a film.

The manufacturing method for a first cured substance according to the embodiment of the present invention preferably includes a film forming step of applying a resin composition onto a base material to form a film.

[Base material]

The kind of the base material can be appropriately determined depending on the use application and is not particularly limited. Examples of the base material include a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, or Fe, paper, spin-on-glass (SOG), a thin film transistor (TFT) array base material, a mold base material, and an electrode plate of a plasma display panel (PDP). In particular, the base material is preferably a base material for semiconductor production, and more preferably a silicon base material, a Cu base material, or a mold base material.

A layer such as an intimate attachment layer made of hexamethyl disilazane (HMDS) or the like, or an oxide layer may be provided on the surface of these base materials.

The shape of the base material is not particularly limited, and it may be a circular shape or may be a rectangular shape.

In a case where the base material has a circular shape, the size of the base material is, for example, preferably a diameter of 100 to 450 mm and more preferably 200 to 450 mm. In a case of a rectangular shape, the length of the short side is, for example, preferably 100 to 1,000 mm and more preferably 200 to 700 mm.

As the base material, for example, a base material having a plate shape and preferably a base material (a substrate) having a panel shape are used.

In a case where the resin composition is applied to form a film on a surface of a resin layer (for example, a layer consisting of a cured substance) or on a surface of a metal layer, the resin layer or the metal layer serves as the base material.

The means for applying the resin composition onto a base material is preferably coating.

Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, a spin coating method, a slit coating method, a spray coating method, or an ink jet method is more preferable, and from the viewpoint of the uniformity of the film thickness and the viewpoint of productivity, a spin coating

method or a slit coating method is more preferable. A film having a desired thickness can be obtained by adjusting the concentration of solid contents of the resin composition and application conditions according to the means to be applied. In addition, the coating method can be appropriately selected depending on the shape of the base material. In a case where a circular base material such as a wafer is used, a spin coating method, a spray coating method, an ink jet method, or the like is preferable, and in a case where a rectangular base material is used, a slit coating method, a spray coating method, an ink jet method, or the like is preferable. For example, the spin coating method can be applied at a rotation speed of 500 to 3,500 rpm for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used.

In addition, a step of removing an unnecessary film at the end part of the base material may be carried out. Examples of such a step include edge bead rinsing (EBR) and back rinsing.

A pre-wetting step of applying various solvents onto the base material before applying the resin composition onto the base material to improve the wettability of the base material and then applying the resin composition may be adopted.

<Drying step>

The above film may be subjected to a step (a drying step) of drying the film (or the layer) formed for removing the solvent, after the film forming step (the layer forming step).

That is, the manufacturing method for a first cured substance according to the embodiment of the present invention may include a drying step of drying the film formed by the film forming step.

It is preferable that the drying step is carried out after the film forming step and before the exposure step.

The drying temperature of the film in the drying step is preferably 50°C to 150°C, more preferably 70°C to 130°C, and still more preferably 90°C to 110°C. In addition, the drying may be carried out by reducing the pressure. Examples of the drying time include 30 seconds to 20 minutes, and the drying time is preferably 1 minute to 10 minutes and more preferably 2 minutes to 7 minutes.

In addition, it is preferable that the drying step satisfies any one of the following condition i or condition ii.

Condition i: a heating temperature in the drying step is 120°C or higher and lower than 150°C.

Condition ii: a heating temperature in the drying step is lower than 120°C and a heating time is 5 minutes or longer.

It is presumed that, by satisfying at least one of the condition i or ii, the solvent can be removed and progression of the curing during drying is suppressed, so that the reflow of the resin layer in the heating step is likely to occur, and a film having excellent flatness is obtained.

In a case where the drying step is performed under the condition i, the drying temperature is preferably 120°C to 140°C and more preferably 120°C to 130°C.

In a case where the drying step is performed under the condition i, the drying time is preferably 1 to 10 minutes and more preferably 2 to 5 minutes.

In a case where the drying step is performed under the condition i, the drying may be performed under atmospheric pressure or under reduced pressure.

The drying means in a case where the drying step is performed under the condition i is not particularly limited, and for example, a hot plate can be used.

In a case where the drying step is performed under the condition ii, the drying temperature is preferably 90°C to 115°C and more preferably 100°C to 115°C.

In a case where the drying step is performed under the condition ii, the drying time is preferably 5 to 15 minutes and more preferably 5 to 10 minutes.

In a case where the drying step is performed under the condition ii, the drying may be performed under atmospheric pressure or under reduced pressure.

The drying means in a case where the drying step is performed under the condition ii is not particularly limited, and for example, a hot plate can be used.

<Exposure step>

The film may be subjected to an exposure step of selectively exposing the film.

The manufacturing method for a first cured substance may include an exposure step of selectively exposing the film formed by the film forming step.

The selective exposure means that a part of the film is exposed. In addition, by selectively exposing the film, an exposed region (an exposed portion) and an unexposed region (a non-exposed portion) are formed in the film.

The exposure amount is not particularly limited as long as the resin composition according to the embodiment of

the present invention can be cured; however, it is, for example, preferably 50 to 10,000 mJ/cm$^2$ and more preferably 200 to 8,000 mJ/cm$^2$ in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. Regarding the resin composition according to the embodiment of the present invention, exposure with a high pressure mercury lamp is particularly preferable, and from the viewpoint of exposure sensitivity, exposure with an i-line is more preferable.

The exposure method is not particularly limited as long as at least a part of the film consisting of the resin composition according to the embodiment of the present invention is exposed; however, examples thereof include exposure using a photo mask and exposure by a laser direct imaging method.

<Post-exposure heating step>

The film may be subjected to a step of carrying out heating after the exposure (a post-exposure heating step).

That is, the manufacturing method for a first cured substance may include a post-exposure heating step of heating the film exposed in the exposure step.

The post-exposure heating step can be carried out after the exposure step and before the development step.

The heating temperature in the post-exposure heating step is preferably 50°C to 140°C and more preferably 60°C to 120°C.

The heating time in the post-exposure heating step is preferably 30 seconds to 300 minutes and more preferably 1 minute to 10 minutes.

In the post-exposure heating step, the temperature rising rate from the temperature at the start of heating to the maximum heating temperature is preferably 1 to 12 °C/min, more preferably 2 to 10 °C/min, and still more preferably 3 to 10 °C/min.

In addition, the temperature rising rate may be appropriately changed during heating.

The heating means in the post-exposure heating step is not particularly limited, and a publicly known hot plate, oven, infrared heater, or the like can be used.

In addition, it is also preferable to carry out the heating in an atmosphere having a low oxygen concentration by allowing an inert gas such as nitrogen, helium, argon, or the like to flow.

<Development step>

The exposed film may be subjected to a development step of carrying out development using a developer to form a pattern.

That is, the manufacturing method for a first cured substance may include a development step of developing the film exposed in the exposure step using a developer to form a pattern.

By carrying out the development, one of the exposed portion and the non-exposed portion of the film is removed, and a pattern is formed.

Here, the development in which the non-exposed portion of the film is removed by the development step is referred to as negative-tone development, and the development in which the exposed portion of the film is removed by the development step is referred to as positive-tone development.

[Developer]

Examples of the developer that is used in the development step include a developer containing an alkaline aqueous solution or an organic solvent.

In a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. The content of the basic compound in the developer is preferably 0.01% to 10% by mass, more preferably 0.1% to 5% by mass, and still more preferably 0.3% to 3% by mass in the total mass of the developer.

In a case where the developer contains an organic solvent, the compounds described in paragraph 0387 of WO2021/112189A can be used as the organic solvent. The content thereof is incorporated in the present specification. In addition, suitable examples of the alcohols include methanol, ethanol, propanol, isopropanol, butanol, pentanol, octanol, diethylene glycol, propylene glycol, methyl isobutyl carbinol, and triethylene glycol, and suitable examples of the amides include N-methylpyrrolidone, N-ethylpyrrolidone, and dimethylformamide.

In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is particularly preferable.

In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.

In a case where the developer contains an organic solvent, the developer may further contain at least one of a basic compound or a base generator. In a case where at least one of the basic compound or the base generator in the developer permeates into the pattern, the performance such as the breaking elongation of the pattern may be improved.

The basic compound is preferably an organic base from the viewpoint of the reliability in a case of being remained in the cured film (the adhesiveness to the base material in a case where the cured substance is further heated).

The basic compound is preferably a basic compound having an amino group and preferably a primary amine, a secondary amine, a tertiary amine, an ammonium salt, a tertiary amide, or the like. However, in order to accelerate the imidization reaction, it is preferably a primary amine, a secondary amine, a tertiary amine, or an ammonium salt, more preferably a secondary amine, a tertiary amine, or an ammonium salt, still more preferably a secondary amine or a tertiary amine, and particularly preferably a tertiary amine.

From the viewpoint of mechanical characteristics (the breaking elongation) of the cured substance, it is preferable that the basic compound hardly remains in the cured film (the obtained cured substance), and from the viewpoint of accelerating cyclization, it is preferable that the residual amount of the basic compound hardly decreases due to vaporization or the like before heating.

Therefore, the boiling point of the basic compound is preferably 30°C to 350°C, more preferably 80°C to 270°C, and still more preferably 100°C to 230°C at normal pressure (101,325 Pa).

The boiling point of the basic compound is preferably higher than the temperature obtained by subtracting 20°C from the boiling point of the organic solvent contained in the developer, and it is more preferably higher than the boiling point of the organic solvent contained in the developer.

For example, in a case where the boiling point of the organic solvent is 100°C, the basic compound to be used preferably has a boiling point of 80°C or higher and more preferably a boiling point of 100°C or higher.

The developer may contain only one kind of basic compound having an amide group or may contain two or more kinds thereof.

Specific examples of the basic compound include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, tetrabutylammonium hydroxide, ethylenediamine, butanediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl) amine, piperidine, methylpiperidine, dimethylpiperidine, piperazine, tropane, N-phenylbenzylamine, 1,2-dianilinoethane, 2-aminoethanol, toluidine, aminophenol, hexylaniline, phenylene diamine, phenylethylamine, dibenzylamine, pyrrole, N-methylpyrrole, N,N,N,N-tetramethylethylenediamine, and N,N,N,N-tetramethyl-1,3-propanediamine.

A preferred aspect of the base generator is the same as the preferred aspect of the base generator contained in the above-described composition. In particular, the base generator is preferably a thermal-base generator.

In a case where the developer contains at least one of a basic compound or a base generator, the content of the basic compound or the base generator is preferably 10% by mass or less, and more preferably 5% by mass or less with

respect to the total mass of the developer. The lower limit of the content is not particularly limited; however, it is, for example, preferably 0.1% by mass or more.

In a case where the basic compound or the base generator is a solid in an environment where the developer is used, the content of the basic compound or the base generator is also preferably 70% to 100% by mass with respect to the total solid content of the developer.

The developer may contain only one kind of the basic compound or base generator or may contain two or more kinds thereof. In a case where at least one of the basic compound or the base generator is two or more kinds, the total thereof is preferably within the above-described range.

The developer may further contain another component.

Examples of the other component include a publicly known surfactant and a publicly known anti-foaming agent.

[Method of supplying developer]

The method of supplying a developer is not particularly limited as long as a desired pattern can be formed, and it includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

Examples of the method of supplying a developer in the development step include a step of continuously supplying a developer to a base material, a step of keeping a developer in a substantially stationary state on a base material, a step of vibrating a developer on a base material by ultrasonic waves or the like, and a step obtained by combining these steps.

The development time is preferably 10 seconds to 10 minutes and more preferably 20 seconds to 5 minutes. The temperature of the developer during development is not particularly determined; however, it is preferably 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

Examples of the organic solvent in a case where the rinsing liquid contains an organic solvent include the same organic solvents as the organic solvents exemplified in the above-described case where the developer contains an organic solvent.

The organic solvent contained in the rinsing liquid is preferably an organic solvent different from the organic solvent contained in the developer, and it is more preferably an organic solvent having a solubility of the pattern, which is lower than that of the organic solvent contained in the developer.

In a case where the rinsing liquid contains an organic solvent, one kind of organic solvent can be used, or two or more kinds thereof can be mixedly used. The organic solvent is preferably cyclopentanone, γ-butyrolactone, dimethyl sulfoxide, N-methylpyrrolidone, cyclohexanone, PGMEA, or PGME, more preferably cyclopentanone, γ-butyrolactone, dimethyl sulfoxide, PGMEA, or PGME, and still more preferably cyclohexanone or PGMEA.

In a case where the rinsing liquid contains an organic solvent, the organic solvent is preferably 50% by mass or more, more preferably 70% by mass or more, and still more preferably 90% by mass or more with respect to the total mass of the rinsing liquid. **In** addition, the organic solvent may be 100% by mass with respect to the total mass of the rinsing liquid.

The rinsing liquid may contain at least one of a basic compound or a base generator.

Although not particularly limited, in a case where the developer contains an organic solvent, an aspect in which

the rinsing liquid contains at least one of an organic solvent, a basic compound, or a base generator is also one of the preferred aspects of the present invention.

Examples of the basic compound and the base generator which are contained in the rinsing liquid include the compounds exemplified as the basic compound and the base generator which may be contained in a case where the developer contains an organic solvent, and the same applies to the preferred aspects thereof.

The basic compound and the base generator, which are contained in the rinsing liquid, may be selected in consideration of the solubility in the solvent in the rinsing liquid.

In a case where the rinsing liquid contains at least one of a basic compound or a base generator, the content of the basic compound or the base generator is preferably 10% by mass or less, and more preferably 5% by mass or less with respect to the total mass of the rinsing liquid. The lower limit of the content is not particularly limited; however, it is, for example, preferably 0.1% by mass or more.

In a case where the basic compound or the base generator is a solid in an environment where the rinsing liquid is used, the content of the basic compound or the base generator is also preferably 70% to 100% by mass with respect to the total solid content of the rinsing liquid.

In a case where the rinsing liquid contains at least one of a basic compound or a base generator, the rinsing liquid may contain only one kind of the basic compound or base generator or may contain two or more kinds thereof. In a case where at least one of the basic compound or the base generator is two or more kinds, the total thereof is preferably within the above-described range.

The rinsing liquid may further contain another component.

Examples of the other component include a publicly known surfactant and a publicly known anti-foaming agent.

[Method of supplying rinsing liquid]

The method of supplying a rinsing liquid is not particularly limited as long as a desired pattern can be formed and includes a method of immersing a base material in a rinsing liquid, a method of supplying a rinsing liquid to a base material by liquid filling, a method of supplying a rinsing liquid to a base material with a shower, and a method of continuously supplying a rinsing liquid to a base material by means such as a straight nozzle.

From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a rinsing liquid to the exposed film, and it is more preferably a step of supplying a rinsing liquid with a spray nozzle.

In the method of supplying a rinsing liquid in the rinsing step, a step of continuously supplying a rinsing liquid to a base material, a step of keeping a rinsing liquid in a substantially stationary state on a base material, a step of vibrating a rinsing liquid on the base material by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly determined; however, it is preferably 10°C to 45°C and more preferably 18°C to 30°C.

The development step may include a step of bringing the treatment liquid into contact with the pattern after the treatment using the developer or after the pattern is washed with the rinsing liquid. In addition, such a method of supplying a treatment liquid before the developer or rinsing liquid which is in contact with the pattern is completely dried may be adopted.

Examples of the treatment liquid include a treatment liquid containing at least one of water or an organic solvent and at least one of a basic compound or a base generator.

Preferred aspects of the organic solvent and at least one of the basic compound or the base generator are the same as the preferred aspects of the organic solvent and at least one of the basic compound or the base generator, which are used in the above-described rinsing liquid.

As a method of supplying the treatment liquid to the pattern, the same method as the above-described method of supplying the rinsing liquid can be used, and the same applies to the preferred aspect thereof.

The content of the basic compound or the base generator in the treatment liquid is preferably 10% by mass or less and more preferably 5% by mass or less with respect to the total mass of the treatment liquid. The lower limit of the content is not particularly limited; however, it is, for example, preferably 0.1% by mass or more.

In addition, In a case where the basic compound or the base generator is a solid in an environment where the treatment liquid is used, the content of the basic compound or the base generator is also preferably 70% to 100% by mass

with respect to the total solid content of the treatment liquid.

In a case where the treatment liquid contains at least one of a basic compound or a base generator, the treatment liquid may contain only one kind of the basic compound or the base generator, or may contain two or more kinds thereof. In a case where at least one of the basic compound or the base generator is two or more kinds, the total thereof is preferably within the above-described range.

<Heating step>

The pattern obtained by the development step (a pattern after the rinsing in a case where the rinsing step is carried out) may be subjected to a heating step of heating the pattern obtained by the development.

That is, the manufacturing method for a first cured substance may include a heating step of heating the pattern obtained by the development step.

In addition, the manufacturing method for a first cured substance may include a pattern obtained by another method without carrying out the development step, or a heating step of heating a film obtained by the film forming step.

In the heating step, the resin such as the polyimide precursor is cyclized to be a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.

The heating step is preferably a step of accelerating the cyclization reaction of the polyimide precursor in the pattern under the action of the base or the like generated from the base generator by heating.

The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.

In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition.

The heating time (the heating time at the maximum heating temperature) is preferably 5 to 360 minutes, more preferably 10 to 300 minutes, and still more preferably 15 to 240 minutes.

In particular, in a case of forming a multilayered laminate, the heating temperature is preferably 30°C or higher, more preferably 80°C or higher, still more preferably 100°C or higher, and particularly preferably 120°C or higher, from the viewpoint of adhesiveness between layers.

The upper limit of the heating temperature is preferably 350°C or lower, more preferably 250°C or lower, and still more preferably 240°C or lower.

The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment step may be carried out as a step of two or more stages, for example, a first stage pretreatment step may be carried out in a range of 100°C to 150°C, and then a second stage pretreatment step may be carried out in a range of 150°C to 200°C.

Further, cooling may be carried out after heating, and the cooling rate, in this case, is preferably 1 to 5 °C/min.

From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.

The heating means in the heating step is not particularly limited; however, examples thereof include a hot plate, an infrared furnace, an electric heating oven, a hot air oven, and an infrared oven.

In addition, it is preferable that the heating step satisfies any one of the following condition iii to the following condition v.

Condition iii: a heating temperature in the heating step is 240°C or higher.

Condition iv: a heating temperature in the heating step is 150°C or higher and lower than 240°C, and the heating time is 3 hours or longer.

Condition v: the heating step includes at least a first heating step and a second heating step performed after the first heating step, in which a heating temperature in the first heating step is 150°C or higher and lower than 200°C and a heating temperature in the second heating step is 200°C or higher.

It is presumed that, according to the heating related to the condition iii to the condition v, the resin is likely to be reflowed, and a cured substance having excellent flatness is likely to be obtained.

In a case where the heating step is carried out under the condition iii, the heating temperature (maximum heating temperature) is preferably 240°C to 380°C and more preferably 240°C to 350°C.

In a case where the heating step is performed under the condition iii, the heating time (the heating time at the above-described heating temperature) is not particularly limited, but is preferably 5 to 240 minutes, more preferably 10 to 180 minutes, and still more preferably 15 to 120 minutes.

In addition, the temperature rising rate, the temperature at the start of heating, the fact that the heating may be performed in a stepwise manner, and the preferred aspect in a case where the heating is performed in a stepwise manner, the fact that the cooling may be performed after the heating, the preferred aspect of the cooling, and the preferred aspect of the heating means are as described above.

In a case where the heating step is carried out under the condition iv, the heating temperature (maximum heating temperature) is preferably 160°C to 230°C and more preferably 170°C to 220°C.

In a case where the heating step is performed under the condition iv, the heating time (the heating time at the above-described heating temperature) is not particularly limited, but is preferably 3 to 10 hours, more preferably 3 to 8 hours, and still more preferably 3 to 6 hours.

In addition, the temperature rising rate, the temperature at the start of heating, the fact that the heating may be performed in a stepwise manner, and the preferred aspect in a case where the heating is performed in a stepwise manner, the fact that the cooling may be performed after the heating, the preferred aspect of the cooling, and the preferred aspect of the heating means are as described above.

In a case where the heating step is performed under the condition v, the heating temperature in the first heating step (the maximum heating temperature in the first heating step) is preferably 150°C to 195°C and more preferably 160°C to 190°C.

In a case where the heating step is performed under the condition v, the heating time (the heating time at the above-described heating temperature) in the first heating step are not particularly limited, but are preferably 1 to 10 hours, more preferably 1 to 8 hours, and still more preferably 2 to 6 hours.

In addition, the temperature rising rate in the heating in the first heating step, the temperature at the start of heating, the fact that the heating may be carried out stepwise, and the preferred aspect in a case of carrying out the heating stepwise, as well as the preferred aspect of the heating means are as described above.

In a case where the heating step is performed under the condition v, the heating temperature in the second heating step (the maximum heating temperature in the second heating step) is preferably 200°C to 350°C, more preferably 210°C to 300°C, and still more preferably 220 to 250.

It is preferable that the maximum heating temperature in the second heating step is the maximum heating temperature in the heating step.

In a case where the heating step is performed under the condition v, the heating time (the heating time at the above-described heating temperature) in the second heating step is not particularly limited, but is preferably 5 to 180 minutes, more preferably 15 to 150 minutes, and still more preferably 30 to 120 minutes.

In addition, the temperature rising rate in the second heating step, the temperature at the start of heating, the fact that the heating may be performed in a stepwise manner, and the preferred aspect in a case where the heating is performed in a stepwise manner, the fact that the cooling may be performed after the heating, the preferred aspect of the cooling, and the preferred aspect of the heating means are as described above.

In addition, the cooling may be performed once after the first heating step and before the second heating step, but an aspect in which the cooling is not performed is also one of the preferred aspects of the present invention.

That is, in the condition v, it is also one of the preferred aspects of the present invention that the heating step is performed by raising the temperature as it is after heating at the maximum heating temperature in the first heating step, reaching the maximum heating temperature in the second heating step, and performing heating for a predetermined time.

A preferred aspect of the temperature rising rate in the temperature rising is the same as the preferred aspect of the temperature rising rate in the above-described heating step.

In addition, in the condition v, another heating step may be further included before the first heating step, between the first heating step and the second heating step, and after the second heating step. However, it is preferable that the

maximum heating temperature in the heating step is the maximum heating temperature in the second heating step.

That is, it is preferable that the heating temperature in the other heating step does not exceed the maximum heating temperature in the second heating step.

<Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.

That is, the manufacturing method for a first cured substance according to the embodiment of the present invention may include a post-development exposure step of exposing the pattern obtained by the development step. The manufacturing method for a first cured substance according to the embodiment of the present invention may include the heating step and the post-development exposure step or may include only one of the heating step and the post-development exposure step.

In the post-development exposure step, it is possible to accelerate, for example, a reaction in which the cyclization of a polyimide precursor or the like proceeds by photosensitization of a photobase generator.

In the post-development exposure step, it is sufficient that at least a part of the pattern obtained in the development step is exposed; however, it is preferable that the whole of the above pattern is exposed.

The exposure amount in the post-development exposure step is preferably 50 to 20,000 $mJ/cm^2$ and more preferably 100 to 15,000 $mJ/cm^2$ in terms of conversion of exposure energy at the wavelength at which the photosensitive compound has a sensitivity.

The post-development exposure step can be carried out using, for example, the light source in the above-described exposure step, and it is preferable to use broadband light.

<Metal layer forming step>

The pattern (preferably a pattern that has been subjected to at least one of the heating step or the post-development exposure step) obtained by the development step may be subjected to a metal layer forming step of forming a metal layer on the pattern.

That is, it is preferable that the manufacturing method for a first cured substance according to the embodiment of the present invention includes a metal layer forming step of forming a metal layer on the pattern (preferably a pattern that has been subjected to at least one of the heating step or the post-development exposure step) obtained by the development step.

For the metal layer, existing metal kinds can be used without particular limitations. Examples thereof include copper, aluminum, nickel, vanadium, titanium, chromium, cobalt, gold, tungsten, tin, silver, and an alloy including these metals, where copper or aluminum is more preferable, and copper is still more preferable.

The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method (PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning method combining photolithography and electrolytic plating. Examples of the preferred aspect of the plating include electrolytic plating using a copper sulfate plating liquid or a copper cyanide plating liquid.

The thickness of the metal layer at the thickest portion is preferably 0.01 to 50 $\mu m$ and more preferably 1 to 10 $\mu m$.

<Use application>

Examples of the field to which the manufacturing method for a first cured substance according to the embodiment of the present invention or the cured substance according to the embodiment of the present invention can be applied include an insulating film of an electronic device, an interlayer insulating film for a re-distribution layer, and a stress buffer film. In addition, a sealing film, a substrate material (a base film or cover lay of a flexible print substrate, an interlayer insulating film), or such an insulating film in a use application for mounting as described above, which is patterned by etching, is mentioned. For these use applications, for example, Science & Technology Co., Ltd., "High functionality and applied technology of polyimide" April 2008, Technical library CMC TL "Basics and development of polyimide materials" supervised by Masaaki Kakimoto, published in November 2011, "Latest Polyimide Basics and Applications" edited by Japan Polyimide & Aromatic Polymers Study Group, NTS Inc., August 2010, or the like can be referred to.

The manufacturing method for a first cured substance according to the embodiment of the present invention and

the cured substance according to the embodiment of the present invention can also be used for the production of board surfaces such as an offset board surface or a screen board surface, for etching of molded parts, for the production of protective lacquers and dielectric layers in electronics, in particular, microelectronics.

A second aspect of the manufacturing method for a cured substance according to the embodiment of the present invention (hereinafter, also referred to as a "manufacturing method for a second cured substance") is a manufacturing method for a cured substance, including a drying step of heating and drying a resin composition containing at least one resin selected from the group consisting of a polyimide and a precursor thereof, in which a dielectric loss tangent of the resin is less than 0.25, thereby forming a film, and a heating step of heating the film, in which any one of the following condition i to condition v is satisfied.

Condition i: a heating temperature in the drying step is 120°C or higher and lower than 150°C.

Condition ii: a heating temperature in the drying step is lower than 120°C and a heating time is 5 minutes or longer.

Condition iii: a heating temperature in the heating step is 240°C or higher.

Condition iv: a heating temperature in the heating step is 150°C or higher and lower than 240°C, and the heating time is 3 hours or longer.

Condition v: the heating step includes at least a first heating step and a second heating step performed after the first heating step, in which a heating temperature in the first heating step is 150°C or higher and lower than 200°C and a heating temperature in the second heating step is 200°C or higher.

The manufacturing method for the second cured substance is the same as the above-described manufacturing method for the first cured substance, except that the manufacturing method for the second resin composition is limited to a configuration in which the second resin composition is used and any one of the above-described condition i to condition v is satisfied, and the preferred aspect thereof is also the same.

A third aspect of the manufacturing method for a cured substance according to the embodiment of the present invention (hereinafter, also referred to as a "manufacturing method for a third cured substance") is a manufacturing method for a cured substance, including a drying step of heating and drying a curable composition containing at least one resin selected from the group consisting of a polyimide and a precursor thereof, thereby forming a film, and a heating step of heating the film, in which a dielectric loss tangent of the obtained cured substance is less than 0.03, and any one of the following condition i to condition v is satisfied.

Condition i: a heating temperature in the drying step is 120°C or higher and lower than 150°C.

Condition ii: a heating temperature in the drying step is lower than 120°C and a heating time is 5 minutes or longer.

Condition iii: a heating temperature in the heating step is 240°C or higher.

Condition iv: a heating temperature in the heating step is 150°C or higher and lower than 240°C, and the heating time is 3 hours or longer.

Condition v: the heating step includes at least a first heating step and a second heating step performed after the first heating step, in which a heating temperature in the first heating step is 150°C or higher and lower than 200°C and a heating temperature in the second heating step is 200°C or higher.

The manufacturing method for the third cured substance is the same as the above-described manufacturing method for the first cured substance, except that the manufacturing method for the second resin composition is limited to a configuration in which the dielectric loss tangent of the obtained cured substance is less than 0.03 and any one of the above-described condition i to condition v is satisfied, and the preferred aspect thereof is also the same.

It is preferable that an exposure step of selectively exposing the film and a development step of developing the film using a developer to form a pattern, between the drying step and the heating step are included.

The preferred aspects of the exposure step and the development step are the same as those of the above-described manufacturing method for the first cured substance.

(Laminate and manufacturing method for laminate)

A laminate according to the embodiment of the present invention refers to a structure body having a plurality of layers consisting of the cured substance according to the embodiment of the present invention.

The laminate is a laminate including two or more layers consisting of a cured substance, and it may be a laminate in which three or more layers are laminated.

At least one of the two or more layers consisting of a cured substance, which are included in the laminate, is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a cured substance

according to the embodiment of the present invention.

In the laminate according to the embodiment of the present invention, an aspect in which two or more layers of layers consisting of a cured substance are included and a metal layer is provided between any of the layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wiring line of the re-distribution layer or the like.

<Laminating step>

The manufacturing method for a laminate according to the embodiment of the present invention preferably further includes a laminating step.

The laminating step is a series of steps including carrying out again, in the following order on the surface of the pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. **In** addition, (e) the metal layer forming step may be included after at least one of the heating step or the post-development exposure step of (d). It is needless to say that the laminating step may further include appropriately the above-described drying step.

**In** a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin layers of 2 or more layers and 9 or less layers is still more preferable.

In the above layers, the compositions, shapes, film thicknesses, and the like may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in this order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

(Surface activation treatment step)

The manufacturing method for a laminate according to the embodiment of the present invention preferably includes a surface activation treatment step of subjecting at least a part of the metal layer or a part of the resin composition layer to a surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

It is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative-tone development is carried out, it is less likely to be damaged by the surface treatment, and thus the adhesiveness is likely to be improved.

The surface activation treatment can be carried out, for example, according to the method described in paragraph 0415 of WO2021/112189A. The content thereof is incorporated in the present specification.

(Semiconductor device and manufacturing method therefor)

The present invention also discloses a semiconductor device, which includes the cured substance according to the embodiment of the present invention or the laminate.

In addition, the present invention also discloses a manufacturing method for a semiconductor device, which includes the manufacturing method for a cured substance according to the embodiment of the present invention or the manufacturing method for a laminate according to the embodiment of the present invention.

As the specific examples of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

## Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

<Synthesis of resin>

[Synthesis of polyimides A-1 to A-19]

A-2, A-3, and A-12 to A-15 were synthesized by the same method as the method described in Example A-1 described later, except that the raw materials were appropriately changed. In addition, polyimides A-4 to A-9 and A-16 to A-19 were synthesized by the same method as the method described in Example A-10 described later. Each of the polyimides A-1 to A-19 is a resin having a repeating unit represented by Formulae (A-1) to (A-19). The structure of each repeating unit was determined from a $^1$H-NMR spectrum. The subscript of the parentheses of the repeating unit represents the molar content of each repeating unit. The weight-average molecular weight (Mw) of each resin is shown in the table below. For those in which a plurality of weight-average molecular weights are described in the table, such as A-6, the amount of the raw material used was appropriately changed to obtain each weight-average molecular weight.

[Synthesis of polyimide A-1]

In a flask equipped with a stirrer and a condenser, 20.8 g (40.0 mmol) of 4,4'-(4,4'-isopropylidenediphenoxy) diphtalic acid anhydride was dissolved in 100 g of N-methylpyrrolidone at a temperature in a range of 20°C to 30°C. Subsequently, 15.3 g (37.2 mmol) of 4,4'-isopropylidenebis[(4-aminophenoxy)benzene] was added thereto, and the mixture was stirred for 1 hour. Subsequently, the temperature was raised to 190°C while flowing nitrogen, the mixture was stirred for 5 hours, and the mixture was cooled to 30°C or lower. Subsequently, the mixture was diluted with 50 g of tetrahydrofuran, precipitated in 2 L of methanol, filtered, and the residue was recovered and vacuum-dried at 45°C for 1 day to obtain a polyimide resin (A-1).

[Synthesis of polyimide A-10]

20.80 g (40 mmol) of 4,4'-(4,4'-isopropylidenediphenoxy)diphtalic acid anhydride was dissolved in 70 g of N-methylpyrrolidone (NMP). Subsequently, 9.08 g (35.2 mmol) of 4,4'-isopropylidenebis(2-aminophenol) was dissolved in 50 g of NMP, and the solution was added dropwise over 1 hour at a temperature of 10°C to 25°C and stirred at 25°C for 30 minutes. Then, 10 g of toluene was added thereto, the mixture was reacted at 200°C for 4 hours while nitrogen was flowing, and the mixture was cooled to 25°C. Subsequently, 15.3 g (100 mmol) of 4-(chloromethyl)styrene, 16.6 g (120 mmol) of potassium carbonate, 1.66 g (12 mmol) of potassium iodide, and 0.08 g of 2,2,6,6-tetramethylpiperidine 1-oxide free radical were added thereto, the mixture was reacted at 95°C for 15 hours, cooled to 25°C, and diluted with 120 g of tetrahydrofuran. Subsequently, the reaction solution was added dropwise to a mixed solution of 1.8 L of methanol and 0.6 L of water, and the mixture was stirred for 15 minutes and a polyimide resin was filtered. Next, the resin was subjected to reslurrying with 1 L of water, filtered, reslurried again with 1 L of methanol, filtered, and dried at 40°C for 8 hours under reduced pressure. Subsequently, the resin dried as described above was dissolved in 250 g of tetrahydrofuran, 40 g of an ion exchange resin (MB-1: manufactured by ORGANO CORPORATION) was added thereto, the mixture was stirred for 4 hours, the ion exchange resin was filtered and removed, and then the polyimide resin was precipitated in 2 L of methanol and stirred for 15 minutes. The polyimide precursor resin was filtered and acquired, and dried at 45°C for 1 day under reduced pressure to obtain a polyimide resin (A-10).

[Synthesis of polyimide precursor A-11]

21.2 g of 4,4'-oxydiphthalic acid anhydride, 18.0 g of 2-hydroxyethyl methacrylate, 23.9 g of pyridine, and 100 mL of diglyme (diethylene glycol dimethyl ether) were mixed and stirred at a temperature of 60°C for 4 hours to synthesize a diester of 4,4'-oxydiphthalic acid and 2-hydroxyethyl methacrylate. Next, the reaction mixture was cooled to -10°C, and 17.0 g of thionyl chloride was added thereto over 60 minutes while maintaining the temperature at -10°C ± 5°C. After dilution with 50 mL of N-methylpyrrolidone, a solution obtained by dissolving 8.89 g of 4,4'-diaminodiphenyl ether in 100 mL of N-methylpyrrolidone was added dropwise to the reaction mixture over 60 minutes at -10 ± 5°C, and the resultant mixture was stirred at room temperature for 2 hours. Then, 10.0 g of ethanol was added thereto, and the resultant mixture was stirred at room temperature for 1 hour.

Next, 6,000 g of water was added to precipitate the polyimide precursor, and the precipitate (a water-polyimide precursor mixture) was stirred for 15 minutes. The precipitate (the solid of the polyimide precursor) after stirring was collected by filtration and dissolved in 500 g of tetrahydrofuran. 6,000 g of water (poor solvent) was added to the obtained solution to precipitate the polyimide precursor, and the precipitate (a water-polyimide precursor mixture) was stirred for 15 minutes. The precipitate (the solid of the polyimide precursor) after stirring was filtered again and dried at 45°C for 3 days under reduced pressure.

After dissolving 46.6 g of the powder after drying in 419.6 g of tetrahydrofuran, 2.3 g of triethylamine was added thereto, and the resultant mixture was stirred at room temperature for 35 minutes. Then, 3,000 g of ethanol was added thereto, and the precipitate was collected by filtration. The obtained precipitate was dissolved in 281.8 g of tetrahydrofuran. 17.1 g of water and 46.6 g of an ion exchange resin UP6040 (manufactured by AmberTec) were added thereto, and the resultant mixture was stirred for 4 hours. Thereafter, the ion exchange resin was removed by filtration, and the obtained polymer solution was added to 5,600 g of water to obtain a precipitate. The precipitate was collected by filtration and dried at 45°C under reduced pressure for 24 hours to obtain 40.3 g of a polyimide precursor (A-11).

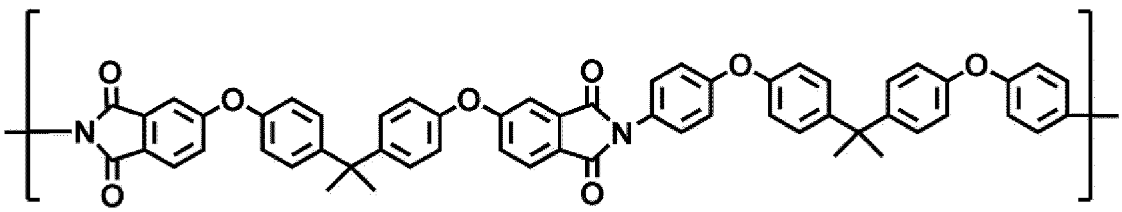

(A-1)

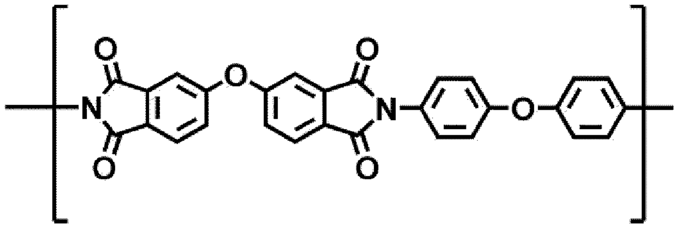

(A-2)

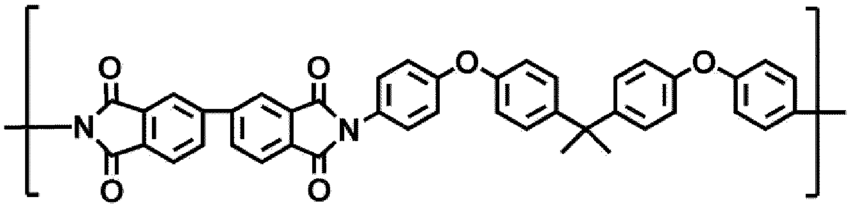

(A-3)

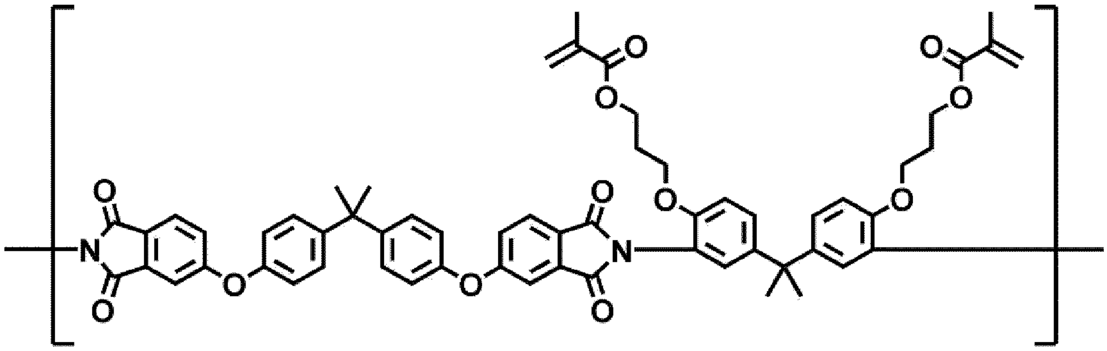

(A-4)

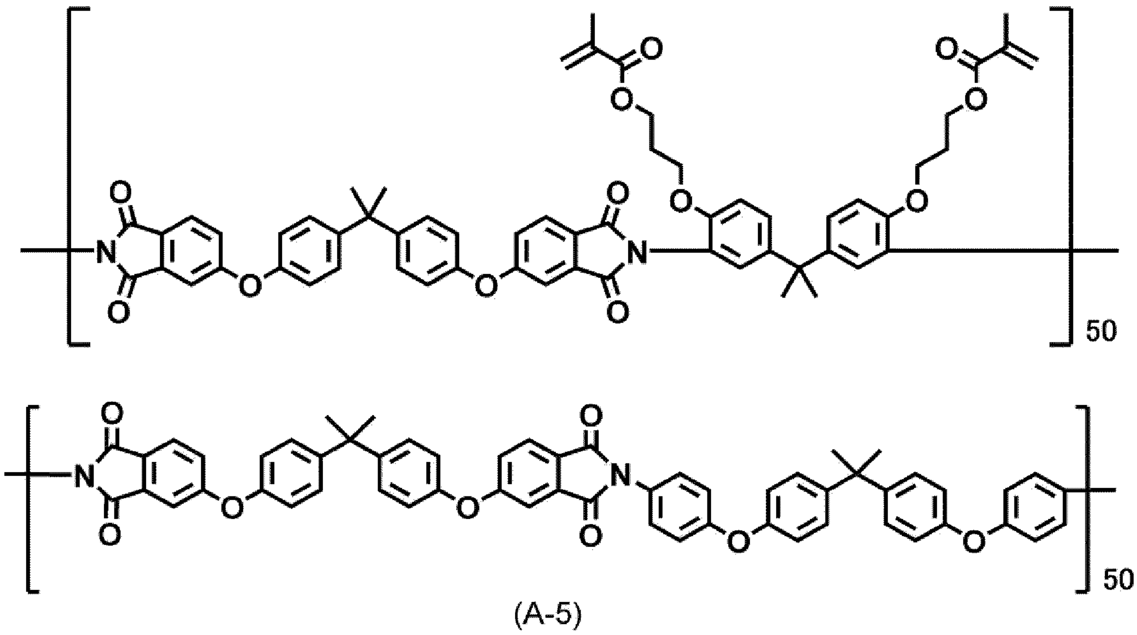

(A-5)

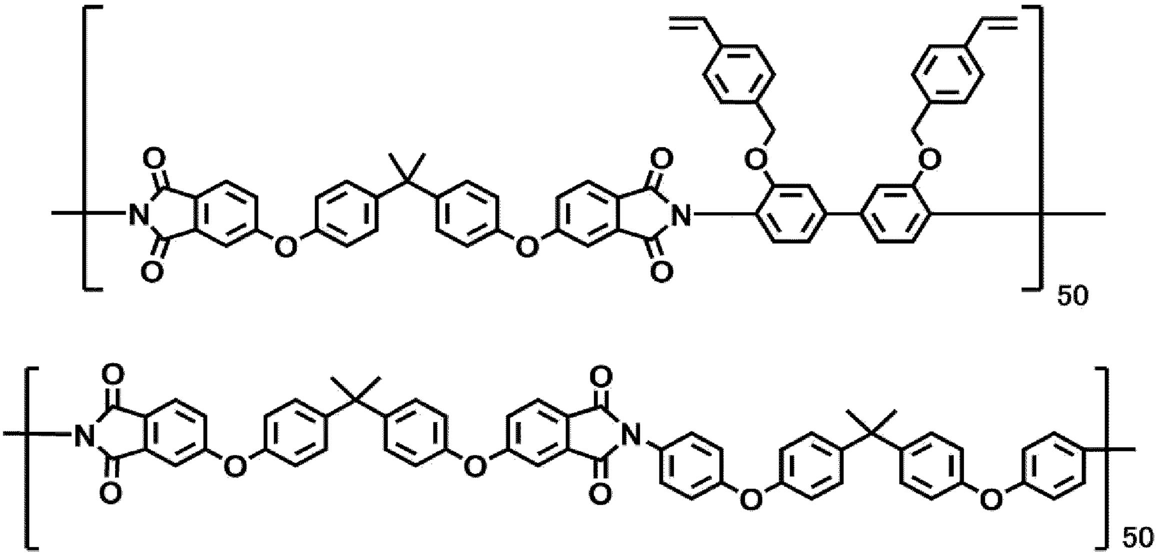

(A-6)

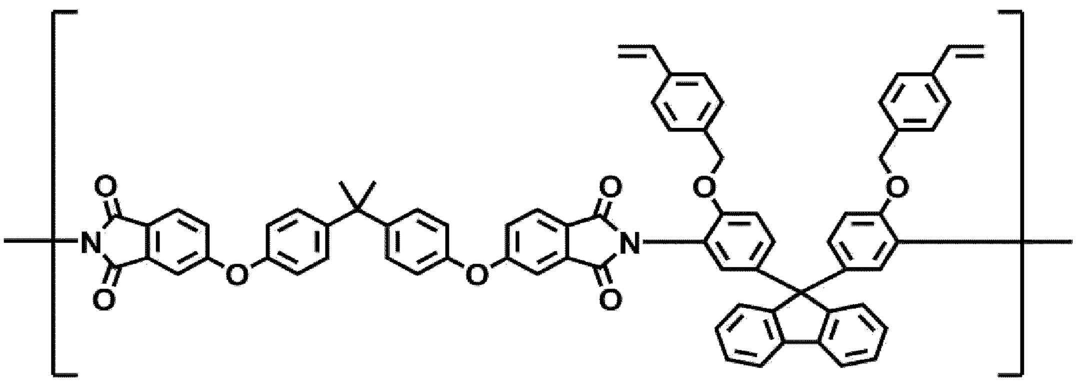

(A-7)

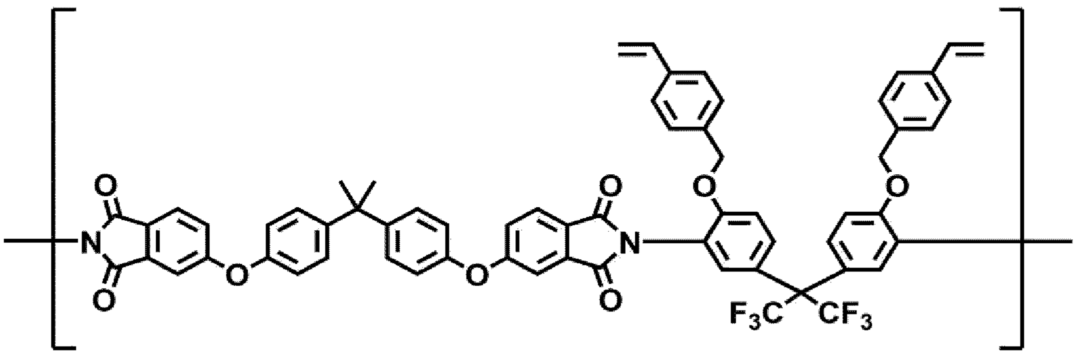

(A-8)

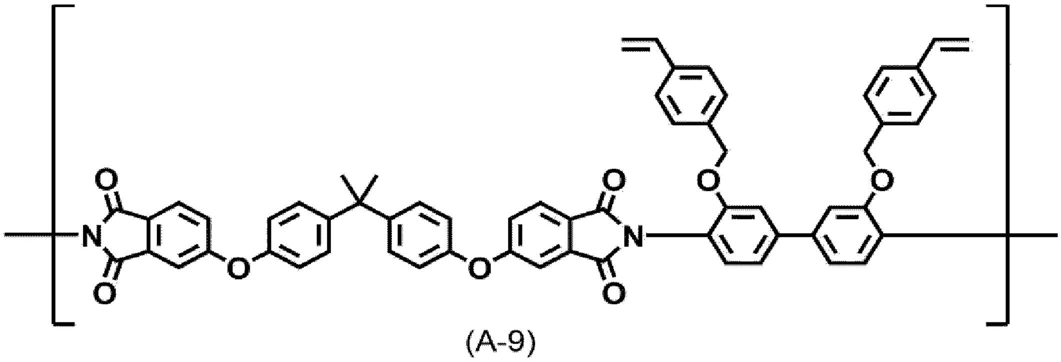

(A-9)

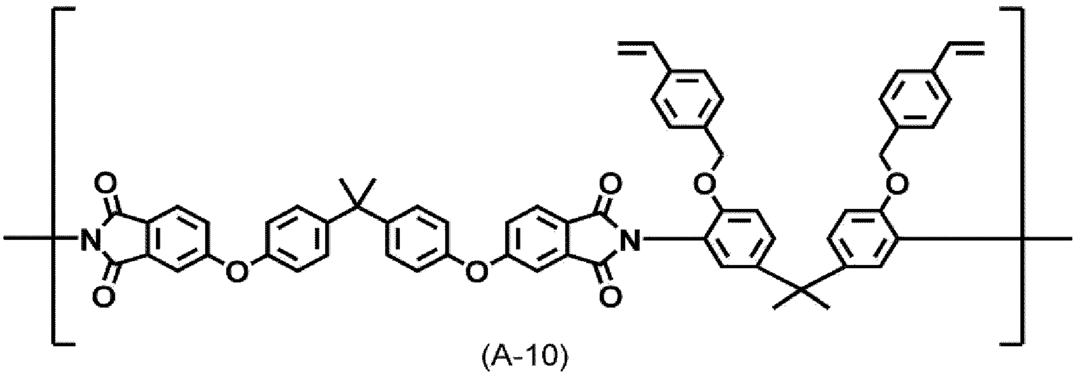

(A-10)

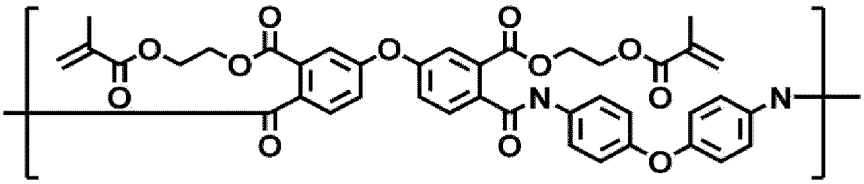

(A-11)

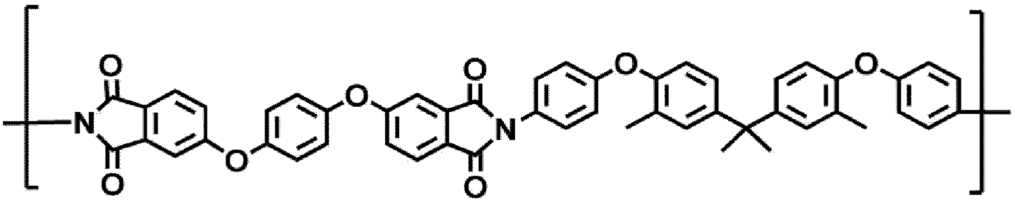

(A-12)

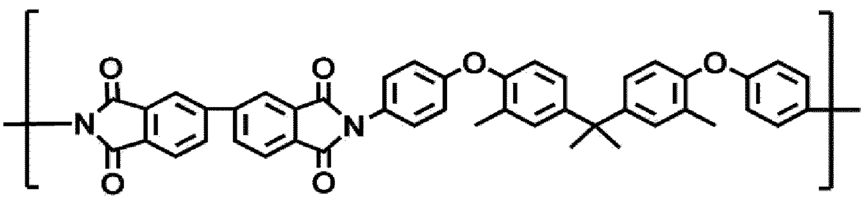

(A-13)

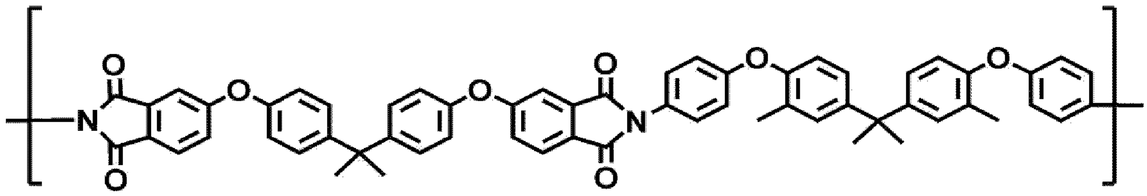

(A-14)

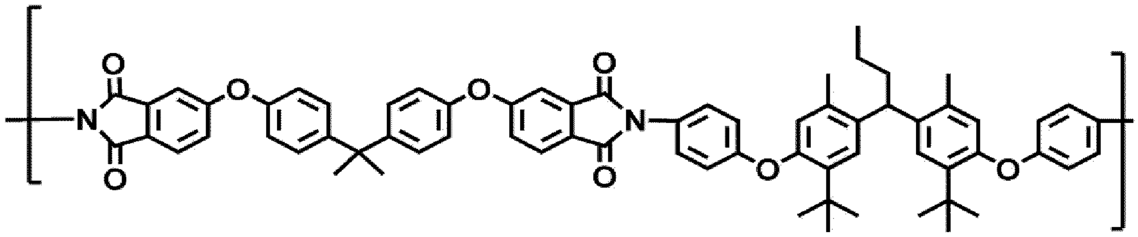

(A-15)

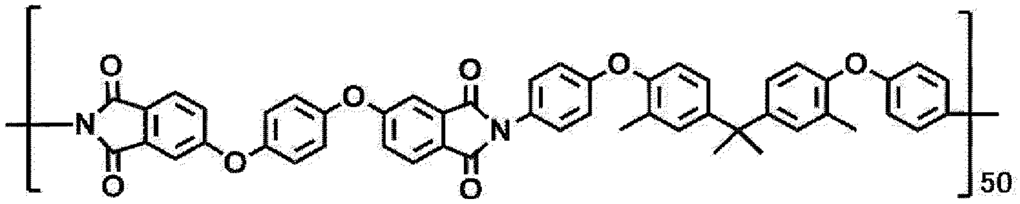

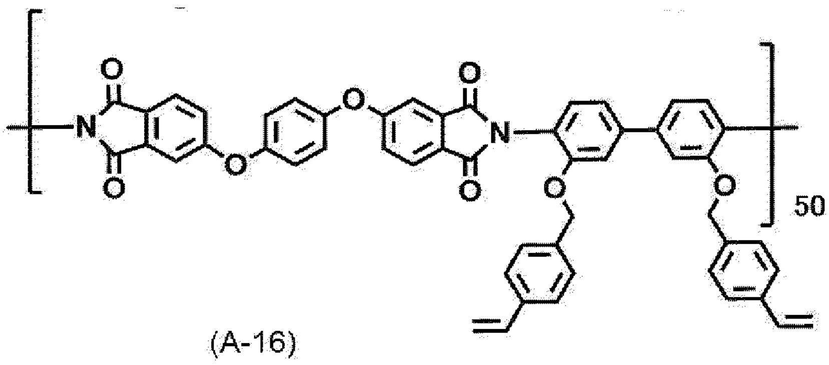

(A-16)

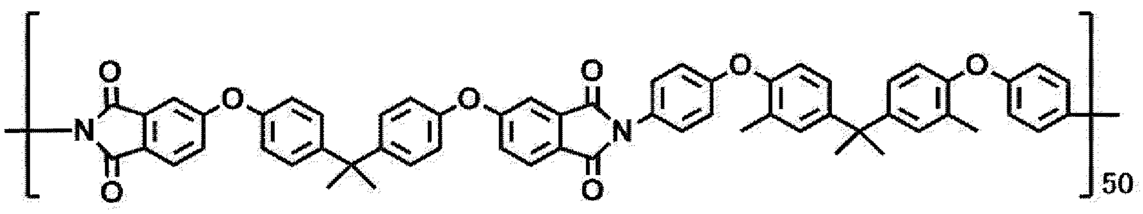

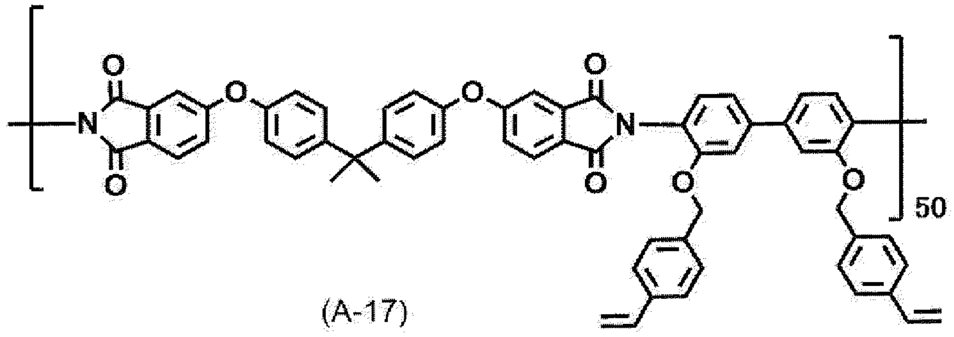

(A-17)

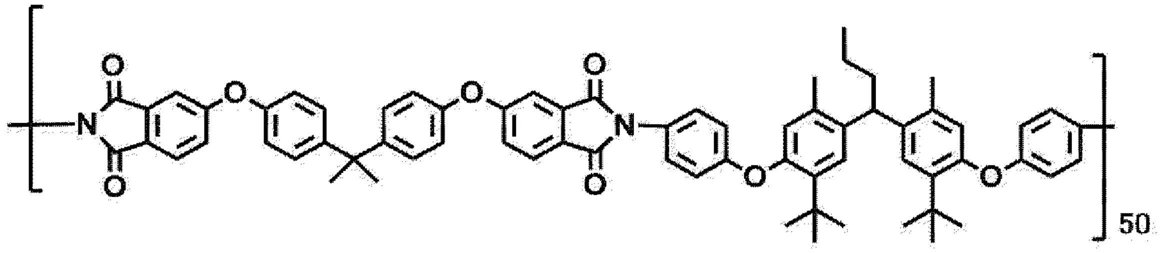

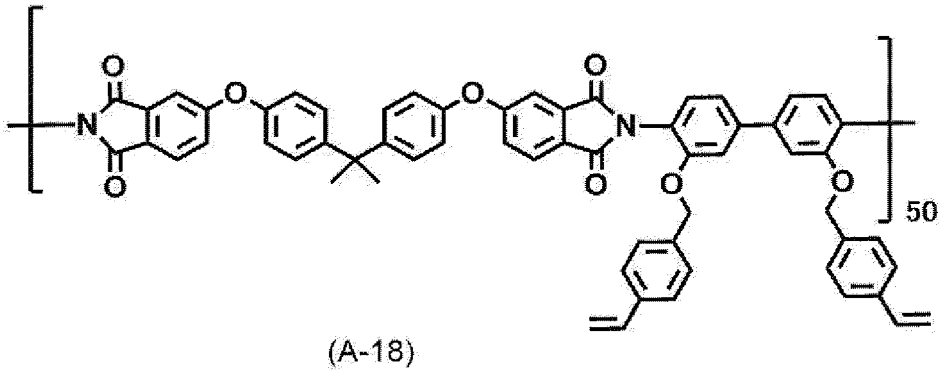

(A-18)

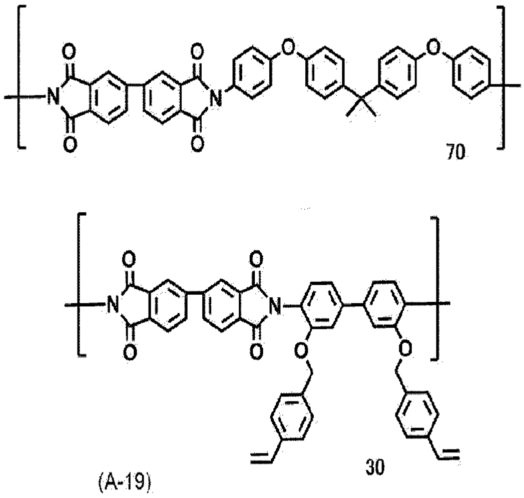

(A-19)

<Preparation of composition>

In each of Examples, the components shown in the table below were mixed to obtain each of the resin compositions. Further, in each Comparative Example, components shown in the following table were mixed to obtain each of the comparative compositions.

Specifically, the content of each component described in the table was set to the amount (in terms of parts by

mass) described in the column of "Adding amount" of each column of the table.

The obtained resin composition and the comparative composition were filtered under pressure using a filter made of ultra-high-molecular-weight polyethylene (UPE), having a micropore width of 0.2 μm.

In addition, in the table, the description of "-" indicates that the corresponding component is not contained in the composition.

[Table 1]

| | | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerization initiator | | Surfactant | | Solvent | | | |
|---|---|---|---|---|---|---|---|---|---|---|---|---|---|---|---|---|---|---|---|---|---|---|---|---|---|---|---|---|---|
| | | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| Example | 1 | A-1 | A | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 2 | A-2 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 3 | A-3 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 4 | A-4 | C | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 5 | A-5 | C | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 6 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 7 | A-7 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 8 | A-8 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 9 | A-9 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 10 | A-10 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 11 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 12 | A-6 | B | 15000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 13 | A-6 | B | 10000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 14 | A-16 | B | 10000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 15 | A-17 | B | 10000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 16 | A-18 | B | 10000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 17 | A-19 | B | 10000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 18 | A-6 | B | 19000 | 30.00 | B-2 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 19 | A-6 | B | 19000 | 30.00 | B-3 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 20 | A-6 | B | 19000 | 30.00 | B-4 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 21 | A-6 | B | 19000 | 30.00 | B-5 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 22 | A-6 | B | 19000 | 30.00 | B-6 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 23 | A-6 | B | 19000 | 30.00 | B-7 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 24 | A-6 | B | 19000 | 30.00 | B-8 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 25 | A-6 | B | 19000 | 30.00 | B-9 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 26 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-1 | 0.01 | L-1 | 56.51 | - | - |
| | 27 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-2 | 0.01 | L-1 | 56.51 | - | - |
| | 28 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-3 | 0.01 | L-1 | 56.51 | - | - |
| | 29 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-4 | 0.01 | L-1 | 56.51 | - | - |
| | 30 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-5 | 0.01 | L-1 | 56.51 | - | - |
| | 31 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-6 | 0.01 | L-1 | 56.51 | - | - |
| | 32 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-7 | 0.01 | L-1 | 56.51 | - | - |
| | 33 | A-6 | B | 19000 | 30.00 | B-1 | 10.73 | C-1 | 1.88 | - | - | E-1 | 0.12 | F-1 | 0.71 | G-1 | 0.05 | - | - | - | - | - | - | K-8 | 0.01 | L-1 | 56.51 | - | - |
| | 34 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 45.21 | L-17 | 11.30 |
| | 35 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-2 | 45.21 | L-3 | 11.30 |
| | 36 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-4 | 45.21 | L-3 | 11.30 |

[Table 2]

| | | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerization initiator | | Surfactant | | Solvent | | | |
|---|---|---|---|---|---|---|---|---|---|---|---|---|---|---|---|---|---|---|---|---|---|---|---|---|---|---|---|---|---|
| | | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| Example | 37 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-2 | 56.51 | - | - |
| | 38 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-4 | 56.51 | - | - |
| | 39 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-6 | 56.51 | - | - |
| | 40 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-7 | 56.51 | - | - |
| | 41 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-8 | 56.51 | - | - |
| | 42 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-9 | 56.51 | - | - |
| | 43 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 56.51 | - | - |
| | 44 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-11 | 56.51 | - | - |
| | 45 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-12 | 56.51 | - | - |
| | 46 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-13 | 56.51 | - | - |
| | 47 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-14 | 56.51 | - | - |
| | 48 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-15 | 56.51 | - | - |
| | 49 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-1 | 11.30 |
| | 50 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-2 | 11.30 |
| | 51 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-4 | 11.30 |
| | 52 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-6 | 11.30 |
| | 53 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 28.26 | L-6 | 28.26 |
| | 54 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-16 | 28.26 | L-6 | 28.26 |
| | 55 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-7 | 11.30 |
| | 56 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-8 | 11.30 |
| | 57 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 45.21 | L-9 | 11.30 |
| | 58 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-14 | 45.21 | L-6 | 11.30 |
| | 59 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 39.56 | L-5 | 16.95 |
| | 60 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-10 | 50.86 | L-5 | 5.65 |
| | 61 | A-6 | B | 10000 | 30.00 | B-7 | 10.73 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 62 | A-11 | C | 8000 | 30.00 | B-1 | 10.73 | C-1 | 1.88 | - | - | E-1 | 0.12 | F-1 | 0.71 | G-1 | 0.05 | - | - | - | - | - | - | K-7 | 0.01 | L-2 | 45.21 | L-3 | 11.30 |
| | 63 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 64 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 65 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 66 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 67 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 68 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 69 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 70 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 71 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 72 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |

[Table 3]

| | | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerizatio n initiator | | Surfactant | | Solvent | | | |
|---|---|---|---|---|---|---|---|---|---|---|---|---|---|---|---|---|---|---|---|---|---|---|---|---|---|---|---|---|---|
| | | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| Example | 73 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 74 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 75 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 76 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 77 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 78 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 79 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 80 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 81 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 82 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 83 | A-6 | B | 25000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |
| | 84 | A-6 | B | 10000 | 30.00 | B-1 | 10.73 | C-1 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 85 | A-6 | B | 10000 | 30.00 | B-1 | 10.73 | C-1 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 86 | A-6<br>A-1 | B<br>A | 10000<br>10000 | 21.00<br>9.00 | B-7 | 10.73 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 87 | A-6<br>A-5 | B<br>C | 10000<br>10000 | 21.00<br>9.00 | B-7 | 10.73 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 88 | A-6<br>A-11 | B<br>C | 10000<br>8000 | 21.00<br>9.00 | B-7 | 10.73 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 89 | A-6 | B | 10000 | 30.00 | B-7<br>B-8 | 7.51<br>3.22 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 90 | A-6 | B | 10000 | 30.00 | B-7<br>B-8 | 3.22<br>7.51 | C-4 | 1.88 | - | - | E-1 | 0.12 | F-1 | 0.71 | G-1 | 0.05 | - | - | - | - | - | - | K-7 | 0.01 | L-10 | 39.56 | L-5 | 16.95 |
| | 91 | A-6 | B | 10000 | 30.00 | B-7 | 10.73 | C-4<br>C-2 | 1.31<br>0.56 | - | - | E-1 | 0.12 | F-1 | 0.71 | G-1 | 0.05 | - | - | - | - | - | - | K-7 | 0.01 | L-10 | 39.56 | L-5 | 16.95 |
| | 92 | A-6 | B | 10000 | 30.00 | B-7 | 10.73 | C-8 | 0.56 | D-1 | 1.31 | E-1 | 0.12 | F-1 | 0.71 | G-1 | 0.05 | - | - | - | - | - | - | K-7 | 0.01 | L-10 | 39.56 | L-5 | 16.95 |
| | 93 | A-6 | B | 10000 | 30.00 | B-7 | 10.73 | C-8 | 0.56 | D-2 | 1.31 | E-1 | 0.12 | F-1 | 0.71 | G-1 | 0.05 | - | - | - | - | - | - | K-7 | 0.01 | L-10 | 39.56 | L-5 | 16.95 |
| | 94 | A-6 | B | 10000 | 30.00 | B-7 | 10.73 | C-2<br>C-8 | 0.56<br>0.56 | D-1 | 0.75 | E-1 | 0.12 | F-1 | 0.71 | G-1 | 0.05 | - | - | - | - | - | - | K-7 | 0.01 | L-10 | 39.56 | L-5 | 16.95 |
| | 95 | A-6 | B | 10000 | 30.00 | B-7 | 10.73 | C-4 | 1.88 | - | - | E-2 | 0.12 | F-1 | 0.71 | G-1 | 0.05 | - | - | - | - | - | - | K-7 | 0.01 | L-10 | 39.56 | L-5 | 16.95 |
| | 96 | A-6 | B | 10000 | 30.00 | B-7 | 10.73 | C-4 | 1.88 | - | - | E-3 | 0.12 | F-1 | 0.71 | G-1 | 0.05 | - | - | - | - | - | - | K-7 | 0.01 | L-10 | 39.56 | L-5 | 16.95 |
| | 97 | A-6 | B | 10000 | 30.00 | B-7 | 10.73 | C-4 | 1.88 | - | - | E-4 | 0.12 | F-1 | 0.71 | G-1 | 0.05 | - | - | - | - | - | - | K-7 | 0.01 | L-10 | 39.56 | L-5 | 16.95 |
| | 98 | A-6 | B | 10000 | 30.00 | B-7 | 10.73 | C-4 | 1.88 | - | - | E-5 | 0.12 | F-1 | 0.71 | G-1 | 0.05 | - | - | - | - | - | - | K-7 | 0.01 | L-10 | 39.56 | L-5 | 16.95 |
| | 99 | A-6 | B | 10000 | 30.00 | B-7 | 10.73 | C-4 | 1.88 | - | - | E-1 | 0.12 | F-2 | 0.71 | G-1 | 0.05 | - | - | - | - | - | - | K-7 | 0.01 | L-10 | 39.56 | L-5 | 16.95 |
| | 100 | A-6 | B | 10000 | 30.00 | B-7 | 10.73 | C-4 | 1.88 | - | - | E-1 | 0.12 | F-3 | 0.71 | G-1 | 0.05 | - | - | - | - | - | - | K-7 | 0.01 | L-10 | 39.56 | L-5 | 16.95 |
| | 101 | A-6 | B | 10000 | 30.00 | B-7 | 10.73 | C-4 | 1.88 | - | - | E-1 | 0.12 | F-4 | 0.71 | G-1 | 0.05 | - | - | - | - | - | - | K-7 | 0.01 | L-10 | 39.56 | L-5 | 16.95 |

[Table 4]

| | | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerization initiator | | Surfactant | | Solvent | | | |
|---|---|---|---|---|---|---|---|---|---|---|---|---|---|---|---|---|---|---|---|---|---|---|---|---|---|---|---|---|---|
| | | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| Example | 102 | A-6 | B | 10000 | 30.00 | B-7 | 10.73 | C-4 | 1.88 | - | - | E-1 | 0.12 | F-5 | 0.71 | G-1 | 0.05 | - | - | - | - | - | - | K-7 | 0.01 | L-10 | 39.56 | L-5 | 16.95 |
| | 103 | A-6 | B | 10000 | 30.00 | B-7 | 10.73 | C-4 | 1.88 | - | - | E-1 | 0.12 | F-6 | 0.71 | G-1 | 0.05 | - | - | - | - | - | - | K-7 | 0.01 | L-10 | 39.56 | L-5 | 16.95 |
| | 104 | A-6 | B | 10000 | 30.00 | B-7 | 10.73 | C-4 | 1.88 | - | - | E-1 | 0.12 | F-7 | 0.71 | G-1 | 0.05 | - | - | - | - | - | - | K-7 | 0.01 | L-10 | 39.56 | L-5 | 16.95 |
| | 105 | A-6 | B | 10000 | 30.00 | B-7 | 10.73 | C-4 | 1.88 | - | - | E-1 | 0.12 | F-8 | 0.71 | G-1 | 0.05 | - | - | - | - | - | - | K-7 | 0.01 | L-10 | 39.56 | L-5 | 16.95 |
| | 106 | A-6 | B | 10000 | 30.00 | B-7 | 10.73 | C-4 | 1.88 | - | - | E-1 | 0.12 | F-9 | 0.71 | G-1 | 0.05 | - | - | - | - | - | - | K-7 | 0.01 | L-10 | 39.56 | L-5 | 16.95 |
| | 107 | A-6 | B | 10000 | 30.00 | B-7 | 10.73 | C-4 | 1.88 | - | - | E-1 | 0.12 | F-10 | 0.71 | G-1 | 0.05 | - | - | - | - | - | - | K-7 | 0.01 | L-10 | 39.56 | L-5 | 16.95 |
| | 108 | A-6 | B | 10000 | 30.00 | B-7 | 10.73 | C-4 | 1.88 | - | - | E-1 | 0.12 | F-1 | 0.71 | G-2 | 0.05 | - | - | - | - | - | - | K-7 | 0.01 | L-10 | 39.56 | L-5 | 16.95 |
| | 109 | A-6 | B | 10000 | 30.00 | B-7 | 10.73 | C-4 | 1.88 | - | - | E-1 | 0.12 | F-1 | 0.71 | G-3 | 0.05 | - | - | - | - | - | - | K-7 | 0.01 | L-10 | 39.56 | L-5 | 16.95 |
| | 110 | A-6 | B | 10000 | 30.00 | B-7 | 10.73 | C-4 | 1.88 | - | - | E-1 | 0.12 | F-1 | 0.71 | G-4 | 0.05 | - | - | - | - | - | - | K-7 | 0.01 | L-10 | 39.56 | L-5 | 16.95 |
| | 111 | A-6 | B | 10000 | 30.00 | B-7 | 10.73 | C-4 | 1.88 | - | - | E-1 | 0.12 | F-1 | 0.71 | G-5 | 0.05 | - | - | - | - | - | - | K-7 | 0.01 | L-10 | 39.56 | L-5 | 16.95 |
| | 112 | A-6 | B | 10000 | 29.70 | B-7 | 10.73 | C-4 | 1.88 | - | - | E-1 | 0.12 | F-1 | 0.71 | G-1 | 0.05 | H-1 | 0.30 | - | - | - | - | K-7 | 0.01 | L-10 | 39.56 | L-5 | 16.95 |
| | 113 | A-6 | B | 10000 | 29.70 | B-7 | 10.73 | C-4 | 1.88 | - | - | E-1 | 0.12 | F-1 | 0.71 | G-1 | 0.05 | H-2 | 0.30 | - | - | - | - | K-7 | 0.01 | L-10 | 39.56 | L-5 | 16.95 |
| | 114 | A-6 | B | 10000 | 29.10 | B-7 | 10.73 | C-4 | 1.88 | - | - | E-1 | 0.12 | F-1 | 0.71 | G-1 | 0.05 | H-2 | 0.90 | - | - | - | - | K-7 | 0.01 | L-10 | 39.56 | L-5 | 16.95 |
| | 115 | A-6 | B | 10000 | 28.50 | B-7 | 10.73 | C-4 | 1.88 | - | - | E-1 | 0.12 | F-1 | 0.71 | G-1 | 0.05 | H-2 | 1.50 | - | - | - | - | K-7 | 0.01 | L-10 | 39.56 | L-5 | 16.95 |
| | 116 | A-6 | B | 10000 | 29.25 | B-7 | 10.73 | C-4 | 1.88 | - | - | E-1 | 0.12 | F-1 | 0.71 | G-1 | 0.05 | - | - | I-1 | 0.75 | - | - | K-7 | 0.01 | L-10 | 39.56 | L-5 | 16.95 |
| | 117 | A-6 | B | 10000 | 29.25 | B-7 | 10.73 | C-4 | 1.88 | - | - | E-1 | 0.12 | F-1 | 0.71 | G-1 | 0.05 | - | - | I-2 | 0.75 | - | - | K-7 | 0.01 | L-10 | 39.56 | L-5 | 16.95 |
| | 118 | A-6 | B | 10000 | 29.25 | B-7 | 10.73 | C-4 | 1.88 | - | - | E-1 | 0.12 | F-1 | 0.71 | G-1 | 0.05 | - | - | I-3 | 0.75 | - | - | K-7 | 0.01 | L-10 | 39.56 | L-5 | 16.95 |
| | 119 | A-6 | B | 10000 | 29.25 | B-7 | 10.73 | C-4 | 1.88 | - | - | E-1 | 0.12 | F-1 | 0.71 | G-1 | 0.05 | - | - | I-4 | 0.75 | - | - | K-7 | 0.01 | L-10 | 39.56 | L-5 | 16.95 |
| | 120 | A-6 | B | 10000 | 29.25 | B-7 | 10.73 | C-4 | 1.88 | - | - | E-1 | 0.12 | F-1 | 0.71 | G-1 | 0.05 | - | - | I-5 | 0.75 | - | - | K-7 | 0.01 | L-10 | 39.56 | L-5 | 16.95 |
| | 121 | A-6 | B | 10000 | 29.25 | B-7 | 10.73 | C-4 | 1.88 | - | - | E-1 | 0.12 | F-1 | 0.71 | G-1 | 0.05 | - | - | I-6 | 0.75 | - | - | K-7 | 0.01 | L-10 | 39.56 | L-5 | 16.95 |
| | 122 | A-6 | B | 10000 | 29.25 | B-7 | 10.73 | C-4 | 1.88 | - | - | E-1 | 0.12 | F-1 | 0.71 | G-1 | 0.05 | - | - | I-7 | 0.75 | - | - | K-7 | 0.01 | L-10 | 39.56 | L-5 | 16.95 |
| | 123 | A-6 | B | 10000 | 29.25 | B-7 | 10.73 | C-4 | 1.88 | - | - | E-1 | 0.12 | F-1 | 0.71 | G-1 | 0.05 | - | - | I-8 | 0.75 | - | - | K-7 | 0.01 | L-10 | 39.56 | L-5 | 16.95 |
| | 124 | A-6 | B | 10000 | 29.70 | B-7 | 10.73 | C-4 | 1.88 | - | - | E-1 | 0.12 | F-1 | 0.71 | G-1 | 0.05 | - | - | I-1 | 0.30 | - | - | K-7 | 0.01 | L-10 | 39.56 | L-5 | 16.95 |
| | 125 | A-6 | B | 10000 | 29.70 | B-7 | 10.73 | C-4 | 1.88 | - | - | E-1 | 0.12 | F-1 | 0.71 | G-1 | 0.05 | - | - | I-2 | 0.30 | - | - | K-7 | 0.01 | L-10 | 39.56 | L-5 | 16.95 |
| | 126 | A-6 | B | 10000 | 29.70 | B-7 | 10.73 | C-4 | 1.88 | - | - | E-1 | 0.12 | F-1 | 0.71 | G-1 | 0.05 | - | - | I-3 | 0.30 | - | - | K-7 | 0.01 | L-10 | 39.56 | L-5 | 16.95 |
| | 127 | A-6 | B | 10000 | 29.70 | B-7 | 10.73 | C-4 | 1.88 | - | - | E-1 | 0.12 | F-1 | 0.71 | G-1 | 0.05 | - | - | I-4 | 0.30 | - | - | K-7 | 0.01 | L-10 | 39.56 | L-5 | 16.95 |
| | 128 | A-6 | B | 10000 | 29.70 | B-7 | 10.73 | C-4 | 1.88 | - | - | E-1 | 0.12 | F-1 | 0.71 | G-1 | 0.05 | - | - | I-5 | 0.30 | - | - | K-7 | 0.01 | L-10 | 39.56 | L-5 | 16.95 |
| | 129 | A-6 | B | 10000 | 29.70 | B-7 | 10.73 | C-4 | 1.88 | - | - | E-1 | 0.12 | F-1 | 0.71 | G-1 | 0.05 | - | - | I-6 | 0.30 | - | - | K-7 | 0.01 | L-10 | 39.56 | L-5 | 16.95 |
| | 130 | A-6 | B | 10000 | 29.70 | B-7 | 10.73 | C-4 | 1.88 | - | - | E-1 | 0.12 | F-1 | 0.71 | G-1 | 0.05 | - | - | I-7 | 0.30 | - | - | K-7 | 0.01 | L-10 | 39.56 | L-5 | 16.95 |
| | 131 | A-6 | B | 10000 | 29.70 | B-7 | 10.73 | C-4 | 1.88 | - | - | E-1 | 0.12 | F-1 | 0.71 | G-1 | 0.05 | - | - | I-8 | 0.30 | - | - | K-7 | 0.01 | L-10 | 39.56 | L-5 | 16.95 |
| | 132 | A-6 | B | 10000 | 29.25 | B-7 | 10.73 | C-4 | 1.88 | - | - | E-1 | 0.12 | F-1 | 0.71 | G-1 | 0.05 | - | - | - | - | J-1 | 0.75 | K-7 | 0.01 | L-10 | 39.56 | L-5 | 16.95 |
| | 133 | A-6 | B | 10000 | 29.70 | B-7 | 10.73 | C-4 | 1.88 | - | - | E-1 | 0.12 | F-1 | 0.71 | G-1 | 0.05 | - | - | - | - | J-1 | 0.30 | K-7 | 0.01 | L-10 | 39.56 | L-5 | 16.95 |
| | 134 | A-6 | B | 10000 | 29.10 | B-7 | 10.73 | C-4 | 1.88 | - | - | E-1 | 0.12 | F-1 | 0.71 | G-1 | 0.05 | H-2 | 0.30 | I-8 | 0.30 | J-1 | 0.30 | K-7 | 0.01 | L-10 | 39.56 | L-5 | 16.95 |
| | 135 | A-16 | B | 10000 | 29.10 | B-7 | 10.73 | C-4 | 1.88 | - | - | E-1 | 0.12 | F-1 | 0.71 | G-1 | 0.05 | H-2 | 0.30 | I-8 | 0.30 | J-1 | 0.30 | K-7 | 0.01 | L-10 | 39.56 | L-5 | 16.95 |
| | 136 | A-17 | B | 10000 | 29.10 | B-7 | 10.73 | C-4 | 1.88 | - | - | E-1 | 0.12 | F-1 | 0.71 | G-1 | 0.05 | H-2 | 0.30 | I-8 | 0.30 | J-1 | 0.30 | K-7 | 0.01 | L-10 | 39.56 | L-5 | 16.95 |
| | 137 | A-18 | B | 10000 | 29.10 | B-7 | 10.73 | C-4 | 1.88 | - | - | E-1 | 0.12 | F-1 | 0.71 | G-1 | 0.05 | H-2 | 0.30 | I-8 | 0.30 | J-1 | 0.30 | K-7 | 0.01 | L-10 | 39.56 | L-5 | 16.95 |

[Table 5]

| | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerization initiator | | Surfactant | | Solvent | | | |
|---|---|---|---|---|---|---|---|---|---|---|---|---|---|---|---|---|---|---|---|---|---|---|---|---|---|---|---|---|
| Example | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| 138 | A-19 | B | 10000 | 29.10 | B-7 | 10.73 | C-4 | 1.88 | - | - | E-1 | 0.12 | F-1 | 0.71 | G-1 | 0.05 | H-2 | 0.30 | I-8 | 0.30 | J-1 | 0.30 | K-7 | 0.01 | L-10 | 39.56 | L-5 | 16.95 |
| 139 | A-1 | A | 25000 | 30.00 | - | - | - | - | - | - | - | - | - | - | - | - | - | - | - | - | - | - | - | - | L-1 | 70.00 | - | - |
| 140 | A-2 | B | 25000 | 30.00 | - | - | - | - | - | - | - | - | - | - | - | - | - | - | - | - | - | - | - | - | L-1 | 70.00 | - | - |
| 141 | A-3 | B | 25000 | 30.00 | - | - | - | - | - | - | - | - | - | - | - | - | - | - | - | - | - | - | - | - | L-1 | 70.00 | - | - |
| 142 | A-4 | C | 25000 | 30.00 | - | - | - | - | - | - | - | - | - | - | - | - | - | - | - | - | - | - | - | - | L-1 | 70.00 | - | - |
| 143 | A-5 | C | 25000 | 30.00 | - | - | - | - | - | - | - | - | - | - | - | - | - | - | - | - | - | - | - | - | L-1 | 70.00 | - | - |
| 144 | A-6 | B | 25000 | 30.00 | - | - | - | - | - | - | - | - | - | - | - | - | - | - | - | - | - | - | - | - | L-1 | 70.00 | - | - |
| 145 | A-7 | B | 25000 | 30.00 | - | - | - | - | - | - | - | - | - | - | - | - | - | - | - | - | - | - | - | - | L-1 | 70.00 | - | - |
| 146 | A-8 | B | 25000 | 30.00 | - | - | - | - | - | - | - | - | - | - | - | - | - | - | - | - | - | - | - | - | L-1 | 70.00 | - | - |
| 147 | A-9 | B | 25000 | 30.00 | - | - | - | - | - | - | - | - | - | - | - | - | - | - | - | - | - | - | - | - | L-1 | 70.00 | - | - |
| 148 | A-10 | B | 25000 | 30.00 | - | - | - | - | - | - | - | - | - | - | - | - | - | - | - | - | - | - | - | - | L-1 | 70.00 | - | - |
| 149 | A-6 | B | 19000 | 30.00 | - | - | - | - | - | - | - | - | - | - | - | - | - | - | - | - | - | - | - | - | L-1 | 70.00 | - | - |
| 150 | A-6 | B | 15000 | 30.00 | - | - | - | - | - | - | - | - | - | - | - | - | - | - | - | - | - | - | - | - | L-1 | 70.00 | - | - |
| 151 | A-6 | B | 10000 | 30.00 | - | - | - | - | - | - | - | - | - | - | - | - | - | - | - | - | - | - | - | - | L-1 | 70.00 | - | - |
| 152 | A-12 | B | 10000 | 30.00 | - | - | - | - | - | - | - | - | - | - | - | - | - | - | - | - | - | - | - | - | L-1 | 70.00 | - | - |
| 153 | A-13 | B | 10000 | 30.00 | - | - | - | - | - | - | - | - | - | - | - | - | - | - | - | - | - | - | - | - | L-1 | 70.00 | - | - |
| 154 | A-14 | A | 10000 | 30.00 | - | - | - | - | - | - | - | - | - | - | - | - | - | - | - | - | - | - | - | - | L-1 | 70.00 | - | - |
| 155 | A-15 | A | 10000 | 30.00 | - | - | - | - | - | - | - | - | - | - | - | - | - | - | - | - | - | - | - | - | L-1 | 70.00 | - | - |
| 156 | A-16 | B | 10000 | 30.00 | - | - | - | - | - | - | - | - | - | - | - | - | - | - | - | - | - | - | - | - | L-1 | 70.00 | - | - |
| 157 | A-17 | B | 10000 | 30.00 | - | - | - | - | - | - | - | - | - | - | - | - | - | - | - | - | - | - | - | - | L-1 | 70.00 | - | - |
| 158 | A-18 | B | 10000 | 30.00 | - | - | - | - | - | - | - | - | - | - | - | - | - | - | - | - | - | - | - | - | L-1 | 70.00 | - | - |
| 159 | A-19 | B | 10000 | 30.00 | - | - | - | - | - | - | - | - | - | - | - | - | - | - | - | - | - | - | - | - | L-1 | 70.00 | - | - |
| 160 | A-1 | A | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 161 | A-2 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 162 | A-3 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 163 | A-4 | C | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 164 | A-5 | C | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 165 | A-6 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 166 | A-7 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 167 | A-8 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 168 | A-9 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 169 | A-10 | B | 25000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 170 | A-6 | B | 19000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 171 | A-6 | B | 15000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 172 | A-6 | B | 10000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| 173 | A-16 | B | 10000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |

[Table 6]

| | | Resin | | | | Polymerizable compound | | Photopolymerization initiator | | Sensitizing agent | | Rust inhibitor | | Adhesive | | Polymerization inhibitor | | i-ray absorption adjuster | | Metal complex | | Thermal polymerization initiator | | Surfactant | | Solvent | | | |
|---|---|---|---|---|---|---|---|---|---|---|---|---|---|---|---|---|---|---|---|---|---|---|---|---|---|---|---|---|---|
| | | Type | tanδ | Mw | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount | Type | Adding amount |
| Example | 174 | A-17 | B | 10000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| | 175 | A-18 | B | 10000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| | 176 | A-19 | B | 10000 | 30.00 | B-1 | 4.55 | C-1 | 1.59 | - | - | E-1 | 0.10 | F-1 | 0.61 | G-1 | 0.04 | - | - | - | - | - | - | - | - | L-1 | 63.11 | - | - |
| | 177 | A-6 | B | 10000 | 30.00 | B-7 | 4.55 | C-4 | 1.59 | - | - | E-1 | 0.10 | F-1 | 0.61 | G-1 | 0.04 | - | - | - | - | - | - | K-7 | 0.01 | L-10 | 44.18 | L-5 | 18.93 |
| | 178 | A-6 | B | 10000 | 30.00 | B-1 | 4.55 | C-5 | 1.59 | - | - | E-4 | 0.10 | F-10 | 0.61 | G-1 | 0.04 | - | - | - | - | - | - | K-7 | 0.01 | L-10 | 44.18 | L-5 | 18.93 |
| | 179 | A-6 | B | 10000 | 29.70 | B-1 | 4.55 | C-5 | 1.59 | - | - | E-4 | 0.10 | F-10 | 0.61 | G-1 | 0.04 | H-2 | 0.30 | - | - | - | - | K-7 | 0.01 | L-10 | 44.18 | L-5 | 18.93 |
| | 180 | A-6 | B | 10000 | 29.25 | B-1 | 4.55 | C-5 | 1.59 | - | - | E-4 | 0.10 | F-10 | 0.61 | G-1 | 0.04 | - | - | I-1 | 0.75 | - | - | K-7 | 0.01 | L-10 | 44.18 | L-5 | 18.93 |
| | 181 | A-6 | B | 10000 | 29.25 | B-1 | 4.55 | C-5 | 1.59 | - | - | E-4 | 0.10 | F-10 | 0.61 | G-1 | 0.04 | - | - | - | - | J-1 | 0.75 | K-7 | 0.01 | L-10 | 44.18 | L-5 | 18.93 |
| | 182 | A-6 | B | 10000 | 28.20 | B-1 | 4.55 | C-5 | 1.59 | - | - | E-4 | 0.10 | F-10 | 0.61 | G-1 | 0.04 | H-2 | 0.30 | I-1 | 0.75 | J-1 | 0.75 | K-7 | 0.01 | L-10 | 44.18 | L-5 | 18.93 |
| | 183 | A-16 | B | 10000 | 28.20 | B-1 | 4.55 | C-5 | 1.59 | - | - | E-4 | 0.10 | F-10 | 0.61 | G-1 | 0.04 | H-2 | 0.30 | I-1 | 0.75 | J-1 | 0.75 | K-7 | 0.01 | L-10 | 44.18 | L-5 | 18.93 |
| | 184 | A-17 | B | 10000 | 28.20 | B-1 | 4.55 | C-5 | 1.59 | - | - | E-4 | 0.10 | F-10 | 0.61 | G-1 | 0.04 | H-2 | 0.30 | I-1 | 0.75 | J-1 | 0.75 | K-7 | 0.01 | L-10 | 44.18 | L-5 | 18.93 |
| | 185 | A-18 | B | 10000 | 28.20 | B-1 | 4.55 | C-5 | 1.59 | - | - | E-4 | 0.10 | F-10 | 0.61 | G-1 | 0.04 | H-2 | 0.30 | I-1 | 0.75 | J-1 | 0.75 | K-7 | 0.01 | L-10 | 44.18 | L-5 | 18.93 |
| | 186 | A-19 | B | 10000 | 28.20 | B-1 | 4.55 | C-5 | 1.59 | - | - | E-4 | 0.10 | F-10 | 0.61 | G-1 | 0.04 | H-2 | 0.30 | I-1 | 0.75 | J-1 | 0.75 | K-7 | 0.01 | L-10 | 44.18 | L-5 | 18.93 |
| Comparative Example | 1 | AR-1 | G | 40000 | 30.00 | B-1 | 10.73 | C-1 | 1.88 | - | - | E-1 | 0.12 | F-1 | 0.71 | G-1 | 0.05 | - | - | - | - | - | - | - | - | L-1 | 56.51 | - | - |

Details of each of the components listed in the table are as follows.

[Resin]

- ·A-1 to A-19: (A-1) to (A-19) synthesized above
- ·AR-1: resin having a repeating unit having the following structure

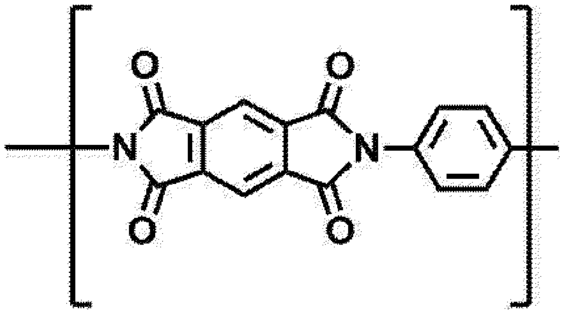

[Polymerizable compound]

- ·B-1: SR-209 (manufactured by Sartomer Company Inc.)
- ·B-2: compound having the following structure
- ·B-3: compound having the following structure
- ·B-4: compound having the following structure
- ·B-5: SR-444 (manufactured by Sartomer Company Inc.)
- ·B-6: SR-295 (manufactured by Sartomer Company Inc.)
- ·B-7: SR-268 (manufactured by Sartomer Company Inc.)
- ·B-8: KAYARAD DPHA (manufactured by Nippon Kayaku Co., Ltd.)
- ·B-9: OGSOL EA-0300 (manufactured by Osaka Gas Chemicals Co., Ltd.)

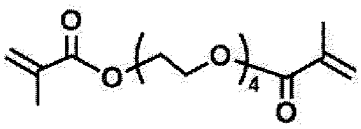

B-1

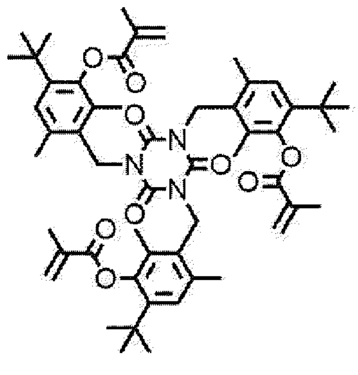

B-2

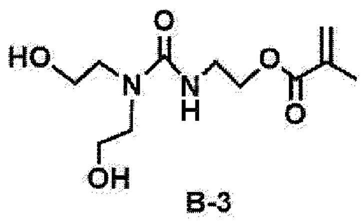

B-3

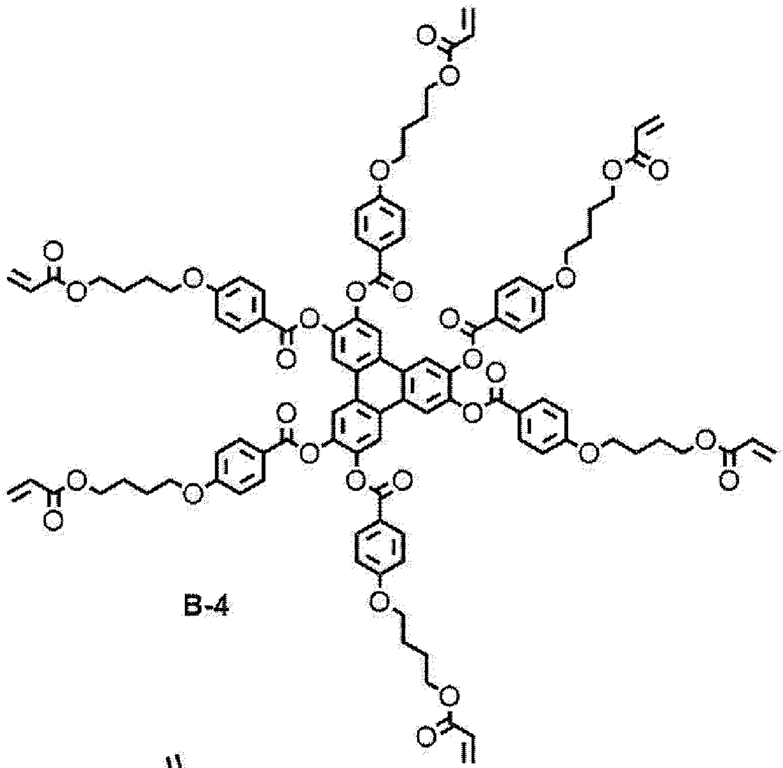

B-4

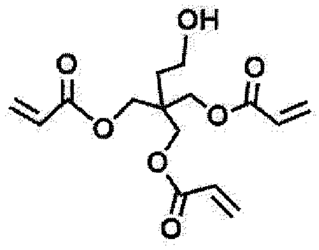

B-5

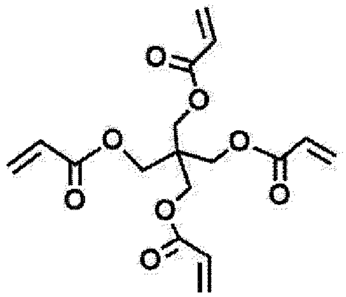

B-6

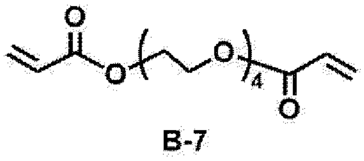

B-7

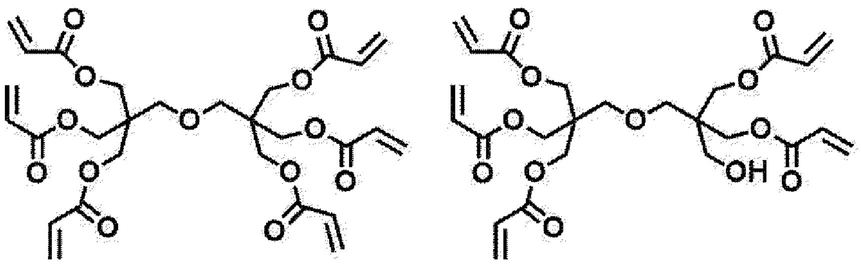

**B-8 (COMPOUND HAVING MOLAR RATIO OF 7:3)**

[Photopolymerization initiator]

C-1: OXE-01 (manufactured by BASF SE)
C-2: OXE-02 (manufactured by BASF SE)
C-3: OXE-03 (manufactured by BASF SE)
C-4: compound having the following structure
C-5: TR-PBG-304 (manufactured by Changzhou Tronly New Electronic Materials Co., Ltd.)
C-6: TR-PBG-305 (manufactured by Changzhou Tronly New Electronic Materials Co., Ltd.)

C-7: TR-PBG-3057 (manufactured by Changzhou Tronly New Electronic Materials Co., Ltd.)
C-8: Quantacure PDO (manufactured by WARD BLEKINSOP)
C-9: Omnirad 1316 (manufactured by IGM Resins)
C-10: Omnirad 1312 (manufactured by IGM Resins)
C-11: compound having the following structure

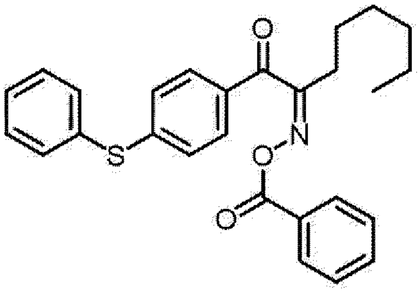
C-1

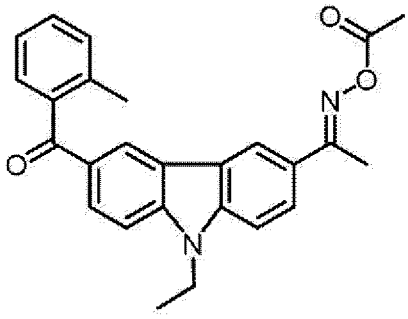
C-2

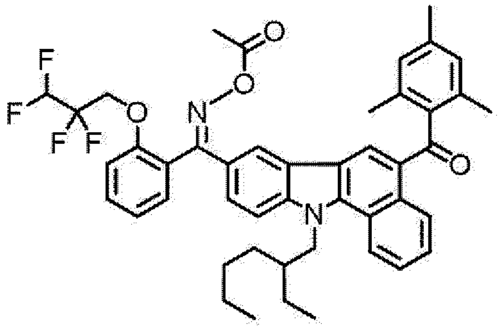
C-3

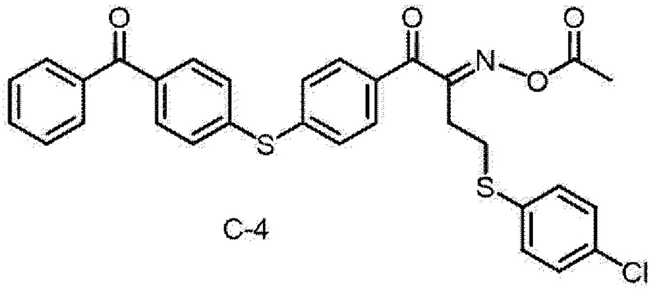
C-4

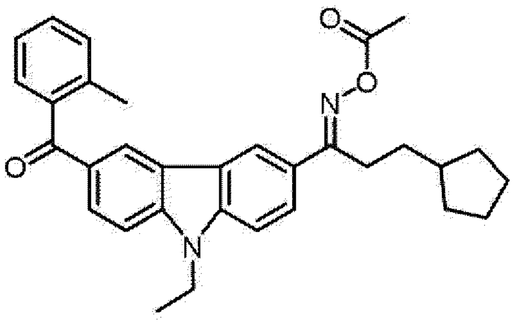
C-5

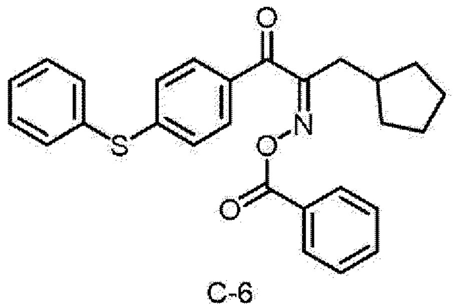
C-6

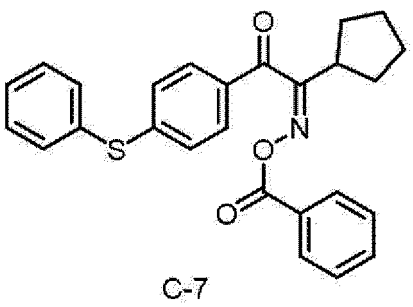
C-7

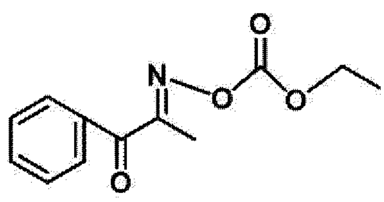
C-8

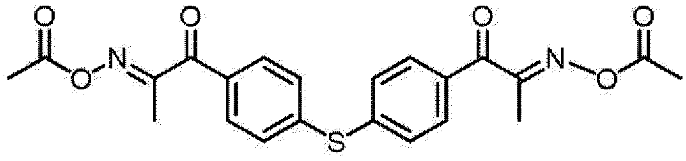

C-9

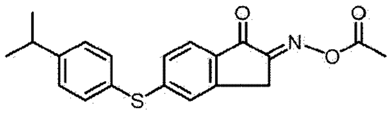

C-10

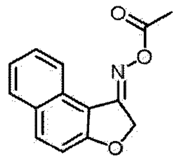

C-11

[Sensitizing agent]

·D-1: compound having the following structure
·D-2: compound having the following structure

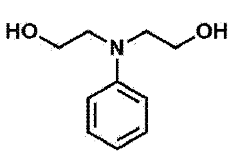

**(D-1)**

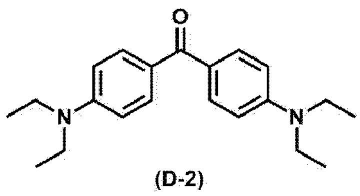

**(D-2)**

[Rust inhibitor (migration suppressing agent)]

·E-1: 5-aminotetrazole
·E-2: 1H-tetrazole
·E-3: Benzotriazole
·E-4: A compound having the following structure
·E-5: 5-methylbenzotriazole

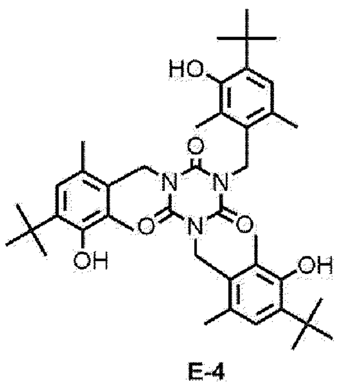

**E-4**

[Adhesive (silane coupling agent)]

·F-1: A compound having the following structure
·F-2: KBM-403 (manufactured by Shin-Etsu Chemical Co., Ltd.)
·F-3: KBM-573 (manufactured by Shin-Etsu Chemical Co., Ltd.)
·F-4: KBE-903 (manufactured by Shin-Etsu Chemical Co., Ltd.)
·F-5: X-12-989MS (manufactured by Shin-Etsu Chemical Co., Ltd.)
·F-6: X-12-1214A (manufactured by Shin-Etsu Chemical Co., Ltd.)
·F-7: X-12-1281C (manufactured by Shin-Etsu Chemical Co., Ltd.)
·F-8: X-12-1288 (manufactured by Shin-Etsu Chemical Co., Ltd.)
·F-9: compound having the following structure (here, Et represents an ethyl group)
·F-10: A compound having the following structure

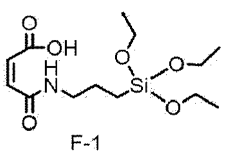

F-1

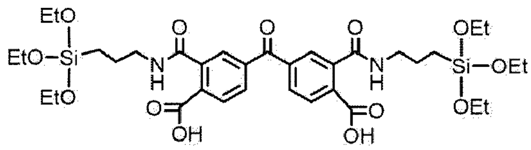

F-9

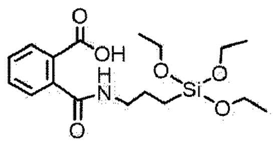

F-10

[Polymerization inhibitor]

·G-1: 4-methoxyphenol
· G-2: 1,4-benzoquinone
· G-3: 2-nitroso-1-naphthol
·G-4: 4-OH TEMPO benzoate
·G-5: 4-tert-butylcatechol

[i-ray absorption adjuster]

·H-1: A compound having the following structure
·H-2: PS-62T (manufactured by Toyo Gosei Co., Ltd.)

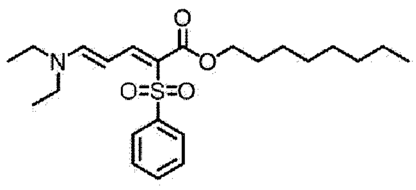

H-1

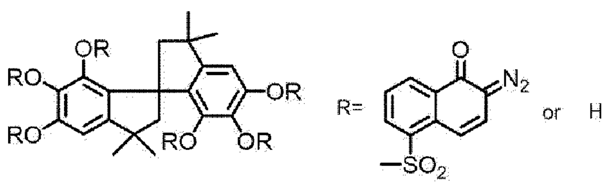

R= or H

H-2

[Metal complex]

- I-1: TC-750 (manufactured by Matsumoto Fine Chemical Co., Ltd.)
- I-2: TC-401 (manufactured by Matsumoto Fine Chemical Co., Ltd.)
- I-3: TC-800 (manufactured by Matsumoto Fine Chemical Co., Ltd.)
- I-4: TC-810 (manufactured by Matsumoto Fine Chemical Co., Ltd.)
- I-5: compound having the following structure
- I-6: compound having the following structure
- I-7: compound having the following structure
- I-8: compound having the following structure

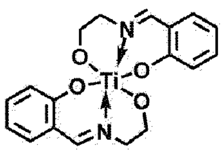

I-5

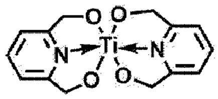

I-6

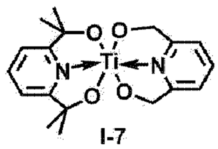

I-7

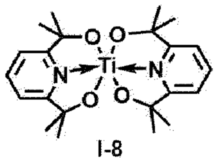

I-8

[Thermal polymerization initiator]

- J-1: PARKMILL D (manufactured by NOF Corporation)

[Surfactant]

- K-1: F-554 (fluorine-based surfactant, manufactured by DIC Corporation)
- K-2: PF-6320 (fluorine-based surfactant, manufactured by OMNINOVA)
- K-3: F-557 (fluorine-based surfactant, manufactured by DIC Corporation)
- K-4: KP-341 (silicone-based surfactant, manufactured by Shin-Etsu Silicone Co., Ltd.)
- K-5: KP-323 (silicone-based surfactant, manufactured by Shin-Etsu Silicone Co., Ltd.)
- K-6: KP-110 (silicone-based surfactant, manufactured by Shin-Etsu Silicone Co., Ltd.)
- K-7: KF-6000 (silicone-based surfactant, manufactured by Shin-Etsu Silicone Co., Ltd.)
- K-8: KF-6001 (silicone-based surfactant, manufactured by Shin-Etsu Silicone Co., Ltd.)

[Solvent]

- L-1: NMP (N-methylpyrrolidone, boiling point: 202°C)
- L-2: GBL (γ-butyrolactone, boiling point: 204°C)
- L-3: DMSO (dimethyl sulfoxide, boiling point: 189°C)
- L-4: γ-valerolactone (boiling point: 207°C)
- L-5: Propylene carbonate (boiling point: 242°C)
- L-6: 1,3-dimethyl-2-imidazolidinone (boiling point: 225°C)
- L-7: 3-methoxy-N,N-dimethylpropanamide (boiling point: 215°C)
- L-8: 3-butoxy-N,N-dimethylpropanamide (boiling point: 252°C)

·L-9: 2-hydroxy-N,N-dimethylpropanamide (boiling point: 200°C)
·L-10: cyclopentanone (boiling point: 131°C)
·L-11: cyclohexanone (boiling point: 156°C)
·L-12: cycloheptanone (boiling point: 179°C)
·L-13: 4-methylcyclohexanone (boiling point: 170°C)
·L-14: 3-methylcyclohexanone (boiling point: 169°C)
·L-15: anisole (boiling point: 154°C)
·L-16: cyclohexyl acetate (boiling point: 175°C)
·L-17: EL (ethyl lactate, boiling point: 154°C)

<Evaluation>

[Measurement of tan δ of resin]

The resin powder was packed in a sample tube, and tan δ at 28 GHz was determined using a cavity resonator. The evaluation was carried out according to the following evaluation standards, and the evaluation results are described in the column of tan δ of "Resin" in the above table.

[Measurement of tan δ of cured film (cured substance)]

Each of the resin compositions or comparative compositions in Examples and Comparative Examples was applied onto a silicon wafer by a spin coating method to form a resin composition layer. The obtained silicon wafer onto which the resin composition layer had been applied was dried on a hot plate at 110°C for 3 minutes, whereby a resin composition layer in which a film thickness after the film formation on the silicon wafer was a uniform thickness of 10 μm was obtained.

The above-described resin composition layer was heated at 230°C for 1 hour at a temperature rising rate of 10 °C/min in a nitrogen atmosphere. The obtained cured film was immersed in a 4.9% by mass aqueous hydrofluoric acid solution and peeled off from the silicon wafer, and the tan δ at 28 GHz was determined using a cavity resonator. The evaluation results are described in the column of "tan δ of cured film" in the table. In the examples in which "-" is described in the following table, the present evaluation was not performed.

- Conditions of measuring device of -tan δ -

Split cylinder resonator (CR-728)
Network analyzer: N5230A (manufactured by Keysight Technologies, Inc.)

- Evaluation standards -

A: $0.001 \leq \tan\delta < 0.005$
B: $0.005 \leq \tan\delta < 0.010$
C: $0.010 \leq \tan\delta < 0.015$
D: $0.015 \leq \tan\delta < 0.020$
E: $0.020 \leq \tan\delta < 0.025$
F: $0.025 \leq \tan\delta < 0.03$
G: $\tan\delta \geq 0.03$

[Evaluation of flatness]

In each of Examples and Comparative Examples, the resin composition or the comparative composition was applied onto a silicon wafer on which a copper wire having a height of 15 μm and 20 μm line-and-space (L/S) and a taper angle of 85 degrees was formed by a spin coating method to form a resin composition layer. The silicon wafer to which the obtained resin composition layer was applied was dried on a hot plate, thereby obtaining a resin composition layer having a uniform thickness of a film thickness of about 20 μm in the space portion of the copper wire on the silicon wafer.

The resin composition layer was heated in a nitrogen atmosphere at a temperature rising rate of 10 °C/min,

thereby obtaining a cured substance.

The obtained cured substance was measured for a recess X (μm) of the cured substance in the space portion of the copper wire with a scanning electron microscope (S-4800) (manufactured by Hitachi High-Tech Corporation), and evaluated according to the following standard. The evaluation results are described in the column of "Flatness" in the table below.

Fig. 1 is a schematic cross-sectional view of a state in which a cured substance is formed on a silicon wafer on which a copper wire is formed. A silicon wafer 16 in Fig. 1 comprises a copper wire 14, and a cured substance 12 is formed on the silicon wafer. Here, the cured substance 12 in the region on the silicon wafer 16 where the copper wire 14 is not formed has a recess 18.

H is the height (15 μm) of the copper wire 14, W is the width (20 μm) of the space portion of the copper wire 14, and θ is the taper angle (85 degrees) of the copper wire 14. h1 indicates the total thickness of the cured substance 12 and the copper wire 14 at the center position of the copper wire 14, and h2 indicates the thickness of the cured substance 12 at the center position of the space portion of the copper wire, respectively. Here, the above-described "recess X" is a value calculated by h1 - h2.

It is preferable that the smaller the recess X, the better the flatness, and for example, it is preferable that the evaluation is A, B, or C.

The drying step and the heating step were performed under the following conditions.

<Drying step>

(A) 110°C for 3 minutes (reference condition)
(B) 110°C for 4 minutes
(C) 110°C for 5 minutes (corresponding to condition ii)
(D) 110°C for 10 minutes (corresponding to condition ii)
(E) 100°C for 10 minutes (corresponding to condition ii)
(F) 120°C for 3 minutes (corresponding to condition i)
(G) 140°C for 3 minutes (corresponding to condition i)
(H) 150°C for 3 minutes
(I) 160°C for 3 minutes

Condition i: a heating temperature in the drying step is 120°C or higher and lower than 150°C.

Condition ii: a heating temperature in the drying step is lower than 120°C and a heating time is 5 minutes or longer.

<Heating step>

(a) 230°C for 1 hour (reference condition)
(b) 240°C for 1 hour (corresponding to the condition iii)
(c) 350°C for 1 hour (corresponding to the condition iii)
(d) 230°C for 2 hours
(e) 230°C for 3 hours (corresponding to the condition iv)
(f) 200°C for 3 hours (corresponding to condition iv)
(g) 150°C for 3 hours (corresponding to the condition iv)
(h) 140°C for 5 hours
(i) The first heating step was performed at 200°C for 3 hours, and the second heating step was performed at 230°C for 1 hour.
(j) The first heating step was performed at 190°C for 3 hours, and the second heating step was performed at 230°C for 1 hour (corresponding to the condition v)
(k) The first heating step was performed at 150°C for 3 hours, and the second heating step was performed at 230°C for 1 hour (corresponding to the condition v)
(l) The first heating step was performed at 140°C for 3 hours, and the second heating step was performed at 230°C for 1 hour.

(Evaluation standards)

A: $X \leq 1$
B: $1 < X \leq 2$
C: $2 < X \leq 3$
D: $3 < X \leq 5$
E: $X > 5$

[Evaluation of resolution]

Each of the resin compositions and comparative compositions prepared in each Examples and Comparative Examples was applied in a layered manner to the surface of the thin copper layer of the resin base material on which the thin copper layer was formed on the surface by a spin coating method, and dried on a hot plate at 110°C for 3 minutes to form a resin composition layer having a film thickness of 5 μm after film formation, and then exposed using a stepper (FPA-3000 i5 (manufactured by Canon Inc.)). The exposure was performed at a wavelength of 365 nm and 200 mJ/$cm^2$ through a mask in which hole patterns having a diameter of 3 to 20 μm were formed at an interval of 1 μm. Subsequently, development was carried out with cyclopentanone for 15 seconds, rinsing was carried out with PGMEA for 30 seconds, heating was performed at a temperature rising rate of 10 °C/min in a nitrogen atmosphere, and heating was carried out at 230°C for 1 hour to obtain a hole pattern of 3 to 20 μm. The formed hole pattern was evaluated according to the following standards. The evaluation results are described in the column of "Resolution" in the table below. It can be said that the smaller the diameter of the hole pattern that can be formed, the better the resolution, and for example, A, B, or C is preferable. In the examples in which "-" is described in the following table, the present evaluation was not performed.

- Evaluation standards -

A: A hole pattern having a diameter of up to 3 μm could be resolved.
B: A hole pattern having a diameter of 5 μm could be resolved, but a hole pattern having a diameter of 3 μm could not be formed.
C: A hole pattern having a diameter of 7 μm could be resolved, but a hole pattern having a diameter of 5 μm could not be formed.
D: A hole pattern having a diameter of 10 μm could be resolved, but a hole pattern having a diameter of 7 μm could not be formed.
E: A hole pattern having a diameter of 20 μm was not resolved.

[Evaluation of in-plane wafer coating uniformity]

A composition of each Example was applied onto a 8 inch circular silicon wafer by a spin coating method to form a resin composition layer. The silicon wafer to which the obtained resin composition layer was applied was dried on a hot plate at 110°C for 3 minutes to form a dried film, and the film thickness distribution in the wafer plane was measured. The film thicknesses at a total of 21 points of the center of the wafer, ±90 mm, ±81 mm, ±72 mm, ±63 mm, ±54 mm, ±45 mm, ±36 mm, ±27 mm, ±18 mm, and ±9 mm from the center of the wafer in the diameter direction were measured with an optical film thickness meter (F-50EXR, manufactured by Filmetrics, Inc.), and Y was calculated according to the following expression as an index of the in-plane wafer coating uniformity and evaluated according to the following evaluation standard.

Fig. 2 is a schematic top view showing a measurement position of a film thickness of a dried film formed on a circular silicon wafer. In a silicon wafer 20 on which the dried film is formed, a total of 21 film thickness measurement points 22 are aligned at equal intervals on the diameter of the silicon wafer, and one measurement point present in the center of the measurement points 22 is present in a center 24 of the silicon wafer 20 on which the dried film is formed.

The evaluation results are described in the column of "In-plane wafer coating uniformity" in the following table. It can be said that the smaller the Y, the better the in-plane wafer coating uniformity. For example, evaluation A, B, or C is preferable. In the examples in which "-" is described in the following table, the present evaluation was not performed.

Y is a larger value of (maximum film thickness/average film thickness - 1) and -(minimum film thickness/average film thickness - 1).

(Evaluation standards)

A: Y ≤ 3%
B: 3% < Y ≤ 5%
C: 5% < Y ≤ 10%
D: 10% < Y ≤ 20%
E: Y > 20%

[PCT Evaluation]

A composition of each Example was applied onto a silicon wafer on which a wiring line having a height of 6 μm, a line-and-space (L/S) of 10 μm, and a taper angle of 90 degrees was formed by a spin coating method to form a resin composition layer. The obtained silicon wafer onto which the resin composition layer had been applied was dried on a hot plate at 110°C for 3 minutes, whereby a resin composition layer in which a film thickness after the film formation on the silicon wafer was a uniform thickness of 10 μm was obtained.
The obtained resin composition layer on the entire surface of the silicon wafer was exposed with an USHIO exposure machine (light source: 500 $W/m^2$, ultra-high pressure mercury lamp) at an exposure energy of 400 $mJ/cm^2$.
The resin composition layer after the exposure was heated at 230°C for 1 hour at a temperature rising rate of 10 °C/min in a nitrogen atmosphere to obtain a cured substance.
The obtained cured substance was subjected to a PCT test (temperature: 121°C/humidity: 100%/250 hours (PC-R8D manufactured by Hirayama Manufacturing Corporation)), and the presence or absence of cracks at the interface between the copper wire and the cured substance was observed with a scanning electron microscope (S-4800) (manufactured by Hitachi High-Tech Corporation). As a result, it was found that there was no occurrence of cracks in any of Examples, and the interlayer insulating film had excellent reliability and could be suitably used.

Explanation of References

12: cured substance
14: copper wire
16: silicon wafer
18: recess
20: silicon wafer on which dried film was formed
22: film thickness measurement point
24: center
θ: taper angle of copper wire
H: height of copper wire
W: width of space portion of copper wire
h1: total thickness of cured substance and copper wire at center position of copper wire
h2: thickness of cured substance at center position of space portion of copper wire

[Table 7]

| | Drying step | Heating step | tanδ of cured film | Evaluation | | |
|---|---|---|---|---|---|---|
| | | | | Flatness | Resolution | In-plane wafer coating uniformity |
| Example 1 | A | a | B | C | C | C |
| Example 2 | A | a | C | C | C | C |
| Example 3 | A | a | C | C | C | C |
| Example 4 | A | a | D | C | B | C |
| Example 5 | A | a | D | C | B | C |

(continued)

| | Drying step | Heating step | tanδ of cured film | Evaluation | | |
|---|---|---|---|---|---|---|
| | | | | Flatness | Resolution | In-plane wafer coating uniformity |
| Example 6 | A | a | C | C | B | C |
| Example 7 | A | a | C | C | B | C |
| Example 8 | A | a | C | C | B | C |
| Example 9 | A | a | C | C | B | C |
| Example 10 | A | a | C | C | B | C |
| Example 11 | A | a | C | B | B | C |
| Example 12 | A | a | C | A | A | C |
| Example 13 | A | a | C | A | A | C |
| Example 14 | A | a | C | A | A | C |
| Example 15 | A | a | C | A | A | C |
| Example 16 | A | a | C | A | A | C |
| Example 17 | A | a | C | A | A | C |
| Example 18 | A | a | C | B | B | C |
| Example 19 | A | a | C | B | B | C |
| Example 20 | A | a | C | A | B | C |
| Example 21 | A | a | C | A | B | C |
| Example 22 | A | a | C | A | B | C |
| Example 23 | A | a | C | A | B | C |
| Example 24 | A | a | C | A | B | C |
| Example 25 | A | a | C | A | B | C |
| Example 26 | A | a | C | B | B | B |
| Example 27 | A | a | C | B | B | B |
| Example 28 | A | a | C | B | B | B |
| Example 29 | A | a | C | B | B | A |
| Example 30 | A | a | C | B | B | A |
| Example 31 | A | a | C | B | B | A |
| Example 32 | A | a | C | B | B | A |
| Example 33 | A | a | C | B | B | A |
| Example 34 | A | a | C | C | B | C |
| Example 35 | A | a | C | C | B | C |
| Example 36 | A | a | C | C | B | C |
| Example 37 | A | a | C | C | B | C |
| Example 38 | A | a | C | C | B | C |
| Example 39 | A | a | C | C | B | C |
| Example 40 | A | a | C | C | B | C |
| Example 41 | A | a | C | C | B | C |
| Example 42 | A | a | C | C | B | C |
| Example 43 | A | a | C | B | B | C |

(continued)

| | Drying step | Heating step | tanδ of cured film | Evaluation | | |
|---|---|---|---|---|---|---|
| | | | | Flatness | Resolution | In-plane wafer coating uniformity |
| Example 44 | A | a | C | B | B | C |
| Example 45 | A | a | C | B | B | C |
| Example 46 | A | a | C | B | B | C |
| Example 47 | A | a | C | B | B | C |
| Example 48 | A | a | C | B | B | C |

[Table 8]

| | Drying step | Heating step | tanδ of cured film | Evaluation | | |
|---|---|---|---|---|---|---|
| | | | | Flatness | Resolution | In-plane wafer coating uniformity |
| Example 49 | A | a | C | B | B | B |
| Example 50 | A | a | C | B | B | B |
| Example 51 | A | a | C | B | B | B |
| Example 52 | A | a | C | B | B | B |
| Example 53 | A | a | C | B | B | B |
| Example 54 | A | a | C | B | B | B |
| Example 55 | A | a | C | B | B | B |
| Example 56 | A | a | C | B | B | B |
| Example 57 | A | a | C | B | B | B |
| Example 58 | A | a | C | B | B | B |
| Example 59 | A | a | C | B | B | B |
| Example 60 | A | a | C | B | B | B |
| Example 61 | A | a | C | A | A | A |
| Example 62 | A | a | C | C | A | C |
| Example 63 | B | a | - | C | - | - |
| Example 64 | C | a | - | B | - | - |
| Example 65 | D | a | - | B | - | - |
| Example 66 | E | a | - | B | - | - |
| Example 67 | F | a | - | B | - | - |
| Example 68 | G | a | - | B | - | - |
| Example 69 | H | a | - | C | - | - |
| Example 70 | I | a | - | C | - | - |
| Example 71 | A | b | - | B | - | - |
| Example 72 | A | c | - | B | - | - |
| Example 73 | A | d | - | C | - | - |
| Example 74 | A | e | - | B | - | - |
| Example 75 | A | f | - | B | - | - |
| Example 76 | A | g | - | B | - | - |

(continued)

| | Drying step | Heating step | tanδ of cured film | Evaluation | | |
|---|---|---|---|---|---|---|
| | | | | Flatness | Resolution | In-plane wafer coating uniformity |
| Example 77 | A | h | - | C | - | - |
| Example 78 | A | i | - | C | - | - |
| Example 79 | A | j | - | B | - | - |
| Example 80 | A | k | - | B | - | - |
| Example 81 | A | l | - | C | - | - |
| Example 82 | C | e | - | A | - | - |
| Example 83 | F | f | - | A | - | - |
| Example 84 | C | e | - | A | - | - |
| Example 85 | F | f | - | A | - | - |
| Example 86 | A | a | C | A | A | A |
| Example 87 | A | a | C | A | A | A |
| Example 88 | A | a | C | A | A | A |
| Example 89 | A | a | C | A | A | A |
| Example 90 | A | a | C | A | A | A |
| Example 91 | A | a | C | A | A | A |
| Example 92 | A | a | C | A | A | A |
| Example 93 | A | a | C | A | A | A |
| Example 94 | A | a | C | A | A | A |
| Example 95 | A | a | C | A | A | A |
| Example 96 | A | a | C | A | A | A |

[Table 9]

| | Drying step | Heating step | tanδ of cured film | Evaluation | | |
|---|---|---|---|---|---|---|
| | | | | Flatness | Resolution | In-plane wafer coating uniformity |
| Example 97 | A | a | C | A | A | A |
| Example 98 | A | a | C | A | A | A |
| Example 99 | A | a | C | A | A | A |
| Example 100 | A | a | C | A | A | A |
| Example 101 | A | a | C | A | A | A |
| Example 102 | A | a | C | A | A | A |
| Example 103 | A | a | C | A | A | A |
| Example 104 | A | a | C | A | A | A |
| Example 105 | A | a | C | A | A | A |
| Example 106 | A | a | C | A | A | A |
| Example 107 | A | a | C | A | A | A |
| Example 108 | A | a | C | A | A | A |
| Example 109 | A | a | C | A | A | A |

(continued)

| | Drying step | Heating step | tanδ of cured film | Evaluation | | |
|---|---|---|---|---|---|---|
| | | | | Flatness | Resolution | In-plane wafer coating uniformity |
| Example 110 | A | a | C | A | A | A |
| Example 111 | A | a | C | A | A | A |
| Example 112 | A | a | C | A | A | A |
| Example 113 | A | a | C | A | A | A |
| Example 114 | A | a | C | A | A | A |
| Example 115 | A | a | C | A | A | A |
| Example 116 | A | a | C | A | A | A |
| Example 117 | A | a | C | A | A | A |
| Example 118 | A | a | C | A | A | A |
| Example 119 | A | a | C | A | A | A |
| Example 120 | A | a | C | A | A | A |
| Example 121 | A | a | C | A | A | A |
| Example 122 | A | a | C | A | A | A |
| Example 123 | A | a | C | A | A | A |
| Example 124 | A | a | C | A | A | A |
| Example 125 | A | a | C | A | A | A |
| Example 126 | A | a | C | A | A | A |
| Example 127 | A | a | C | A | A | A |
| Example 128 | A | a | C | A | A | A |
| Example 129 | A | a | C | A | A | A |
| Example 130 | A | a | C | A | A | A |
| Example 131 | A | a | C | A | A | A |
| Example 132 | A | a | C | A | A | A |
| Example 133 | A | a | C | A | A | A |
| Example 134 | A | a | C | A | A | A |
| Example 135 | A | a | C | A | A | A |
| Example 136 | A | a | C | A | A | A |
| Example 137 | A | a | C | A | A | A |
| Example 138 | A | a | C | A | A | A |
| Example 139 | A | a | A | C | - | - |
| Example 140 | A | a | B | C | - | - |
| Example 141 | A | a | B | C | - | - |
| Example 142 | A | a | C | C | - | - |
| Example 143 | A | a | C | C | - | - |
| Example 144 | A | a | B | C | - | - |

[Table 10]

| | Drying step | Heating step | tanδ of cured film | Evaluation | | |
|---|---|---|---|---|---|---|
| | | | | Flatness | Resolution | In-plane wafer coating uniformity |
| Example 145 | A | a | B | C | - | - |
| Example 146 | A | a | B | C | - | - |
| Example 147 | A | a | B | C | - | - |
| Example 148 | A | a | B | C | - | - |
| Example 149 | A | a | B | B | - | - |
| Example 150 | A | a | B | A | - | - |
| Example 151 | A | a | B | A | - | - |
| Example 152 | A | a | B | A | - | - |
| Example 153 | A | a | B | A | - | - |
| Example 154 | A | a | A | A | - | - |
| Example 155 | A | a | A | A | - | - |
| Example 156 | A | a | B | A | - | - |
| Example 157 | A | a | B | A | - | - |
| Example 158 | A | a | B | A | - | - |
| Example 159 | A | a | B | A | - | - |
| Example 160 | A | a | B | C | C | C |
| Example 161 | A | a | C | C | C | C |
| Example 162 | A | a | C | C | C | C |
| Example 163 | A | a | D | C | B | C |
| Example 164 | A | a | D | C | B | C |
| Example 165 | A | a | C | C | B | C |
| Example 166 | A | a | C | C | B | C |
| Example 167 | A | a | C | C | B | C |
| Example 168 | A | a | C | C | B | C |
| Example 169 | A | a | C | C | B | C |
| Example 170 | A | a | C | B | B | C |
| Example 171 | A | a | C | A | A | C |
| Example 172 | A | a | C | A | A | C |
| Example 173 | A | a | C | A | A | C |
| Example 174 | A | a | C | A | A | C |
| Example 175 | A | a | C | A | A | C |
| Example 176 | A | a | C | A | A | C |
| Example 177 | A | a | C | A | A | A |
| Example 178 | A | a | C | A | A | A |
| Example 179 | A | a | C | A | A | A |
| Example 180 | A | a | C | A | A | A |
| Example 181 | A | a | C | A | A | A |
| Example 182 | A | a | C | A | A | A |

(continued)

| | Drying step | Heating step | tanδ of cured film | Evaluation | | |
|---|---|---|---|---|---|---|
| | | | | Flatness | Resolution | In-plane wafer coating uniformity |
| Example 183 | A | a | C | A | A | A |
| Example 184 | A | a | C | A | A | A |
| Example 185 | A | a | C | A | A | A |
| Example 186 | A | a | C | A | A | A |
| Comparative Example 1 | A | a | G | D | D | - |

From the above results, it can be seen that the cured substance formed of the resin composition according to the embodiment of the present invention has excellent flatness. In addition, in the conditions (H) and (I) of the drying step, it is presumed that the curing of the film proceeds in the drying step, and thus the reflow is unlikely to occur, and the evaluation result of the flatness is C. Furthermore, in the condition (h) of the heating step, it is presumed that since the heating temperature was not sufficient with respect to Tg (glass transition temperature) of the film, reflow was unlikely to occur, and the evaluation result of the flatness was C.

The comparative composition according to Comparative Example 1 does not contain the specific resin. It can be seen that the cured substance formed of such a comparative composition is inferior in flatness.

<Example 101>

The resin composition used in Example 1 was applied in a layered manner to the surface of the thin copper layer of the resin base material on which the thin copper layer was formed on the surface by a spin coating method, and a drying step was performed under the conditions described in Example 1 in the above table to form a resin composition layer having a film thickness of 5 μm, and then the resin composition layer was exposed using a stepper (FPA-3000 i5 (manufactured by Canon Inc.)). Exposure was carried out through a mask (a binary mask in which the pattern is a pattern of 1:1 line-and-space and the line width is 10 μm) at a wavelength of 365 nm and 200mJ/$cm^2$. After the exposure, the layer was developed with cyclopentanone for 15 seconds and rinsed with PGMEA for 30 seconds to obtain a layer pattern.

Next, a heating step was carried out under a nitrogen atmosphere under the conditions described in Example 1 in the table to form an interlayer insulating film for a re-distribution layer. This interlayer insulating film for a re-distribution layer was excellent in insulating properties.

In addition, in a case where a semiconductor device was manufactured using this interlayer insulating film for a re-distribution layer, it has been confirmed that the semiconductor device operates without any problem.

## Claims

**1.** A resin composition comprising:

at least one resin selected from the group consisting of a polyimide and a precursor thereof,
wherein a dielectric loss tangent of a cured substance obtained by heating the resin composition at 230°C for 1 hour is less than 0.03.

**2.** A resin composition comprising:

at least one resin selected from the group consisting of a polyimide and a precursor thereof,
wherein a dielectric loss tangent of the resin is less than 0.025.

**3.** The resin composition according to claim 1 or 2, further comprising:

a polymerizable compound; and
a photopolymerization initiator.

**4.** The resin composition according to claim 3,
wherein the polymerizable compound contains an acryloyl group.

**5.** The resin composition according to claim 1 or 2, wherein a weight-average molecular weight of the resin is 20,000 or less.

**6.** The resin composition according to claim 1 or 2, wherein the resin has a polymerizable group.

**7.** The resin composition according to claim 1 or 2, wherein the resin has a vinylphenyl group.

**8.** The resin composition according to claim 1 or 2,

wherein the resin has a group obtained by removing two or more hydrogen atoms from a structure represented by Formula (A-1),

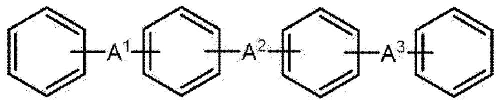

(A-1)

in Formula (A-1), $A^1$ to $A^3$ each independently represent a single bond or a divalent linking group, and four benzene rings described in Formula (A-1) may each have a substituent.

**9.** The resin composition according to claim 1 or 2, further comprising: a solvent having a boiling point of 180°C or lower.

**10.** The resin composition according to claim 9, further comprising: a solvent having a boiling point of higher than 180°C.

**11.** The resin composition according to claim 1 or 2, further comprising: a surfactant.

**12.** The resin composition according to claim 11, wherein the surfactant is a compound containing a silicon atom.

**13.** The resin composition according to claim 1 or 2, wherein the resin composition is used for forming an interlayer insulating film for a re-distribution layer.

**14.** A cured substance obtained by curing the resin composition according to claim 1 or 2.

**15.** A laminate comprising:

two or more layers consisting of the cured substance according to claim 14; and
a metal layer provided between any of the layers consisting of the cured substance.

**16.** A manufacturing method for a cured substance, comprising: a film forming step of applying the resin composition according to claim 1 or 2 onto a base material to form a film.

**17.** A manufacturing method for a cured substance, comprising:

a drying step of heating and drying a resin composition containing at least one resin selected from the group consisting of a polyimide and a precursor thereof, in which a dielectric loss tangent of the resin is less than 0.025, thereby forming a film; and
a heating step of heating the film,
wherein any one of the following condition i to condition v is satisfied,

condition i: a heating temperature in the drying step is 120°C or higher and lower than 150°C,
condition ii: a heating temperature in the drying step is lower than 120°C and a heating time is 5 minutes or longer,
condition iii: a heating temperature in the heating step is 240°C or higher,

condition iv: a heating temperature in the heating step is 150°C or higher and lower than 240°C, and the heating time is 3 hours or longer,
condition v: the heating step includes at least a first heating step and a second heating step performed after the first heating step, in which a heating temperature in the first heating step is 150°C or higher and lower than 200°C and a heating temperature in the second heating step is 200°C or higher.

**18.** A manufacturing method for a cured substance, comprising:

a drying step of heating and drying a curable composition containing at least one resin selected from the group consisting of a polyimide and a precursor thereof, thereby forming a film; and
a heating step of heating the film,
wherein a dielectric loss tangent of the obtained cured substance is less than 0.03, and
any one of the following condition i to condition v is satisfied,

condition i: a heating temperature in the drying step is 120°C or higher and lower than 150°C,
condition ii: a heating temperature in the drying step is lower than 120°C and a heating time is 5 minutes or longer,
condition iii: a heating temperature in the heating step is 240°C or higher,
condition iv: a heating temperature in the heating step is 150°C or higher and lower than 240°C, and the heating time is 3 hours or longer,
condition v: the heating step includes at least a first heating step and a second heating step performed after the first heating step, in which a heating temperature in the first heating step is 150°C or higher and lower than 200°C and a heating temperature in the second heating step is 200°C or higher.

**19.** The manufacturing method for a cured substance according to claim 17 or 18, further comprising:
an exposure step of selectively exposing the film and a development step of developing the film using a developer to form a pattern, between the drying step and the heating step.

**20.** A manufacturing method for a laminate, comprising:
the manufacturing method for a cured substance according to claim 16.

**21.** A manufacturing method for a semiconductor device, comprising:
the manufacturing method for a cured substance according to claim 16.

**22.** A semiconductor device comprising:
the cured substance according to claim 14.

FIG. 1

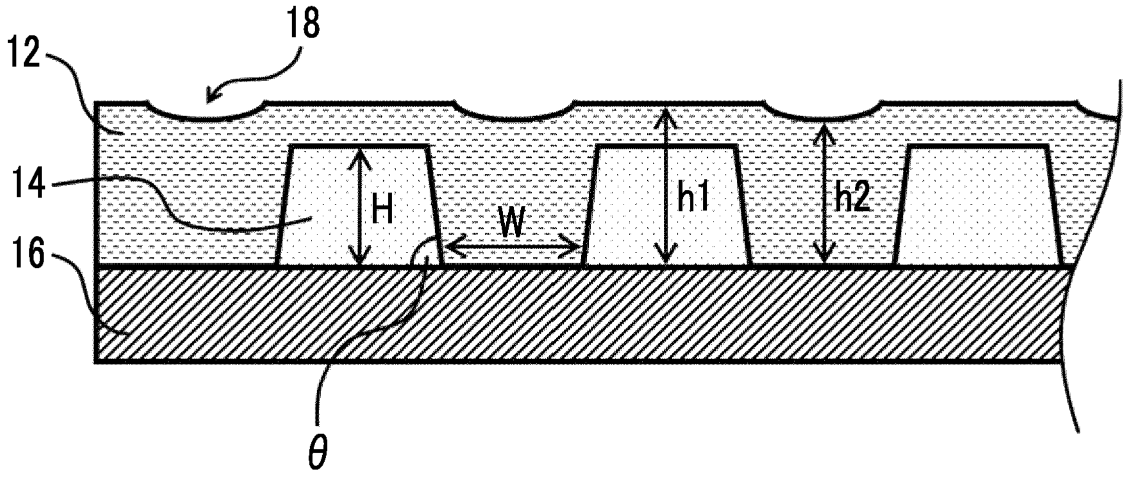


FIG. 2

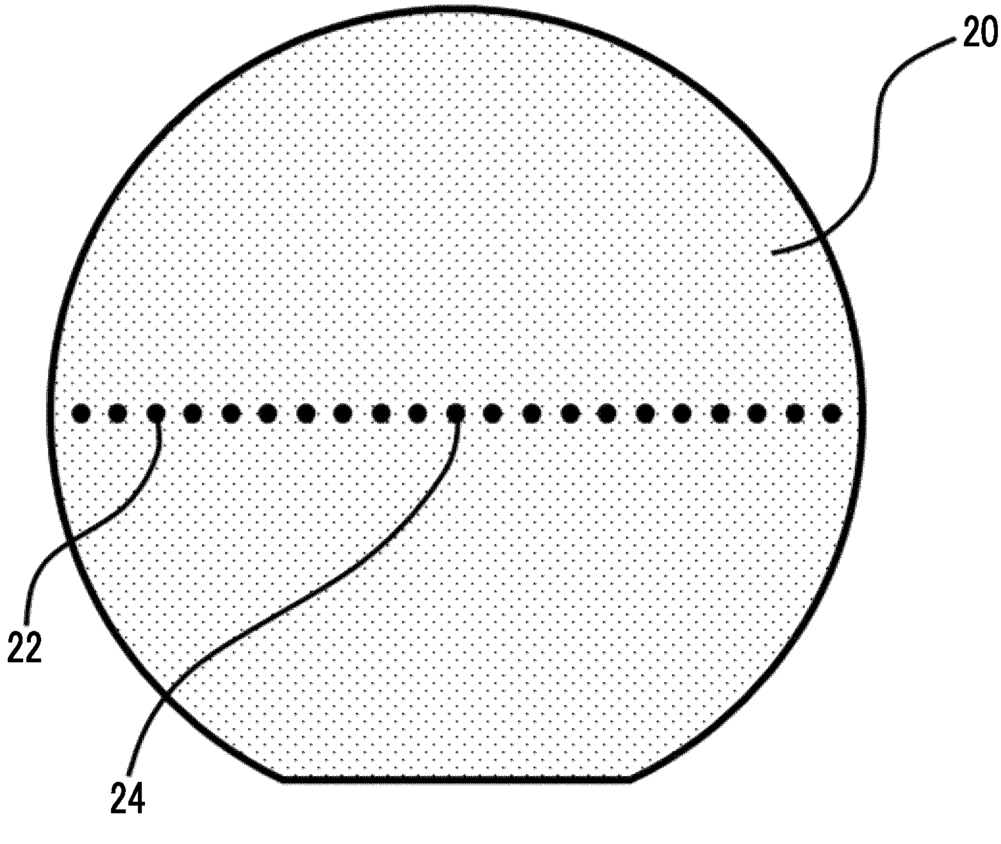

**INTERNATIONAL SEARCH REPORT**

International application No. **PCT/JP2023/035249**

**A. CLASSIFICATION OF SUBJECT MATTER**

***C08G 73/12***(2006.01)i; ***C08F 290/14***(2006.01)i; ***G03F 7/004***(2006.01)i; ***G03F 7/027***(2006.01)i; ***G03F 7/037***(2006.01)i; ***G03F 7/20***(2006.01)i

FI: C08G73/12; G03F7/004 504; G03F7/004 501; G03F7/027 501; G03F7/027 514; G03F7/037; C08F290/14; G03F7/20 521; G03F7/20 501

According to International Patent Classification (IPC) or to both national classification and IPC

**B. FIELDS SEARCHED**

Minimum documentation searched (classification system followed by classification symbols)

C08G73/12; C08F290/14; G03F7/004; G03F7/027; G03F7/037; G03F7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2022-021937 A (HD MICROSYSTEMS, LTD.) 03 February 2022 (2022-02-03) claims, paragraphs [0031], [0032], [0065], [0074], [0123], [0155], [0166], [0174], [0175], [0185], table 1, paragraphs [0191], [0194], [0195], examples | 1-6, 8-22 |
| Y | | 7, 11-12 |
| X | WO 2022/158359 A1 (ASAHI KASEI CORP.) 28 July 2022 (2022-07-28) claims, paragraphs [0073], [0094], [0117], [0121], [0126], [0129], [0133], [0137]-[0139], [0141], [0164], table 2, examples | 1-6, 8-10, 13-22 |
| Y | | 11-12 |
| Y | JP 2021-123652 A (FUJIFILM CORP.) 30 August 2021 (2021-08-30) paragraph [0064] | 7 |
| A | JP 2021-196482 A (ASAHI KASEI CORP.) 27 December 2021 (2021-12-27) claims, examples | 1-22 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 December 2023** | **12 December 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/035249**

**C. DOCUMENTS CONSIDERED TO BE RELEVANT**

| Category* | Citation of document, with indication, where appropriate, of the relevant passages | Relevant to claim No. |
|---|---|---|
| A | JP 2022-054416 A (ASAHI KASEI CORP.) 06 April 2022 (2022-04-06) claims, examples | 1-22 |
| P, X | JP 2022-154451 A (AJINOMOTO CO., INC.) 13 October 2022 (2022-10-13) claims, examples | 1-4, 6, 8, 10, 13-22 |

Form PCT/ISA/210 (second sheet) (January 2015)

**INTERNATIONAL SEARCH REPORT**
**Information on patent family members**

International application No.
**PCT/JP2023/035249**

| Patent document cited in search report | Publication date (day/month/year) | Patent family member(s) | Publication date (day/month/year) |
|---|---|---|---|
| JP 2022-021937 A | 03 February 2022 | (Family: none) | |
| WO 2022/158359 A1 | 28 July 2022 | (Family: none) | |
| JP 2021-123652 A | 30 August 2021 | TW 202130707 A | |
| JP 2021-196482 A | 27 December 2021 | (Family: none) | |
| JP 2022-054416 A | 06 April 2022 | CN 114253076 A | |
| JP 2022-154451 A | 13 October 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020255859 A
- WO 2021039782 A
- WO 2017038598 A
- WO 2022145355 A
- JP 2016027357 A
- WO 2021112189 A
- JP 48041708 B
- JP S48041708 B
- JP 51037193 A
- JP S51037193 A
- JP 2032293 B
- JP H02032293 B
- JP 2016765 B
- JP H02016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H01105238 A
- WO 2015199219 A
- JP 2014130173 A
- JP 6301489 B
- WO 2018221177 A
- WO 2018110179 A
- JP 2019043864 A
- JP 2019044030 A
- JP 2019167313 A
- JP 2015087611 A
- JP 10291969 A
- JP H10291969 A
- JP 4225898 B
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680A A
- JP 2017198865 A
- WO 2017164127 A
- WO 2013167515 A
- JP 2012014052 A
- WO 2021020359 A
- JP 4600600 B
- JP 2007269779 A
- JP 2009191061 A
- WO 2015125469 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- WO 2020066416 A
- WO 2018038002 A
- JP 2018173573 A
- JP 2011128358 A
- JP 2014186186 A
- JP 2013072935 A
- JP 2013015701 A
- JP 2009283711 A
- JP 2011059656 A
- JP 2012194520 A
- JP 4253058 A
- JP H4253058 A
- JP 5224410 A
- JP H5224410 A
- JP 5303200 A
- JP H5303200 A
- EP 530148 A
- JP 2019206689 A
- JP 2012003225 A
- US 20130034812 A
- JP 2008250074 A
- JP 2010164965 A
- JP 2008063554 A
- JP 2015123351 A
- JP 2006023696 A
- JP 2006047592 A
- US 9159547 B

- JP 2007157879 A
- JP 2001521288 A
- JP 2004214501 A
- JP 2004101850 A
- US 7888181 B2
- US 9177926 B2

**Non-patent literature cited in the description**


- Handbook of Chemistry, Pure Chemistry. Chemical Society of Japan
- *MATERIAL STAGE*, 2019, vol. 19 (3)
- *J. C. S. Perkin II*, 1979, 1653-1660
- *J. C. S. Perkin II*, 1979, 156-162
- *Journal of Photopolymer Science and Technology*, 1995, 202-232
- Polymer Dictionary. The Society of Polymer Science, 2005, 683-684
- High functionality and applied technology of polyimide. Science & Technology Co., Ltd, April 2008
- Basics and development of polyimide materials. Technical library CMC TL, November 2011
- Latest Polyimide Basics and Applications. Japan Polyimide & Aromatic Polymers Study Group. NTS Inc, August 2010